# EUROPEAN PATENT SPECIFICATION

(11) **EP 4 160 708 B1**
(45) Date of publication and mention of the grant of the patent: **08.07.2026**
(21) Application number: 21813675.2
(22) Date of filing: 12.05.2021
(51) Int. Cl.: H10K 85/60, H10K 50/18, C09K 11/06, H10K 101/00

(54) **ORGANIC LIGHT-EMITTING DEVICE, MANUFACTURING METHOD THEREFOR, AND COMPOSITION FOR ORGANIC MATERIAL LAYER OF ORGANIC LIGHT-EMITTING DEVICE**
ORGANISCHE LICHTEMITTIERENDE VORRICHTUNG, HERSTELLUNGSVERFAHREN DAFÜR UND ZUSAMMENSETZUNG FÜR ORGANISCHE MATERIALSCHICHT EINER ORGANISCHEN LICHTEMITTIERENDEN VORRICHTUNG
DISPOSITIF ÉLECTROLUMINESCENT ORGANIQUE, SON PROCÉDÉ DE FABRICATION ET COMPOSITION POUR COUCHE DE MATÉRIAU ORGANIQUE DE DISPOSITIF ÉLECTROLUMINESCENT ORGANIQUE

(30) Priority: 26.05.2020 KR 20200063179
(43) Date of publication of application: 05.04.2023
(73) Proprietor: LT Materials Co., Ltd., Yongin-si, Gyeonggi-do 17118 (KR)
(72) Inventor: LEE, Yong-Hui, Yongin-si, Gyeonggi-do 17118 (KR); YU, Seok-Hyeon, Yongin-si, Gyeonggi-do 17118 (KR); MO, Jun-Tae, Yongin-si, Gyeonggi-do 17118 (KR); KIM, Su-Yeon, Yongin-si, Gyeonggi-do 17118 (KR); PARK, Min-Ji, Yongin-si, Gyeonggi-do 17118 (KR); KIM, Dong-Jun, Yongin-si, Gyeonggi-do 17118 (KR)
(74) Representative: Goddar, Heinz J.
(86) International application number: PCT/KR2021/005956
(87) International publication number: WO 2021/241923

(56) References cited:
- WO-A1-2019/132399
- KR-A- 20190 035 503
- KR-A- 20190 079 341
- KR-A- 20200 017 727
- KR-A- 20200 017 728
- US-A1- 2015 318 495
- US-A1- 2016 293 856

## Description

### [Technical Field]

The present specification relates to an organic light emitting device, a method for manufacturing the same, and a composition for an organic material layer of an organic light emitting device.

### [Background Art]

An electroluminescent device is one type of self-emissive display devices, and has an advantage of having a wide viewing angle, and a high response speed as well as having an excellent contrast.

An organic light emitting device has a structure disposing an organic thin film between two electrodes. When a voltage is applied to an organic light emitting device having such a structure, electrons and holes injected from the two electrodes bind and pair in the organic thin film, and light emits as these annihilate. The organic thin film may be formed in a single layer or a multilayer as necessary.

A material of the organic thin film may have a light emitting function as necessary. For example, as a material of the organic thin film, compounds capable of forming a light emitting layer themselves alone may be used, or compounds capable of performing a role of a host or a dopant of a host-dopant-based light emitting layer may also be used. In addition thereto, compounds capable of performing roles of hole injection, hole transfer, electron blocking, hole blocking, electron transfer, electron injection and the like may also be used as a material of the organic thin film.

Development of an organic thin film material has been continuously required for enhancing performance, lifetime or efficiency of an organic light emitting device. WO2019/132399 discloses an organic light emitting diode comprising a heterocyclic compound based on a dibenzofuran moiety present in the light emitting layer.

US2015/318495 discloses an organic light emitting diode comprising heterocyclic compounds in the light emitting layer.

### [Disclosure]

### [Technical Problem]

The present disclosure is directed to providing an organic light emitting device, a method for manufacturing the same, and a composition for an organic material layer of an organic light emitting device.

### [Technical Solution]

One embodiment according to the present invention provides an organic light emitting device as defined in claim 1.

Another embodiment according to the present invention provides a composition of an organic material layer as defined in claim 11.

Lastly, one embodiment of the present application provides a method for manufacturing an organic light emitting device, the method including preparing a substrate; forming a first electrode on the substrate; forming one or more organic material layers on the first electrode; and forming a second electrode on the organic material layer, wherein the forming of organic material layers includes forming one or more organic material layers using the composition for an organic material layer according to one embodiment of the present application.

### [Advantageous Effects]

Heterocyclic compounds of Chemical Formula 1 and Chemical Formula 2 according to one embodiment of the present application can be used as a material of an organic material layer of an organic light emitting device. The heterocyclic compounds of Chemical Formula 1 and Chemical Formula 2 can be used as a material of a hole injection layer, a hole transfer layer, a light emitting layer, an electron transfer layer, an electron injection layer, a charge generation layer or the like in an organic light emitting device. Particularly, the heterocyclic compound represented by Chemical Formula 1 and the heterocyclic compound represented by Chemical Formula 2 can be used as a material of a light emitting layer of an organic light emitting device at the same time. In addition, when using the heterocyclic compound represented by Chemical Formula 1 and the heterocyclic compound represented by Chemical Formula 2 in an organic light emitting device at the same time, a driving voltage of the device can be lowered, light efficiency can be enhanced, and lifetime properties of the device can be enhanced by thermal stability of the compound.

### [Description of Drawings]

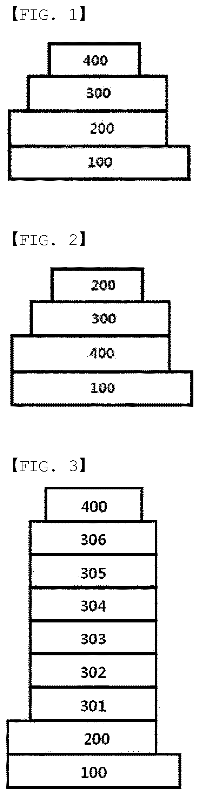

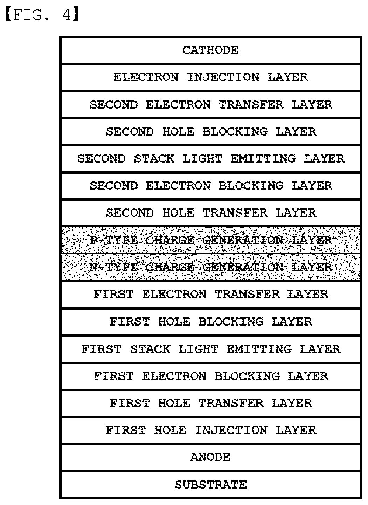

FIG. 1 to FIG. 4 are diagrams each schematically illustrating a lamination structure of an organic light emitting device according to one embodiment of the present application.
100: Substrate
200: Anode
300: Organic Material Layer
301: Hole Injection Layer
302: Hole Transfer Layer
303: Light Emitting Layer
304: Hole Blocking Layer
305: Electron Transfer Layer
306: Electron Injection Layer
400: Cathode

### [Mode for Disclosure]

Hereinafter, the present application will be described in detail.

The term "substitution" means a hydrogen atom bonding to a carbon atom of a compound being changed to another substituent, and the position of substitution is not limited as long as it is a position at which the hydrogen atom is substituted, that is, a position at which a substituent can substitute, and when two or more substituents substitute, the two or more substituents may be the same as or different from each other.

In the present specification, "substituted or unsubstituted" means being substituted with one or more substituents selected from the group consisting of deuterium; a halogen group; -CN; a C1 to C60 alkyl group; a C2 to C60 alkenyl group; a C2 to C60 alkynyl group; a C3 to C60 cycloalkyl group; a C2 to C60 heterocycloalkyl group; a C6 to C60 aryl group; a C2 to C60 heteroaryl group; a silyl group; a phosphine oxide group; and an amine group, or a substituent linking two or more substituents selected from among the substituents illustrated above, or being unsubstituted.

In the present specification, a "case of a substituent being not indicated in a chemical formula or compound structure" means that a hydrogen atom bonds to a carbon atom. However, since deuterium (²H) is an isotope of hydrogen, some hydrogen atoms may be deuterium.

In one embodiment of the present application, a "case of a substituent being not indicated in a chemical formula or compound structure" may mean that positions that may come as a substituent may all be hydrogen or deuterium. In other words, since deuterium is an isotope of hydrogen, some hydrogen atoms may be deuterium that is an isotope, and herein, a content of the deuterium may be from 0% to 100%.

In one embodiment of the present application, in a "case of a substituent being not indicated in a chemical formula or compound structure", hydrogen and deuterium may be mixed in compounds when deuterium is not explicitly excluded such as a deuterium content being 0%, a hydrogen content being 100% or substituents being all hydrogen.

In one embodiment of the present application, deuterium is one of isotopes of hydrogen, is an element having deuteron formed with one proton and one neutron as a nucleus, and may be expressed as hydrogen-2, and the elemental symbol may also be written as D or ²H.

In one embodiment of the present application, an isotope means an atom with the same atomic number (Z) but with a different mass number (A), and may also be interpreted as an element with the same number of protons but with a different number of neutrons.

In one embodiment of the present application, a meaning of a content T% of a specific substituent may be defined as T2/T1×100=T% when the total number of substituents that a basic compound may have is defined as T1, and the number of specific substituents among these is defined as T2.

In other words, in one example, having a deuterium content of 20% in a phenyl group represented by 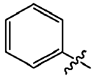 means that the total number of substituents that the phenyl group may have is 5 (T1 in the formula), and the number of deuterium among these is 1 (T2 in the formula). In other words, having a deuterium content of 20% in a phenyl group may be represented by the following structural formulae.

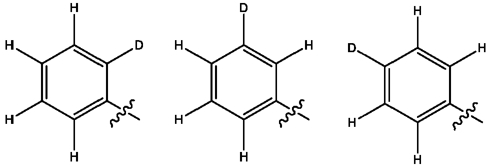

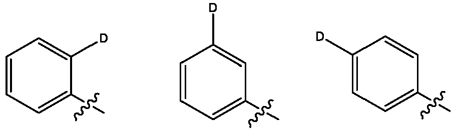

In addition, in one embodiment of the present application, "a phenyl group having a deuterium content of 0%" may mean a phenyl group that does not include a deuterium atom, that is, a phenyl group that has 5 hydrogen atoms.

In the present specification, the halogen group may be fluorine, chlorine, bromine or iodine.

In the present specification, the alkyl group includes linear or branched having 1 to 60 carbon atoms, and may be further substituted with other substituents. The number of carbon atoms of the alkyl group may be from 1 to 60, specifically from 1 to 40 and more specifically from 1 to 20. Specific examples thereof may include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group and the like, but are not limited thereto.

In the present specification, the alkenyl group includes linear or branched having 2 to 60 carbon atoms, and may be further substituted with other substituents. The number of carbon atoms of the alkenyl group may be from 2 to 60, specifically from 2 to 40 and more specifically from 2 to 20. Specific examples thereof may include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present specification, the alkynyl group includes linear or branched having 2 to 60 carbon atoms, and may be further substituted with other substituents. The number of carbon atoms of the alkynyl group may be from 2 to 60, specifically from 2 to 40 and more specifically from 2 to 20.

In the present specification, the alkoxy group may be linear, branched or cyclic. The number of carbon atoms of the alkoxy group is not particularly limited, but is preferably from 1 to 20. Specific examples thereof may include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy and the like, but are not limited thereto.

In the present specification, the cycloalkyl group includes a monocyclic or polycyclic aryl group having 3 to 60 carbon atoms, and may be further substituted with other substituents. Herein, the polycyclic means a group in which the cycloalkyl group is directly linked to or fused with other cyclic groups. Herein, the other cyclic groups may be a cycloalkyl group, but may also be different types of cyclic groups such as a heterocycloalkyl group, an aryl group and a heteroaryl group. The number of carbon groups of the cycloalkyl group may be from 3 to 60, specifically from 3 to 40 and more specifically from 5 to 20. Specific examples thereof may include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group and the like, but are not limited thereto.

In the present specification, the heterocycloalkyl group includes O, S, Se, N or Si as a heteroatom, includes monocyclic or polycyclic having 2 to 60 carbon atoms, and may be further substituted with other substituents. Herein, the polycyclic means a group in which the heterocycloalkyl group is directly linked to or fused with other cyclic groups. Herein, the other cyclic groups may be a heterocycloalkyl group, but may also be different types of cyclic groups such as a cycloalkyl group, an aryl group and a heteroaryl group. The number of carbon atoms of the heterocycloalkyl group may be from 2 to 60, specifically from 2 to 40 and more specifically from 3 to 20.

In the present specification, the aryl group includes monocyclic or polycyclic having 6 to 60 carbon atoms, and may be further substituted with other substituents. Herein, the polycyclic means a group in which the aryl group is directly linked to or fused with other cyclic groups. Herein, the other cyclic groups may be an aryl group, but may also be different types of cyclic groups such as a cycloalkyl group, a heterocycloalkyl group and a heteroaryl group. The aryl group includes a spiro group. The number of carbon atoms of the aryl group may be from 6 to 60, specifically from 6 to 40 and more specifically from 6 to 25. Specific examples of the aryl group may include a phenyl group, a biphenyl group, a triphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused ring group thereof, and the like, but are not limited thereto.

In the present specification, the fluorenyl group may be substituted, and adjacent substituents may bond to each other to form a ring.

When the fluorenyl group is substituted, 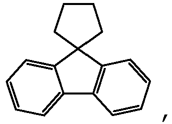 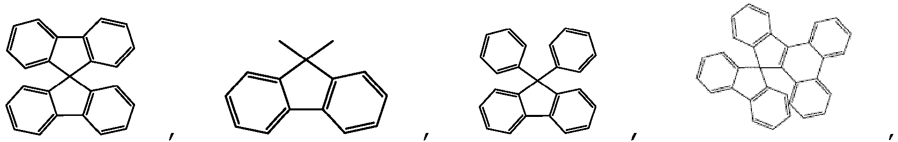 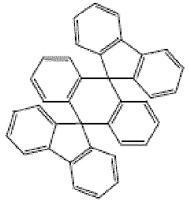 and the like may be included, however, the structure is not limited thereto.

In the present specification, the heteroaryl group includes S, O, Se, N or Si as a heteroatom, includes monocyclic or polycyclic having 2 to 60 carbon atoms, and may be further substituted with other substituents. Herein, the polycyclic means a group in which the heteroaryl group is directly linked to or fused with other cyclic groups. Herein, the other cyclic groups may be a heteroaryl group, but may also be different types of cyclic groups such as a cycloalkyl group, a heterocycloalkyl group and an aryl group. The number of carbon atoms of the heteroaryl group may be from 2 to 60, specifically from 2 to 40 and more specifically from 3 to 25. Specific examples of the heteroaryl group may include a pyridyl group, a pyrrolyl group, a pyrimidyl group, a pyridazinyl group, a furanyl group, a thiophene group, an imidazolyl group, a pyrazolyl group, an oxazolyl group, an isoxazolyl group, a thiazolyl group, an isothiazolyl group, a triazolyl group, a furazanyl group, an oxadiazolyl group, a thiadiazolyl group, a dithiazolyl group, a tetrazolyl group, a pyranyl group, a thiopyranyl group, a diazinyl group, an oxazinyl group, a thiazinyl group, a dioxynyl group, a triazinyl group, a tetrazinyl group, a quinolyl group, an isoquinolyl group, a quinazolinyl group, an isoquinazolinyl group, a qninozolinyl group, a naphthyridyl group, an acridinyl group, a phenanthridinyl group, an imidazopyridinyl group, a diazanaphthalenyl group, a triazaindene group, an indolyl group, an indolizinyl group, a benzothiazolyl group, a benzoxazolyl group, a benzimidazolyl group, a benzothiophene group, a benzofuran group, a dibenzothiophene group, a dibenzofuran group, a carbazolyl group, a benzocarbazolyl group, a dibenzocarbazolyl group, a phenazinyl group, a dibenzosilole group, spirobi(dibenzosilole), a dihydrophenazinyl group, a phenoxazinyl group, a phenanthridyl group, an imidazopyridinyl group, a thienyl group, an indolo[2,3-a]carbazolyl group, an indolo[2,3-b]carbazolyl group, an indolinyl group, a 10,11-dihydro-dibenzo[b,f]azepine group, a 9,10-dihydroacridinyl group, a phenanthrazinyl group, a phenothiathiazinyl group, a phthalazinyl group, a naphthylidinyl group, a phenanthrolinyl group, a benzo[c] [1,2,5]thiadiazolyl group, a 5,10-dihydrobenzo[b,e] [1,4]azasilinyl group, a pyrazolo[1,5-c]quinazolinyl group, a pyrido[1,2-b]indazolyl group, a pyrido[1,2-a]imidazo[1,2-e]indolinyl group, a 5,11-dihydroindeno[1,2-b]carbazolyl group and the like, but are not limited thereto.

In the present specification, the triazine group includes 1,3,5-triazine and 1,2,4-triazine.

In the present specification, the amine group may be selected from the group consisting of a monoalkylamine group; a monoarylamine group; a monoheteroarylamine group; -NH₂; a dialkylamine group; a diarylamine group; a diheteroarylamine group; an alkylarylamine group; an alkylheteroarylamine group; and an arylheteroarylamine group, and although not particularly limited thereto, the number of carbon atoms is preferably from 1 to 30. Specific examples of the amine group may include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group and the like, but are not limited thereto.

In the present specification, the arylene group means the aryl group having two bonding sites, that is, a divalent group. The descriptions on the aryl group provided above may be applied thereto except that these are each a divalent group. In addition, the heteroarylene group means the heteroaryl group having two bonding sites, that is, a divalent group. The descriptions on the heteroaryl group provided above may be applied thereto except that these are each a divalent group.

In the present specification, the phosphine oxide group may be represented by -P(=O)RrRf, and Rr and Rf may represent substituents. Specifically, the phosphine oxide group may be substituted with an aryl group, and as the aryl group, the examples described above may be used. Examples of the phosphine oxide group may include a diphenylphosphine oxide group, a dinaphthylphosphine oxide group and the like, but are not limited thereto.

In the present specification, the silyl group is a substituent including Si, having the Si atom directly linked as a radical, and is represented by -SiR₁₀₄R₁₀₅R₁₀₆. R₁₀₄ to R₁₀₆ are the same as or different from each other, and may be each independently a substituent formed with at least one of hydrogen; deuterium; a halogen group; an alkyl group; an alkenyl group; an alkoxy group; a cycloalkyl group; an aryl group; and a heterocyclic group. Specific examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but are not limited thereto.

In the present specification, the "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituting ortho positions in a benzene ring, and two substituents substituting the same carbon in an aliphatic ring may be interpreted as groups "adjacent" to each other.

As the aliphatic or aromatic hydrocarbon ring, or the aliphatic or aromatic heteroring that adjacent groups may form, the structures illustrated as the cycloalkyl group, the aryl group, the cycloheteroalkyl group and the heteroaryl group described above may be used except for those that are not a monovalent group.

One embodiment of the present application provides an organic light emitting device including a first electrode, a second electrode, and one or more organic material layers provided between the first electrode and the second electrode,
wherein one or more layers of the organic material layers include the heterocyclic compound represented by Chemical Formula 1 and the heterocyclic compound represented by Chemical Formula 2.

In one embodiment of the present application, Chemical Formula 1 may be represented by the following Chemical Formula 3 or Chemical Formula 4.

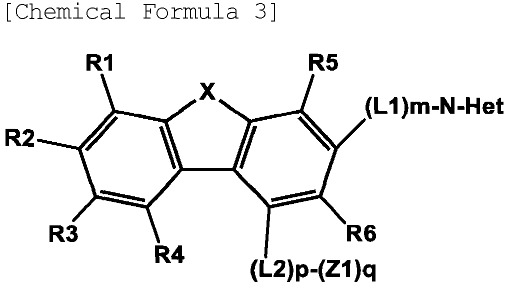

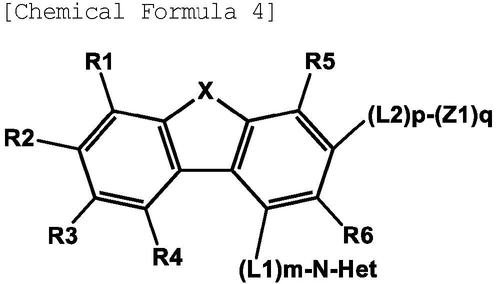

In Chemical Formulae 3 and 4,
R1 to R6, L1, L2, Z1, N-Het, X, m, p and q have the same definitions as in Chemical Formula 1.

In one embodiment of the present application, R1 to R6 are the same as or different from each other, and each independently selected from the group consisting of hydrogen; deuterium; a halogen group; -CN; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R"; and a substituted or unsubstituted amine group, or two or more groups adjacent to each other may bond to each other to form a substituted or unsubstituted C6 to C60 aromatic hydrocarbon ring or a substituted or unsubstituted C2 to C60 heteroring.

In another embodiment, R1 to R6 are the same as or different from each other, and may be each independently selected from the group consisting of hydrogen; deuterium; a substituted or unsubstituted C1 to C60 alkyl group; a substituted or unsubstituted C6 to C60 aryl group; a substituted or unsubstituted C2 to C60 heteroaryl group; and a substituted or unsubstituted amine group.

In another embodiment, R1 to R6 are the same as or different from each other, and may be each independently selected from the group consisting of hydrogen; deuterium; a substituted or unsubstituted C1 to C40 alkyl group; a substituted or unsubstituted C6 to C40 aryl group; a substituted or unsubstituted C2 to C40 heteroaryl group; and a substituted or unsubstituted amine group.

In another embodiment, R1 to R6 may be hydrogen; or deuterium.

In another embodiment, R1 to R6 may be hydrogen.

In one embodiment of the present application, X may be O.

In one embodiment of the present application, X may be S.

In one embodiment of the present application, X may be NRa.

Particularly, when X is O or S, an excellent electron transfer ability is obtained by having O and S atoms with high electronegativity at the center of the core structure, and properties suitable for exciton blocking are also obtained.

In one embodiment of the present application, Ra may be a substituted or unsubstituted C1 to C60 alkyl group; a substituted or unsubstituted C6 to C60 aryl group; or a substituted or unsubstituted C2 to C60 heteroaryl group.

In another embodiment, Ra may be a substituted or unsubstituted C6 to C60 aryl group.

In another embodiment, Ra may be a substituted or unsubstituted C6 to C40 aryl group.

In another embodiment, Ra may be a C6 to C40 monocyclic or polycyclic aryl group.

In another embodiment, Ra may be a C6 to C40 monocyclic aryl group.

In another embodiment, Ra may be a phenyl group.

In one embodiment of the present application, N-Het may be a monocyclic or polycyclic heterocyclic group substituted or unsubstituted and including one or more Ns.

In another embodiment, N-Het may be a monocyclic or polycyclic heterocyclic group substituted or unsubstituted and including one or more and three or less Ns.

In another embodiment, N-Het may be a monocyclic or polycyclic heterocyclic group substituted or unsubstituted and including one or two Ns.

In another embodiment, N-Het may be a monocyclic or polycyclic C2 to C60 heterocyclic group unsubstituted or substituted with one or more substituents selected from the group consisting of a C6 to C60 aryl group and a C2 to C60 heteroaryl group, and including one or more Ns.

In another embodiment, N-Het may be unsubstituted or substituted with one or more substituents selected from the group consisting of a C6 to C60 aryl group and a C2 to C60 heteroaryl group, and may be a triazine group; a pyrimidine group; a pyridine group; a quinoline group; a quinazoline group; a phenanthroline group; an imidazole group; a benzothiazole group; or a benzo[4,5]thieno[2,3-d]pyrimidine group.

In another embodiment, N-Het may be a triazine group; a pyrimidine group; a pyridine group; a quinazoline group; a phenanthroline group; a benzo[4,5]furo[2,3-d]pyrimidine group; or a benzo[4,5]thieno[2,3-d]pyrimidine group, and the substituents may be further substituted with one or more substituents selected form the group consisting of a substituted or unsubstituted C6 to C60 aryl group and a substituted or unsubstituted C2 to C60 heteroaryl group.

In another embodiment, N-Het may be a triazine group; a pyrimidine group; a pyridine group; a quinazoline group; a phenanthroline group; a benzo[4,5]furo[2,3-d]pyrimidine group; or a benzo[4,5]thieno[2,3-d]pyrimidine group, and the substituents may be further substituted with one or more substituents selected form the group consisting of a phenyl group unsubstituted or substituted with a silyl group, a biphenyl group, a terphenyl group, a naphthyl group, a dimethylfluorenyl group, a dibenzofuran group and a dibenzothiophene group.

In another embodiment, N-Het may be a triazine group unsubstituted or substituted with one or more substituents selected form the group consisting of a phenyl group unsubstituted or substituted with a silyl group, a biphenyl group, a terphenyl group, a naphthyl group, a dimethylfluorenyl group, a dibenzofuran group and a dibenzothiophene group; a pyrimidine group unsubstituted or substituted with a phenyl group; a pyridine group unsubstituted or substituted with a phenyl group; a quinazoline group unsubstituted or substituted with a phenyl group; a phenanthroline group; a benzo[4,5]furo[2,3-d]pyrimidine group unsubstituted or substituted with a phenyl group; or a benzo[4,5]thieno[2,3-d]pyrimidine group unsubstituted or substituted with a phenyl group.

In an embodiment, according to the present invention, N-Het is a triazine group unsubstituted or substituted with one or more substituents selected form the group consisting of a phenyl group, a biphenyl group, a terphenyl group, a naphthyl group, a triphenylenyl group, a dibenzofuran group, a dibenzothiophene group, a pyridine group, a dimethylfluorenyl group, a diphenylfluorenyl group and a spirobifluorene group; a pyrimidine group unsubstituted or substituted with a phenyl group; a pyridine group unsubstituted or substituted with a phenyl group; a quinoline group unsubstituted or substituted with a phenyl group; a quinazoline group unsubstituted or substituted with a phenyl group; a phenanthroline group; an imidazole group unsubstituted or substituted with a phenyl group; a benzothiazole group; a benzo[4,5]thieno[2,3-d]pyrimidine group unsubstituted or substituted with a phenyl group.

In one embodiment of the present application, N-Het may be substituted again with -CN; a phenyl group; P(=O)RR'; or SiRR'R".

In one embodiment of the present application, L1 and L2 are the same as or different from each other, and may be each independently a direct bond; a substituted or unsubstituted C6 to C60 arylene group; or a substituted or unsubstituted C2 to C60 heteroarylene group.

In another embodiment, L1 and L2 are the same as or different from each other, and may be each independently a direct bond; a substituted or unsubstituted C6 to C40 arylene group; or a substituted or unsubstituted C2 to C40 heteroarylene group.

In another embodiment, L1 and L2 are the same as or different from each other, and may be each independently a direct bond; a C6 to C40 arylene group; or a C2 to C40 heteroarylene group.

In another embodiment, L1 and L2 are the same as or different from each other, and may be each independently a direct bond; a C6 to C40 arylene group; or a C2 to C40 heteroarylene group including N as a hetero-element.

In another embodiment, L1 and L2 are the same as or different from each other, and may be each independently a direct bond; a phenylene group; a biphenylene group; a naphthylene group; or a divalent pyridine group.

In another embodiment, L1 and L2 are the same as or different from each other, and may be each independently a direct bond; or a C6 to C40 arylene group.

In another embodiment, according to the present invention, L1 and L2 are the same as or different from each other, and are each independently a direct bond; or a phenylene group.

In one embodiment of the present application, Z1 may be selected from the group consisting of deuterium; a halogen group; -CN; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R"; and a substituted or unsubstituted amine group.

In one embodiment of the present application, R, R' and R" are the same as or different from each other, and may be each independently a substituted or unsubstituted C1 to C60 alkyl group; a substituted or unsubstituted C6 to C60 aryl group; or a substituted or unsubstituted C2 to C60 heteroaryl group.

In another embodiment, R, R' and R" are the same as or different from each other, and may be each independently a substituted or unsubstituted C1 to C60 alkyl group; or a substituted or unsubstituted C6 to C60 aryl group.

In another embodiment, R, R' and R" are the same as or different from each other, and may be each independently a C1 to C60 alkyl group; or a C6 to C60 aryl group.

In an embodiment, according to the present invention, R, R' and R" are the same as or different from each other, and are each independently a methyl group; or a phenyl group.

In another embodiment, R, R' and R" may be a phenyl group.

In one embodiment of the present application, Z1 may be - CN; or a substituted or unsubstituted amine group, or represented by the following Chemical Formula 1-1.

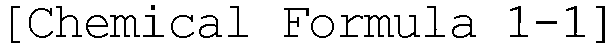

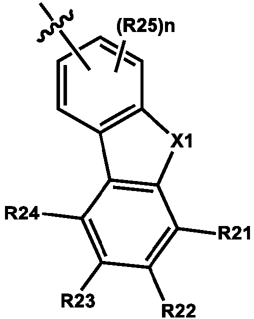

In Chemical Formula 1-1, 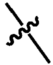 means a position linked to L2 of Chemical Formula 1,
X1 is O; S; N(R31); or C(R32) (R33),
R21 to R25 are the same as or different from each other, and each independently selected from the group consisting of hydrogen; deuterium; a halogen group; -CN; a substituted or unsubstituted C1 to C60 alkyl group; a substituted or unsubstituted C6 to C60 aryl group; and a substituted or unsubstituted C2 to C60 heteroaryl group, or two or more groups adjacent to each other bond to each other to form a substituted or unsubstituted C6 to C60 aromatic ring,
n is an integer of 0 to 3,
when n is 2 or greater, substituents in the parentheses are the same as or different from each other, and
R31 to R33 are the same as or different from each other, and each independently selected from the group consisting of a substituted or unsubstituted C1 to C60 alkyl group; a substituted or unsubstituted C6 to C60 aryl group; and a substituted or unsubstituted C2 to C60 heteroaryl group, or two or more groups adjacent to each other may bond to each other to form a substituted or unsubstituted C6 to C60 aromatic ring.

In one embodiment of the present application, R21 to R25 are the same as or different from each other, and each independently selected from the group consisting of hydrogen; deuterium; a halogen group; -CN; a substituted or unsubstituted C1 to C60 alkyl group; a substituted or unsubstituted C6 to C60 aryl group; and a substituted or unsubstituted C2 to C60 heteroaryl group, or two or more groups adjacent to each other may bond to each other to form a substituted or unsubstituted C6 to C60 aromatic ring.

In another embodiment, R21 to R25 are the same as or different from each other, and each independently selected from the group consisting of hydrogen; a substituted or unsubstituted C6 to C60 aryl group; and a substituted or unsubstituted C2 to C60 heteroaryl group, or two or more groups adjacent to each other may bond to each other to form a substituted or unsubstituted C6 to C60 aromatic ring.

In another embodiment, R21 to R25 are the same as or different from each other, and each independently selected from the group consisting of hydrogen; a C6 to C60 aryl group; and a C2 to C60 heteroaryl group, or two or more groups adjacent to each other may bond to each other to form a C6 to C60 aromatic ring.

In another embodiment, R21 to R25 are the same as or different from each other, and each independently selected from the group consisting of hydrogen; a C6 to C40 aryl group; and a C2 to C40 heteroaryl group, or two or more groups adjacent to each other may bond to each other to form a C6 to C40 aromatic ring.

In an embodiment, according to the present invention, R21 to R25 are the same as or different from each other, and each independently hydrogen; a phenyl group; a biphenyl group; a triphenylenyl group; or a dibenzothiophene group, or groups adjacent to each other may bond to each other to form a phenyl ring.

In one embodiment of the present application, R21 to R24 are the same as or different from each other, and each independently selected from the group consisting of hydrogen; deuterium; a halogen group; -CN; a substituted or unsubstituted C1 to C60 alkyl group; a substituted or unsubstituted C6 to C60 aryl group; and a substituted or unsubstituted C2 to C60 heteroaryl group, or two or more groups adjacent to each other may bond to each other to form a substituted or unsubstituted C6 to C60 aromatic ring.

In one embodiment of the present application, R21 to R24 are the same as or different from each other, and each independently selected from the group consisting of hydrogen; deuterium; a halogen group; -CN; a substituted or unsubstituted C1 to C60 alkyl group; a substituted or unsubstituted C6 to C60 aryl group; and a substituted or unsubstituted C2 to C60 heteroaryl group, or two or more groups adjacent to each other may bond to each other to form a substituted or unsubstituted C6 to C60 aromatic ring.

In one embodiment of the present application, R21 to R24 are the same as or different from each other, and each independently selected from the group consisting of hydrogen; deuterium; a substituted or unsubstituted C6 to C30 aryl group; and a substituted or unsubstituted C2 to C30 heteroaryl group, or two or more groups adjacent to each other may bond to each other to form a substituted or unsubstituted C6 to C30 aromatic ring.

In one embodiment of the present application, R21 to R24 are the same as or different from each other, and each independently selected from the group consisting of hydrogen; deuterium; and a substituted or unsubstituted C6 to C30 aryl group, or two or more groups adjacent to each other may bond to each other to form a substituted or unsubstituted C6 to C30 aromatic ring.

In one embodiment of the present application, R21 to R24 are the same as or different from each other, and each independently selected from the group consisting of hydrogen; deuterium; and a C6 to C30 aryl group, or two or more groups adjacent to each other may bond to each other to form a C6 to C30 aromatic ring.

In one embodiment of the present application, R21 to R24 are the same as or different from each other, and each independently selected from the group consisting of hydrogen; deuterium; and a phenyl group, or two or more groups adjacent to each other may bond to each other to form a benzene ring.

In one embodiment of the present application, R25 may be selected from the group consisting of hydrogen; deuterium; a halogen group; -CN; a substituted or unsubstituted C1 to C60 alkyl group; a substituted or unsubstituted C6 to C60 aryl group; and a substituted or unsubstituted C2 to C60 heteroaryl group.

In one embodiment of the present application, R25 may be hydrogen; or deuterium.

In one embodiment of the present application, X1 may be O.

In one embodiment of the present application, X1 may be **S.**

In one embodiment of the present application, X1 may be N(R31) .

In one embodiment of the present application, X1 may be C (R32) (R33) .

In one embodiment of the present application, R31 to R33 are the same as or different from each other, and each independently selected from the group consisting of a substituted or unsubstituted C1 to C60 alkyl group; a substituted or unsubstituted C6 to C60 aryl group; and a substituted or unsubstituted C2 to C60 heteroaryl group, or two or more groups adjacent to each other may bond to each other to form a substituted or unsubstituted C6 to C60 aromatic ring.

In another embodiment, R31 to R33 are the same as or different from each other, and each independently selected from the group consisting of a substituted or unsubstituted C1 to C40 alkyl group; a substituted or unsubstituted C6 to C40 aryl group; and a substituted or unsubstituted C2 to C40 heteroaryl group, or two or more groups adjacent to each other may bond to each other to form a substituted or unsubstituted C6 to C40 aromatic ring.

In another embodiment, R31 to R33 are the same as or different from each other, and each independently selected from the group consisting of a C1 to C40 alkyl group; and a C6 to C40 aryl group, or two or more groups adjacent to each other may bond to each other to form a C6 to C40 aromatic ring.

In another embodiment, R31 to R33 are the same as or different from each other, and each independently selected from the group consisting of a methyl group and a phenyl group, or two or more groups adjacent to each other may bond to each other to form a fluorenyl group.

In another embodiment, R31 may be a phenyl group.

In another embodiment, R32 and R33 may be a methyl group.

In another embodiment, R32 and R33 may bond to each other to form a fluorenyl group.

In one embodiment of the present application, Z1 is a substituted or unsubstituted amine group, or represented by Chemical Formula 1-1.

In one embodiment of the present application, Z1 may be a substituted or unsubstituted amine group; or a substituted or unsubstituted heteroaryl group including O or S.

In one embodiment of the present application, Z1 may be a substituted or unsubstituted amine group; a substituted or unsubstituted dibenzofuran group; a substituted or unsubstituted naphthobenzofuran group; or a substituted or unsubstituted dibenzothiophene group.

In one embodiment of the present application, Z1 may be a substituted or unsubstituted amine group; a dibenzofuran group unsubstituted or substituted with an aryl group; a naphthobenzofuran group unsubstituted or substituted with an aryl group; or a dibenzothiophene group unsubstituted or substituted with an aryl group.

In one embodiment of the present application, Z1 may be - CN; or an amine group unsubstituted or substituted with one or more substituents selected from the group consisting of a C6 to C60 aryl group and a C2 to C60 heteroaryl group, or represented by Chemical Formula 1-1.

In another embodiment, Z1 may be -CN; or an amine group unsubstituted or substituted with one or more substituents selected from the group consisting of a C6 to C40 aryl group and a C2 to C40 heteroaryl group, or represented by Chemical Formula 1-1.

In an embodiment, according to the present invention, Z1 is -CN; or an amine group unsubstituted or substituted with one or more substituents selected from the group consisting of a phenyl group, a biphenyl group, a naphthyl group, a dimethylfluorenyl group, a dibenzothiophene group and a dibenzofuran group, or represented by Chemical Formula 1-1.

In one embodiment of the present application, when Z1 of Chemical Formula 1 has a substituted or unsubstituted amine group, it may be represented by the following Chemical Formula 1-2.

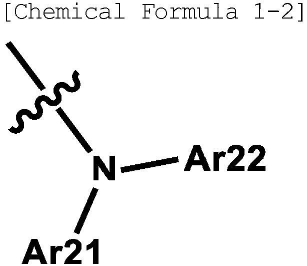

In Chemical Formula 1-2,
Ar21 and Ar22 are the same as or different from each other, and each independently a substituted or unsubstituted C6 to C60 aryl group; or a substituted or unsubstituted C2 to C60 heteroaryl group.

In one embodiment of the present application, Ar21 and Ar22 are the same as or different from each other, and may be each independently a substituted or unsubstituted C6 to C60 aryl group; or a substituted or unsubstituted C2 to C60 heteroaryl group.

In another embodiment, Ar21 and Ar22 are the same as or different from each other, and may be each independently a substituted or unsubstituted C6 to C40 aryl group; or a substituted or unsubstituted C2 to C40 heteroaryl group.

In another embodiment, Ar21 and Ar22 are the same as or different from each other, and may be each independently a C6 to C40 aryl group unsubstituted or substituted with one or more substituents selected from among a C1 to C20 alkyl group, a C6 to C40 aryl group and a C2 to C40 heteroaryl group; or a C2 to C40 heteroaryl group unsubstituted or substituted with a C6 to C40 aryl group.

In another embodiment, Ar21 and Ar22 are the same as or different from each other, and may be each independently a C6 to C20 aryl group unsubstituted or substituted with one or more substituents selected from among a C1 to C10 alkyl group, a C6 to C20 aryl group and a C2 to C20 heteroaryl group; or a C2 to C20 heteroaryl group unsubstituted or substituted with a C6 to C20 aryl group.

In another embodiment, Ar21 and Ar22 are the same as or different from each other, and may be each independently a C6 to C40 aryl group unsubstituted or substituted with a C6 to C40 aryl group; or a C2 to C40 heteroaryl group unsubstituted or substituted with a C6 to C40 aryl group.

In another embodiment, Ar21 and Ar22 are the same as or different from each other, and may be each independently a phenyl group unsubstituted or substituted with a naphthyl group; a biphenyl group; a naphthyl group; a dimethylfluorenyl group; a dibenzofuran group; a dibenzothiophene group; or a carbazole group unsubstituted or substituted with a phenyl group.

In another embodiment, Ar21 and Ar22 are the same as or different from each other, and may be each independently a phenyl group unsubstituted or substituted with a naphthyl group, a dibenzothiophene group or a carbazole group; a biphenyl group; a naphthyl group; a dimethylfluorenyl group; a dibenzofuran group; a dibenzothiophene group; or a carbazole group unsubstituted or substituted with a phenyl group.

In one embodiment of the present application, Chemical Formula 1-2 may be represented by any one of the following Chemical Formulae 1-2-1 to 1-2-3.

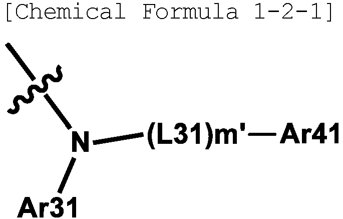

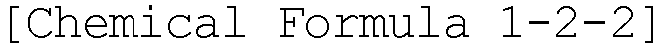

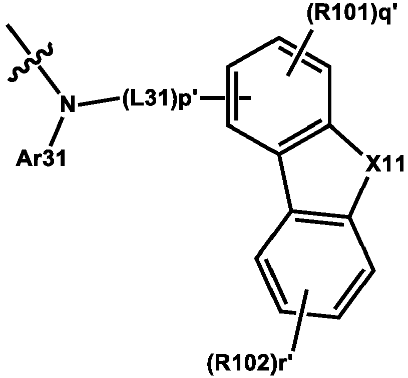

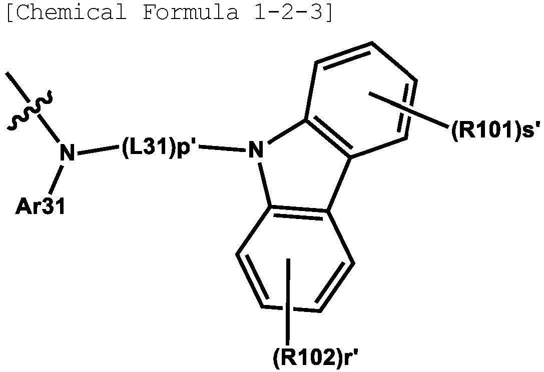

In Chemical Formulae 1-2-1 to 1-2-3,
X11 is O; S; or N(R103),
Ar31 and Ar41 are a substituted or unsubstituted C6 to C60 aryl group,
L31 is a direct bond; a substituted or unsubstituted C6 to C60 arylene group; or a substituted or unsubstituted C2 to C60 heteroarylene group,
R101 and R102 are the same as or different from each other, and each independently hydrogen; deuterium; a halogen group; - CN; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; or a substituted or unsubstituted C2 to C60 heteroaryl group,
R103 is a substituted or unsubstituted C6 to C60 aryl group,
r' and s' are each an integer of 0 to 4,
m' and p' are each an integer of 0 to 5,
q' is an integer of 0 to 3, and
when r', s', m', p' and q' are each 2 or greater, substituents in each parenthesis are the same as or different from each other.

In one embodiment of the present application, Ar31 and Ar41 are a substituted or unsubstituted C6 to C60 aryl group.

In another embodiment, Ar31 and Ar41 are a substituted or unsubstituted C6 to C40 aryl group.

In another embodiment, Ar31 and Ar41 are a C6 to C40 aryl group unsubstituted or substituted with a C1 to C10 alkyl group.

In another embodiment, Ar31 and Ar41 may be a phenyl group; a biphenyl group; a naphthyl group; or a dimethylfluorenyl group.

In one embodiment of the present application, L31 may be a direct bond; a substituted or unsubstituted C6 to C60 arylene group; or a substituted or unsubstituted C2 to C60 heteroarylene group.

In another embodiment, L31 may be a direct bond; or a substituted or unsubstituted C6 to C60 arylene group.

In another embodiment, L31 may be a direct bond; or a substituted or unsubstituted C6 to C40 arylene group.

In another embodiment, L31 may be a direct bond; or a C6 to C40 arylene group.

In another embodiment, L31 may be a direct bond; or a monocyclic or polycyclic C6 to C40 arylene group.

In another embodiment, L31 may be a direct bond; or a phenylene group.

In one embodiment of the present application, R101 and R102 are the same as or different from each other, and may be each independently hydrogen; deuterium; a substituted or unsubstituted C6 to C60 aryl group; or a substituted or unsubstituted C2 to C60 heteroaryl group.

In one embodiment of the present application, R101 and R102 are the same as or different from each other, and may be each independently hydrogen; or deuterium.

In one embodiment of the present application, R103 may be a substituted or unsubstituted C6 to C60 aryl group.

In another embodiment, R103 may be a substituted or unsubstituted C6 to C40 aryl group.

In another embodiment, R103 may be a C6 to C40 aryl group.

In another embodiment, R103 may be a C6 to C20 aryl group.

In another embodiment, R103 may be a phenyl group.

The heterocyclic compound represented by Chemical Formula 2 has, while having high thermal stability, proper molecular weight and band gap particularly when N-Het' is linked without a linker. Using such a compound in a light emitting layer of an organic light emitting device prevents a loss of electrons and holes helping with effective formation of a recombination zone of electrons and holes. When recombination efficiency increases as above, current efficiency increases, and as a result, high efficiency and an increase in the lifetime of the organic light emitting device may be expected when using the heterocyclic compound represented by Chemical Formula 2 as an organic material in the organic light emitting device.

In one embodiment of the present application, Chemical Formula 2 may be represented by any one of the following Chemical Formulae 2-1 to 2-3.

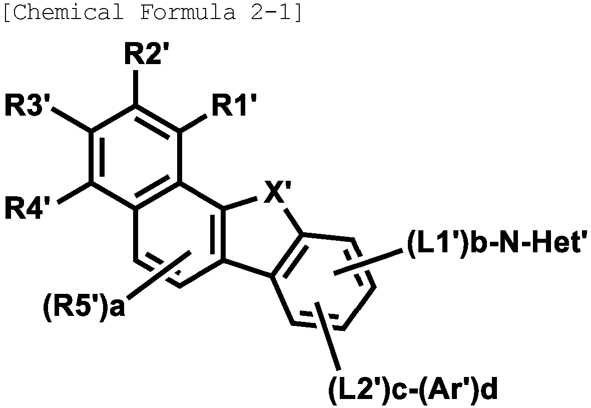

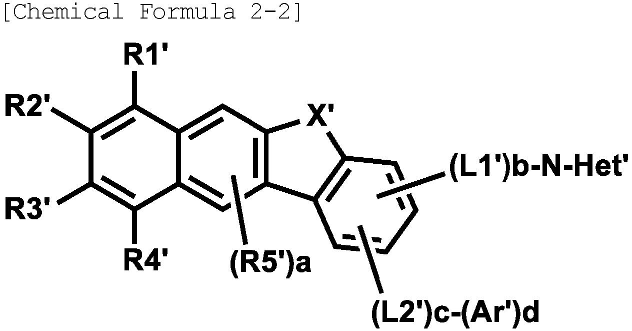

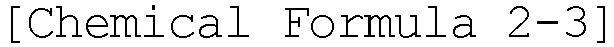

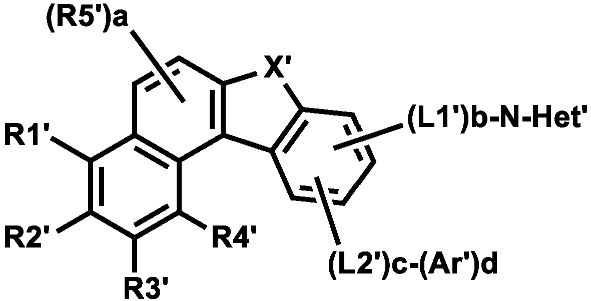

In Chemical Formulae 2-1 to 2-3,
each substituent has the same definition as in Chemical Formula 2.

In one embodiment of the present application, Chemical Formula 2 may be represented by Chemical Formula 2-2 or 2-3.

In one embodiment of the present application, Chemical Formula 2 may be represented by any one of the following Chemical Formulae 2-4 to 2-7.

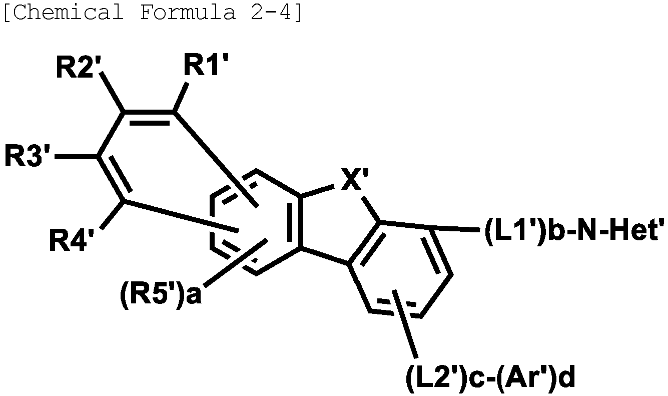

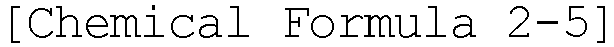

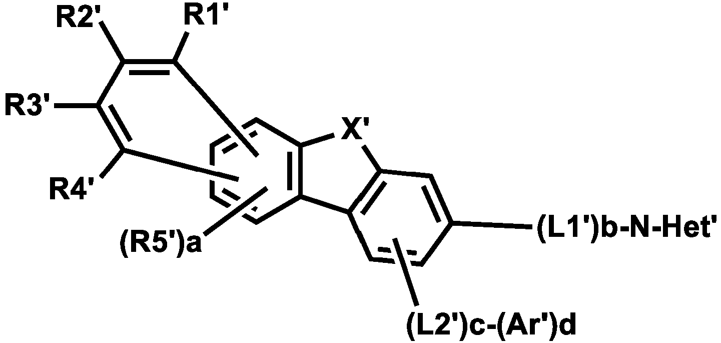

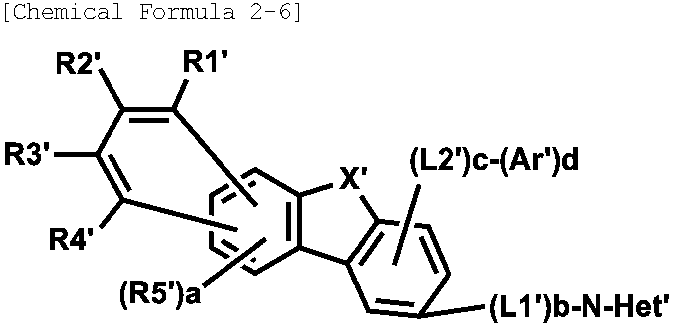

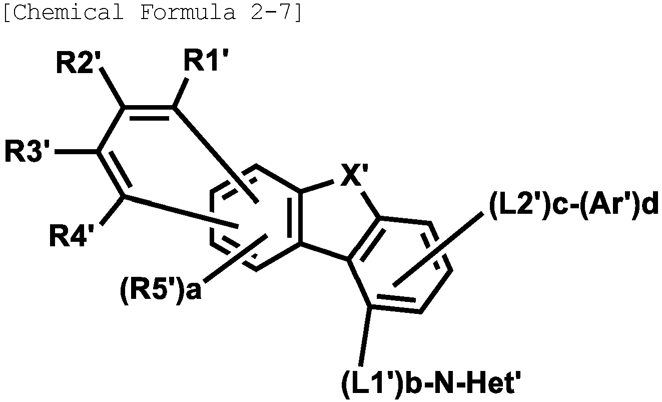

In Chemical Formulae 2-4 to 2-7,
each substituent has the same definition as in Chemical Formula 2.

In one embodiment of the present application, L1' and L2' are the same as or different from each other, and may be each independently a direct bond; a substituted or unsubstituted C6 to C60 arylene group; or a substituted or unsubstituted C2 to C60 heteroarylene group.

In another embodiment, L1' and L2' are the same as or different from each other, and may be each independently a direct bond; a substituted or unsubstituted C6 to C40 arylene group; or a substituted or unsubstituted C2 to C40 heteroarylene group.

In another embodiment, L1' and L2' are the same as or different from each other, and may be each independently a direct bond; a C6 to C40 arylene group; or a C2 to C40 heteroarylene group.

In another embodiment, L1' and L2' are the same as or different from each other, and may be each independently a direct bond; or a C6 to C40 arylene group.

In another embodiment, L1' and L2' are the same as or different from each other, and may be each independently a direct bond; or a C6 to C20 monocyclic or polycyclic arylene group.

In another embodiment, L1' and L2' are the same as or different from each other, and may be each independently a direct bond; or a C6 to C10 monocyclic arylene group; or a C10 to C20 polycyclic arylene group.

In an embodiment, according to the present invention, L1' and L2' are the same as or different from each other, and are each independently a direct bond; a phenylene group; a biphenylene group; or a naphthalene group.

In one embodiment of the present application, X' may be O; or S.

In one embodiment of the present application, X' may be O.

In one embodiment of the present application, X' may be S.

In one embodiment of the present application, N-Het' may be a monocyclic or polycyclic heterocyclic group substituted or unsubstituted and including one or more Ns.

In another embodiment, N-Het' may be a monocyclic or polycyclic heterocyclic group substituted or unsubstituted and including one or more and three or less Ns.

In another embodiment, N-Het' may be a monocyclic or polycyclic heterocyclic group substituted or unsubstituted and including one or more and two or less Ns.

In another embodiment, N-Het' may be a monocyclic or polycyclic heterocyclic group substituted or unsubstituted and including one or two Ns.

In another embodiment, N-Het' may be a triazine group; a pyrimidine group; a pyridine group; a quinazoline group; a phenanthroline group; a benzo[4,5]furo[2,3-d]pyrimidine group; or a benzo[4,5]thieno[2,3-d] pyrimidine group, and the substituents may be further substituted with one or more substituents selected form the group consisting of a substituted or unsubstituted C6 to C60 aryl group and a substituted or unsubstituted C2 to C60 heteroaryl group.

In another embodiment, N-Het' may be a triazine group; a pyrimidine group; a quinazoline group; a benzo[4,5]furo[2,3-d]pyrimidine group; or a benzo[4,5]thieno[2,3-d]pyrimidine group, and the substituents may be further substituted with one or more substituents selected form the group consisting of a phenyl group unsubstituted or substituted with an aryl group, a biphenyl group, a terphenyl group, a naphthyl group unsubstituted or substituted with an aryl group, a dimethylfluorenyl group, a triphenylene group, a dibenzofuran group, a dibenzothiophene group, and a carbazole group unsubstituted or substituted with an aryl group.

In another embodiment, N-Het' may be a triazine group unsubstituted or substituted with one or more substituents selected form the group consisting of a phenyl group unsubstituted or substituted with a naphthyl group, a biphenyl group, a terphenyl group, a naphthyl group unsubstituted or substituted with a phenyl group, a dimethylfluorenyl group, a triphenylene group, a dibenzofuran group, a dibenzothiophene group, and a carbazole group substituted with a phenyl group; a pyrimidine group unsubstituted or substituted with a phenyl group; a quinazoline group unsubstituted or substituted with one or more substituents selected form the group consisting of a phenyl group unsubstituted or substituted with a naphthyl group, a biphenyl group, a terphenyl group, a naphthyl group unsubstituted or substituted with a phenyl group, and a dibenzofuran group; a benzo[4,5]furo[2,3-d]pyrimidine group unsubstituted or substituted with one or more substituents selected form the group consisting of a phenyl group, a biphenyl group and a naphthyl group; or a benzo[4,5]thieno[2,3-d]pyrimidine group unsubstituted or substituted with one or more substituents selected form the group consisting of a phenyl group unsubstituted or substituted with a naphthyl group, a biphenyl group, a naphthyl group and a dibenzofuran group.

In another embodiment, N-Het' may be a monocyclic or polycyclic C2 to C60 heterocyclic group unsubstituted or substituted with one or more substituents selected form the group consisting of a C6 to C60 aryl group and a C2 to C60 heteroaryl group, and including one or more Ns.

In another embodiment, N-Het' may be a triazine group; a pyrimidine group; a pyridine group; a quinoline group; a quinazoline group; an imidazole group; a benzothiazole group; a benzofuro[3,2-d]pyrimidine group; or a benzo[4,5]thieno[2,3-d]pyrimidine group, unsubstituted or substituted with one or more substituents selected form the group consisting of a C6 to C60 aryl group and a C2 to C60 heteroaryl group.

In an embodiment, according to the present invention, N-Het' is a triazine group unsubstituted or substituted with one or more substituents selected form the group consisting of a phenyl group, a biphenyl group, a naphthyl group, a triphenylenyl group, a dibenzofuran group, a dibenzothiophene group and a carbazole group; a pyrimidine group unsubstituted or substituted with a phenyl group; a pyridine group unsubstituted or substituted with a phenyl group; a quinazoline group unsubstituted or substituted with one or more substituents selected form the group consisting of a phenyl group, a biphenyl group, a terphenyl group and a naphthyl group; a benzofuro[3,2-d]pyrimidine group unsubstituted or substituted with a phenyl group or a naphthyl group; or a benzo [4,5]thieno[2,3-d]pyrimidine group unsubstituted or substituted with a phenyl group or a naphthyl group.

In one embodiment of the present application, N-Het' may be substituted again with a phenyl group; or a naphthyl group.

In another embodiment, N-Het' may be represented by the following Chemical Formula A.

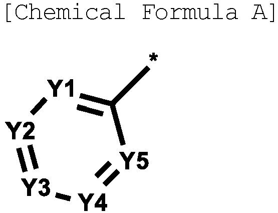

In Chemical Formula A,
* is a position at which Chemical Formula 2 and N-Het' bond,
Y1 to Y5 are the same as or different from each other and each independently N or C(Rb), at least one of Y1 to Y5 is N, and when C(Rb) is 2 or greater, each Rbs are the same as or different from each other, and
Rbs are the same as or different from each other, and each independently selected from the group consisting of hydrogen; deuterium; a substituted or unsubstituted C6 to C60 aryl group; and a substituted or unsubstituted C2 to C60 heteroaryl group, or two or more groups adjacent to each other may bond to each other to form a substituted or unsubstituted C6 to C60 aromatic hydrocarbon ring or a substituted or unsubstituted C2 to C60 heteroring.

In one embodiment of the present application, * of Chemical Formula A means a position linked to L1' of Chemical Formula 2.

In one embodiment of the present application, Chemical Formula A may be represented by any one of the following Chemical Formulae A-1 to A-7.

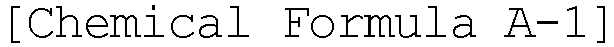

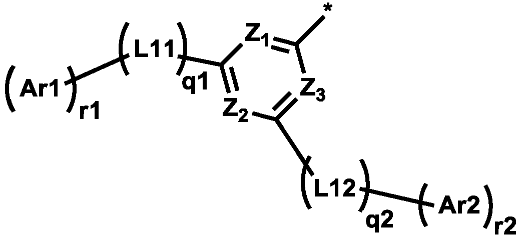

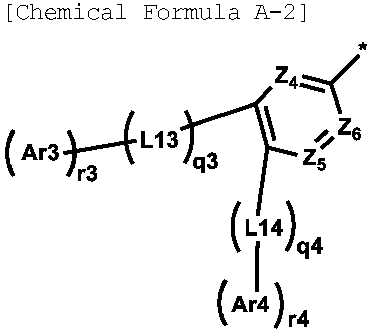

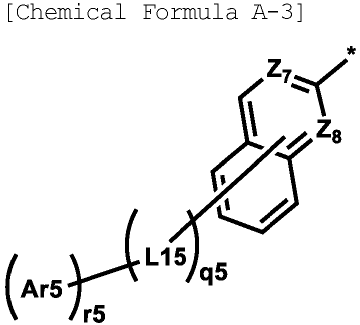

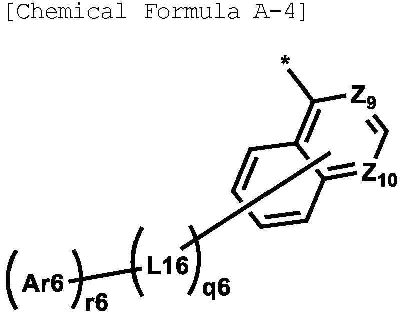

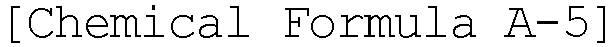

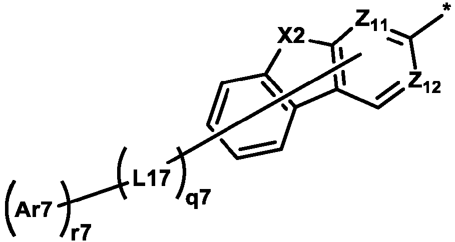

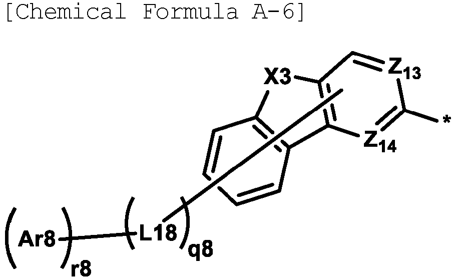

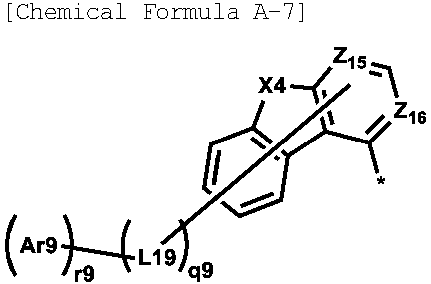

In Chemical Formulae A-1 to A-7,
* is a position at which Chemical Formula 2 and N-Het' bond,
Z₁ to Z₁₆ are the same as or different from each other and each independently N or CH, at least one of Z₁ to Z₃ is N, at least one of Z₄ to Z₆ is N, at least one of Z₇ and Z₈ is N, at least one of Z₉ and Z₁₀ is N, at least one of Z₁₁ and Z₁₂ is N, at least one of Z₁₃ and Z₁₄ is N, and at least one of Z₁₅ and Z₁₆ is N,
L11 to L19 are the same as or different from each other, and each independently a direct bond; a substituted or unsubstituted C6 to C60 arylene group; or a substituted or unsubstituted C2 to C60 heteroarylene group,
Ar1 to Ar9 are the same as or different from each other, and each independently hydrogen; deuterium; a substituted or unsubstituted C6 to C60 aryl group; or a substituted or unsubstituted C2 to C60 heteroaryl group,
X2 to X4 are the same as or different from each other, and each independently O; or S,
q1 to q9 are each independently an integer of 0 to 2, and when q1 to q9 are each 2, substituents in the parentheses are the same as or different from each other, and
r1 to r4 are each independently an integer of 1 to 3, r5 to r9 are each independently an integer of 1 to 5, and when r1 to r9 are each 2 or greater, substituents in the parentheses are the same as or different from each other.

In one embodiment of the present application, Z₁ to Z₃ of Chemical Formula A-1 are the same as or different from each other and each independently N or CH, and at least one of Z₁ to Z₃ may be N.

In one embodiment of the present application, Z₁ is N, and Z₂ and Z₃ are CH.

In one embodiment of the present application, Z₂ is N, and Z₁ and Z₃ are CH.

In one embodiment of the present application, Z₃ is N, and Z₁ and Z₂ are CH.

In one embodiment of the present application, Z₁ is CH, and Z₂ and Z₃ are N.

In one embodiment of the present application, Z₂ is CH, and Z₁ and Z₃ are N.

In one embodiment of the present application, Z₃ is CH, and Z₁ and Z₂ are N.

In one embodiment of the present application, Z₁ to Z₃ are N.

In one embodiment of the present application, Z₄ to Z₆ of Chemical Formula A-2 are the same as or different from each other and each independently N or CH, and at least one of Z₄ to Z₆ may be N.

In one embodiment of the present application, Z₄ is N, and Z₅ and Z₆ are CH.

In one embodiment of the present application, Z₅ is N, and Z₄ and Z₆ are CH.

In one embodiment of the present application, Z₆ is N, and Z₄ and Z₅ are CH.

In one embodiment of the present application, Z₄ is CH, and Z₅ and Z₆ are N.

In one embodiment of the present application, Z₅ is CH, and Z₄ and Z₆ are N.

In one embodiment of the present application, Z₆ is CH, and Z₄ and Z₅ are N.

In one embodiment of the present application, Z₄ to Z₆ are N.

In one embodiment of the present application, Z₇ and Z₈ of Chemical Formula A-3 are the same as or different from each other and each independently N or CH, and at least one of Z₇ and Z₈ may be N.

In one embodiment of the present application, Z₇ is N, and Z₈ is CH.

In one embodiment of the present application, Z₈ is N, and Z₇ is CH.

In one embodiment of the present application, Z₇ and Z₈ are N.

In one embodiment of the present application, Z₉ and Z₁₀ of Chemical Formula A-4 are the same as or different from each other and each independently N or CH, and at least one of Z₉ and Z₁₀ may be N.

In one embodiment of the present application, Z₉ is N, and Z₁₀ is CH.

In one embodiment of the present application, Z₁₀ is N, and Z₉ is CH.

In one embodiment of the present application, Z₉ and Z₁₀ are N.

In one embodiment of the present application, Z₁₁ and Z₁₂ of Chemical Formula A-5 are the same as or different from each other and each independently N or CH, and at least one of Z₁₁ and Z₁₂ may be N.

In one embodiment of the present application, Z₁₁ is N, and Z₁₂ is CH.

In one embodiment of the present application, Z₁₂ is N, and Z₁₁ is CH.

In one embodiment of the present application, Z₁₁ and Z₁₂ are N.

In one embodiment of the present application, Z₁₃ and Z₁₄ of Chemical Formula A-6 are the same as or different from each other and each independently N or CH, and at least one of Z₁₃ and Z₁₄ may be N.

In one embodiment of the present application, Z₁₃ is N, and Z₁₄ is CH.

In one embodiment of the present application, Z₁₄ is N, and Z₁₃ is CH.

In one embodiment of the present application, Z₁₃ and Z₁₄ are N.

In one embodiment of the present application, Z₁₅ and Z₁₆ of Chemical Formula A-7 are the same as or different from each other and each independently N or CH, and at least one of Z₁₅ and Z₁₆ may be N.

In one embodiment of the present application, Z₁₅ is N, and Z₁₅ is CH.

In one embodiment of the present application, Z₁₆ is N, and Z₁₅ is CH.

In one embodiment of the present application, Z₁₅ and Z₁₆ are N.

In one embodiment of the present application, L1 to L9 of Chemical Formulae A-1 to A-7 are the same as or different from each other, and may be each independently a direct bond; a substituted or unsubstituted C6 to C60 arylene group; or a substituted or unsubstituted C2 to C60 heteroarylene group.

In one embodiment of the present application, L1 to L9 are the same as or different from each other, and may be each independently a direct bond; a substituted or unsubstituted C6 to C40 arylene group; or a substituted or unsubstituted C2 to C40 heteroarylene group.

In one embodiment of the present application, L1 to L9 are the same as or different from each other, and may be each independently a direct bond; a substituted or unsubstituted C6 to C20 arylene group; or a substituted or unsubstituted C2 to C20 heteroarylene group.

In one embodiment of the present application, L1 to L9 are the same as or different from each other, and may be each independently a direct bond; or a substituted or unsubstituted C6 to C20 arylene group.

In one embodiment of the present application, L1 to L9 are the same as or different from each other, and may be each independently a direct bond; a substituted or unsubstituted phenylene group; or a substituted or unsubstituted naphthylene group.

In one embodiment of the present application, L1 to L9 are the same as or different from each other, and may be each independently a direct bond; a phenylene group; or a naphthylene group.

In another embodiment, L1 is a direct bond.

In another embodiment, L1 is a phenylene group.

In another embodiment, L1 is a naphthylene group.

In another embodiment, L2 is a direct bond.

In another embodiment, L2 is a phenylene group.

In another embodiment, L2 is a naphthylene group.

In another embodiment, L3 is a direct bond.

In another embodiment, L3 is a phenylene group.

In another embodiment, L3 is a naphthylene group.

In another embodiment, L4 is a direct bond.

In another embodiment, L4 is a phenylene group.

In another embodiment, L4 is a naphthylene group.

In another embodiment, L5 is a direct bond.

In another embodiment, L5 is a phenylene group.

In another embodiment, L5 is a naphthylene group.

In another embodiment, L6 is a direct bond.

In another embodiment, L6 is a phenylene group.

In another embodiment, L6 is a naphthylene group.

In another embodiment, L7 is a direct bond.

In another embodiment, L7 is a phenylene group.

In another embodiment, L7 is a naphthylene group.

In another embodiment, L8 is a direct bond.

In another embodiment, L8 is a phenylene group.

In another embodiment, L8 is a naphthylene group.

In another embodiment, L9 is a direct bond.

In another embodiment, L9 is a phenylene group.

In another embodiment, L9 is a naphthylene group.

In one embodiment of the present application, X2 to X4 of Chemical Formulae A-5 to A-7 are the same as or different from each other, and may be each independently O; **or S.**

In one embodiment of the present application, X2 may be **O; or S.**

In one embodiment of the present application, X2 is O.

In one embodiment of the present application, X2 is **S.**

In one embodiment of the present application, X3 may be O; **or S.**

In one embodiment of the present application, X3 is O.

In one embodiment of the present application, X3 is **S.**

In one embodiment of the present application, X4 may be O; **or S.**

In one embodiment of the present application, X4 is O.

In one embodiment of the present application, X4 is **S.**

In one embodiment of the present application, q1 to q9 of Chemical Formulae A-1 to A-7 are each independently an integer of 0 to **2,** and when q1 to q9 are each **2,** substituents in the parentheses may be the same as or different from each other.

In one embodiment of the present application, Ar1 to Ar9 of Chemical Formulae A-1 to A-7 are the same as or different from each other, and may be each independently hydrogen; deuterium; a substituted or unsubstituted C6 to C60 aryl group; or a substituted or unsubstituted C2 to C60 heteroaryl group.

In one embodiment of the present application, Ar1 to Ar9 are the same as or different from each other, and may be each independently a substituted or unsubstituted C6 to C60 aryl group; or a substituted or unsubstituted C2 to C60 heteroaryl group.

In one embodiment of the present application, Ar1 to Ar9 are the same as or different from each other, and may be each independently a substituted or unsubstituted C6 to C40 aryl group; or a substituted or unsubstituted C2 to C40 heteroaryl group.

In one embodiment of the present application, Ar1 to Ar9 are the same as or different from each other, and may be each independently a substituted or unsubstituted phenyl group; a substituted or unsubstituted biphenyl group; a substituted or unsubstituted terphenyl group; a substituted or unsubstituted naphthyl group; a substituted or unsubstituted fluorenyl group; a substituted or unsubstituted triphenylene group; a substituted or unsubstituted dibenzofuran group; a substituted or unsubstituted dibenzothiophene group; or a substituted or unsubstituted carbazole group.

In one embodiment of the present application, Ar1 to Ar9 are the same as or different from each other, and may be each independently a phenyl group unsubstituted or substituted with a naphthyl group; a biphenyl group; a terphenyl group; a naphthyl group unsubstituted or substituted with a phenyl group; a dimethylfluorenyl group; a triphenylene group; a dibenzofuran group; a dibenzothiophene group; or a carbazole group substituted with a phenyl group.

In one embodiment of the present application, Ar1 to Ar9 are the same as or different from each other, and may be each independently a phenyl group; a biphenyl group; a terphenyl group; a triphenyl group; a dibenzofuran group; a dibenzothiophene group; or a substituted or unsubstituted carbazole group.

In one embodiment of the present application, r1 to r4 of Chemical Formulae A-1 to A-7 are each independently an integer of 1 to 3, r5 to r8 are each independently an integer of 1 to 5, and when r1 to r9 are each 2 or greater, substituents in the parentheses are the same as or different from each other.

In one embodiment of the present application, Ar' may be selected from the group consisting of deuterium; a halogen group; -CN; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C60 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; -P(=O)RR'; -SiRR'R"; and a substituted or unsubstituted amine group.

The compound in which Ar' of Chemical Formula 2 is a substituted or unsubstituted amine group has stronger donor properties, and a hole trap phenomenon of a dopant is resolved when using the compound in an organic material layer of an organic light emitting device by the compound further helping with hole injection, and as a result, efficiency of the organic light emitting device may be further improved.

In addition, the compound in which Ar' of Chemical Formula 2 is a substituted or unsubstituted amine group has lower HOMO and LUMO levels, and thereby has an energy level difference advantageous for exciplex formation when used in an organic material layer of an organic light emitting device, and as a result, efficiency and lifetime of the organic light emitting device may be further improved.

In one embodiment of the present application, Ar' may be selected from the group consisting of a substituted or unsubstituted C6 to C60 aryl group; a substituted or unsubstituted C2 to C60 heteroaryl group; and a substituted or unsubstituted amine group.

In another embodiment, Ar' may be selected from the group consisting of a substituted or unsubstituted C6 to C40 aryl group; a substituted or unsubstituted C2 to C40 heteroaryl group; and a substituted or unsubstituted amine group.

In another embodiment, Ar' may be selected from the group consisting of a C6 to C40 aryl group; a C2 to C40 heteroaryl group; and an amine group unsubstituted or substituted with one or more substituents selected form the group consisting of a C1 to C40 alkyl group, a C6 to C40 aryl group and a C2 to C40 heteroaryl group.

In another embodiment, Ar' may be selected from the group consisting of a C6 to C40 aryl group; a C2 to C40 heteroaryl group; and an amine group unsubstituted or substituted with one or more substituents selected form the group consisting of a C6 to C40 aryl group unsubstituted or substituted with an alkyl group, and a C2 to C40 heteroaryl group.

In an embodiment, according to the present invention, Ar' is a phenyl group; a biphenyl group; a naphthyl group; a terphenyl group; a carbazole group; a phenyl ring-fused carbazole group; or an amine group unsubstituted or substituted with one or more substituents selected form the group consisting of a phenyl group, a biphenyl group, a naphthyl group, a dimethylfluorenyl group, a dibenzofuran group and a dibenzothiophene group.

In one embodiment of the present application, Ar' may be a substituted or unsubstituted C6 to C60 aryl group; or a substituted or unsubstituted C2 to C60 heteroaryl group; or a group represented by the following Chemical Formula B.

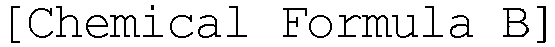

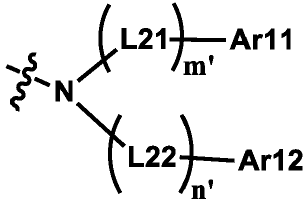

In Chemical Formula B,
L21 and L22 are the same as or different from each other, and each independently a direct bond; a substituted or unsubstituted C6 to C40 arylene group; or a substituted or unsubstituted C2 to C40 heteroarylene group,
Ar11 and Ar12 are the same as or different from each other, and each independently a substituted or unsubstituted C6 to C40 aryl group; or a substituted or unsubstituted C2 to C40 heteroaryl group,
m' and n' are each 0 or 1, and 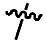 means a position bonding to L2' of Chemical Formula 2.

In one embodiment of the present application, Ar11 and Ar12 are the same as or different from each other, and may be each independently a substituted or unsubstituted C6 to C40 aryl group; or a substituted or unsubstituted C2 to C40 heteroaryl group.

In another embodiment, Ar11 and Ar12 are the same as or different from each other, and may be each independently a substituted or unsubstituted C6 to C20 aryl group; or a substituted or unsubstituted C2 to C20 heteroaryl group.

In another embodiment, Ar11 and Ar12 are the same as or different from each other, and may be each independently a C6 to C20 aryl group unsubstituted or substituted with a C1 to C10 alkyl group; or a C2 to C20 heteroaryl group.

In another embodiment, Ar11 and Ar12 are the same as or different from each other, and may be each independently a phenyl group; a biphenyl group; a naphthyl group; a dimethylfluorenyl group; a dibenzothiophene group; or a dibenzofuran group.

In one embodiment of the present application, L21 and L22 are the same as or different from each other, and may be each independently a direct bond; a substituted or unsubstituted C6 to C40 arylene group; or a substituted or unsubstituted C2 to C40 heteroarylene group.

In another embodiment, L21 and L22 are the same as or different from each other, and may be each independently a direct bond; or a substituted or unsubstituted C6 to C40 arylene group.

In another embodiment, L21 and L22 are the same as or different from each other, and may be each independently a direct bond; or a substituted or unsubstituted C6 to C20 arylene group.

In another embodiment, L21 and L22 are the same as or different from each other, and may be each independently a direct bond; a phenylene group; a biphenylene group; or a naphthalene group.

In the present application, effects of more superior efficiency and lifetime are obtained when including the heterocyclic compound of Chemical Formula 1 and the heterocyclic compound of Chemical Formula 2 in the organic material layer of the organic light emitting device. Such results may lead to a forecast that an exciplex phenomenon occurs when including the two compounds at the same time.

The exciplex phenomenon is a phenomenon of releasing energy having sizes of a donor (p-host) HOMO level and an acceptor (n-host) LUMO level due to electron exchanges between two molecules. When the exciplex phenomenon occurs between two molecules, reverse intersystem crossing (RISC) occurs, and as a result, internal quantum efficiency of fluorescence may increase up to 100%. When a donor (p-host) having a favorable hole transfer ability and an acceptor (n-host) having a favorable electron transfer ability are used as a host of a light emitting layer, holes are injected to the p-host and electrons are injected to the n-host, and therefore, a driving voltage may be lowered, which resultantly helps with enhancement in the lifetime.

In one embodiment of the present application, Chemical Formula 1 may be represented by any one of the following compounds, but is not limited thereto.

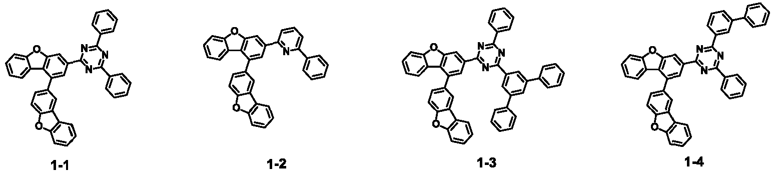

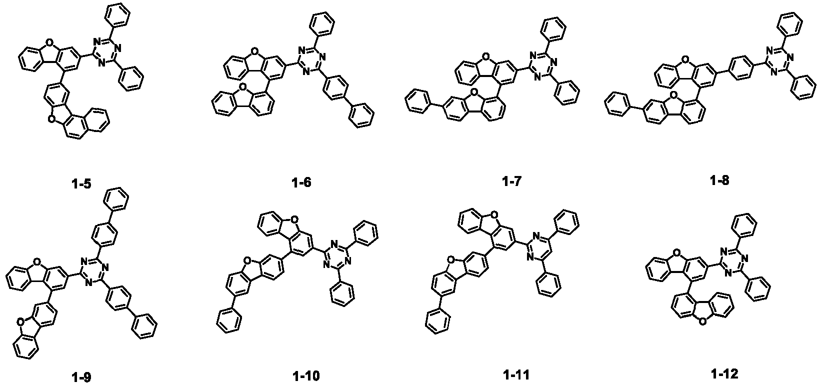

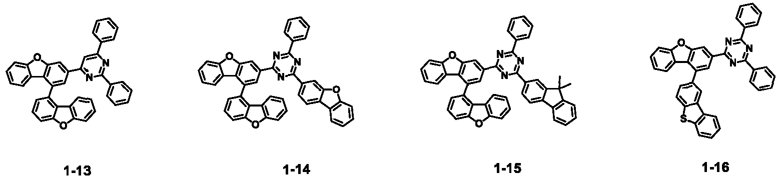

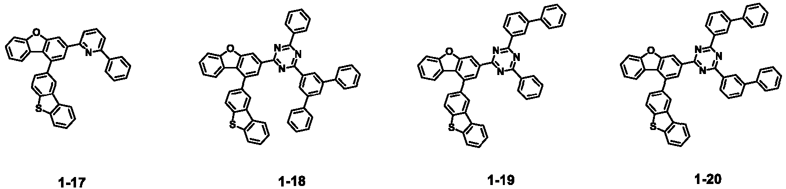

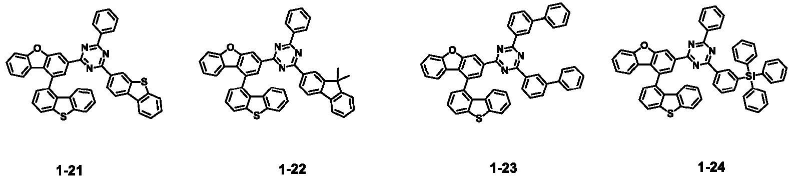

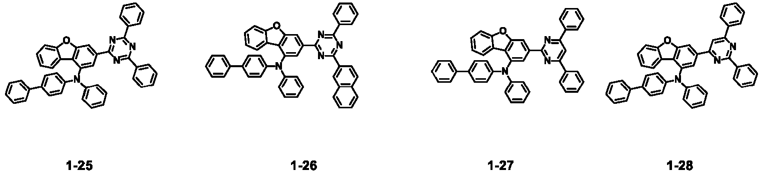

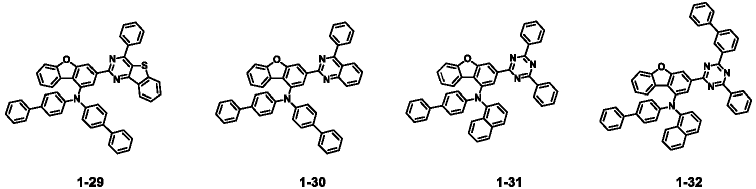

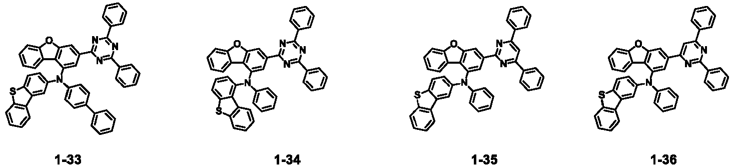

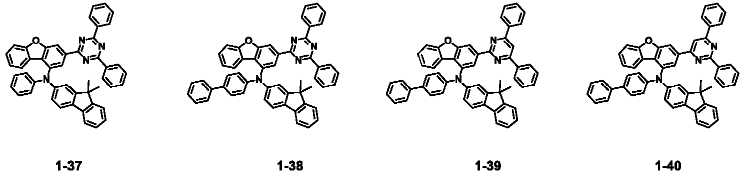

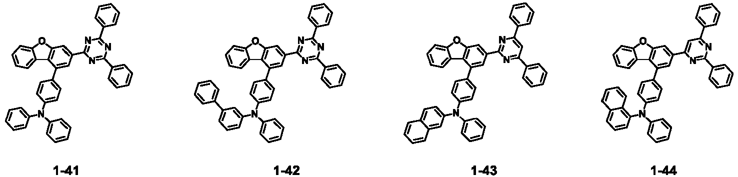

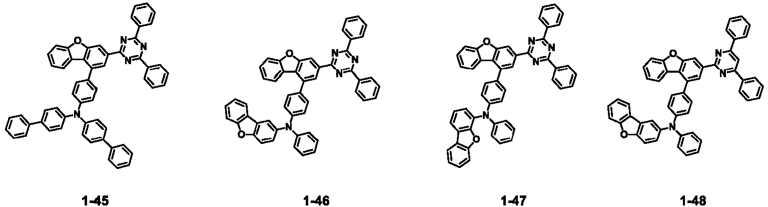

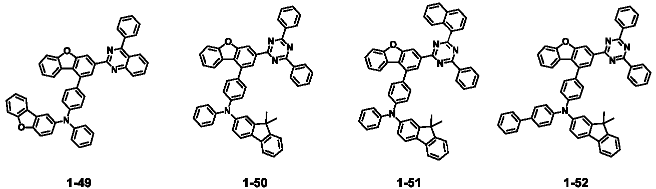

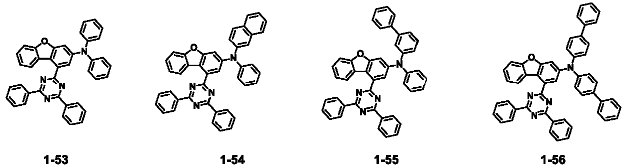

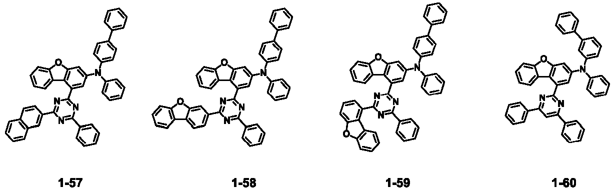

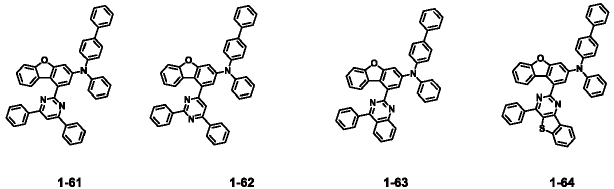

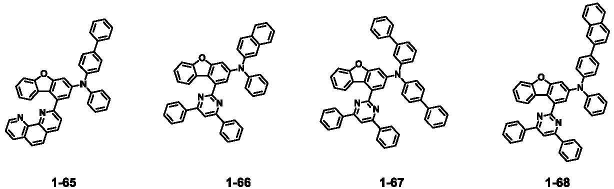

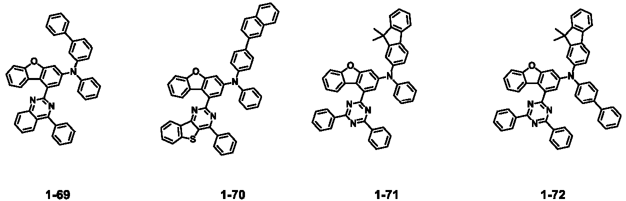

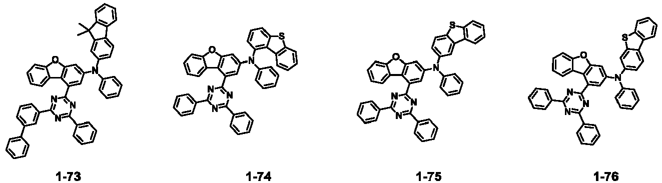

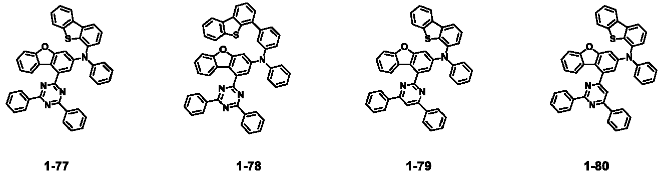

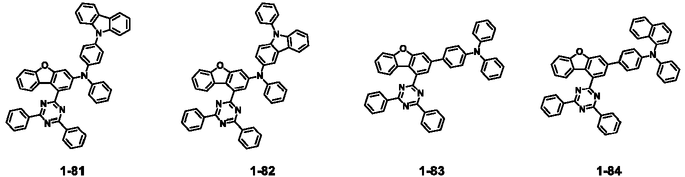

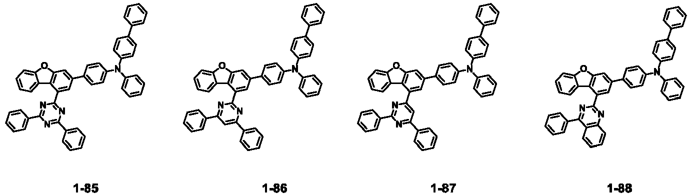

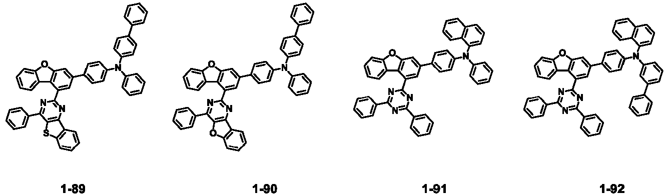

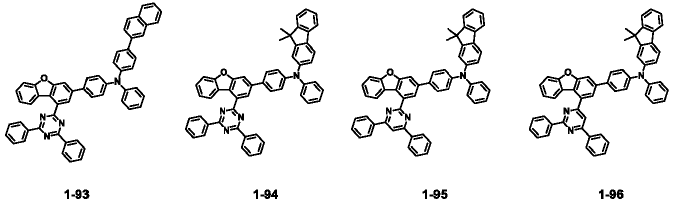

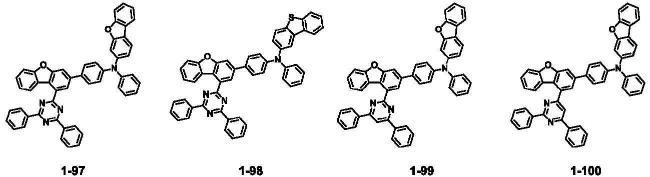

In one embodiment of the present application, Chemical Formula 2 may be represented by any one of the following compounds, but is not limited thereto.

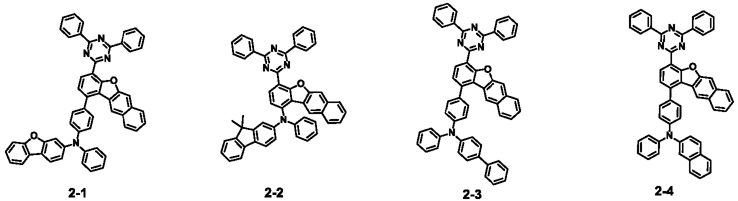

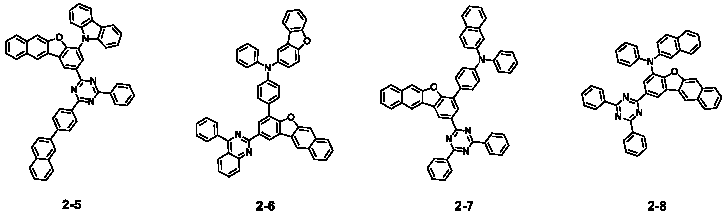

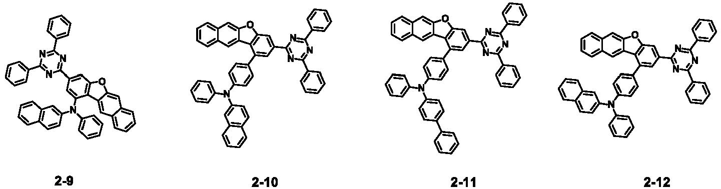

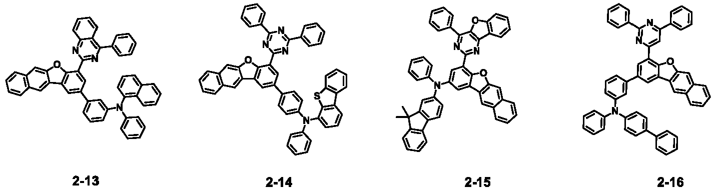

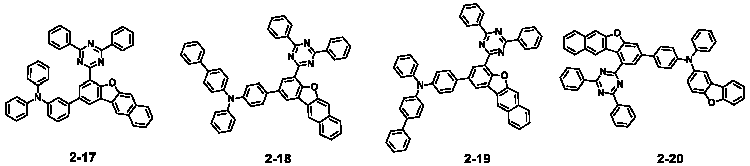

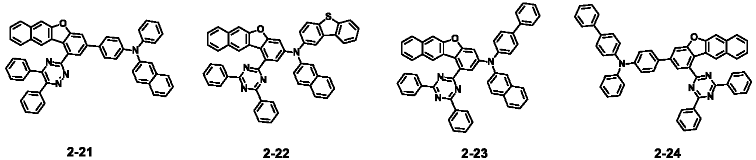

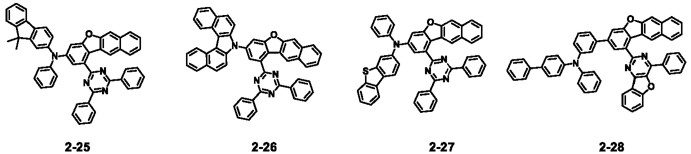

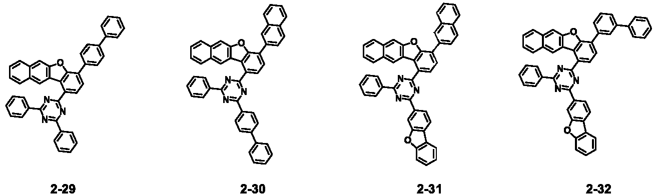

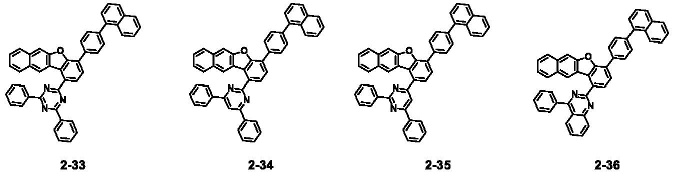

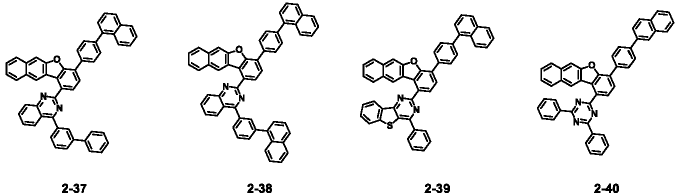

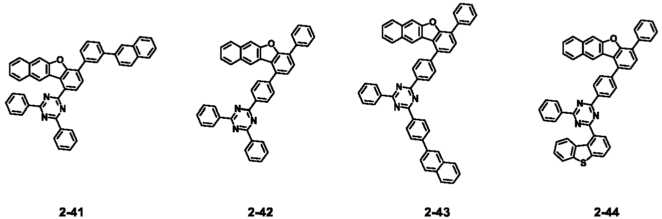

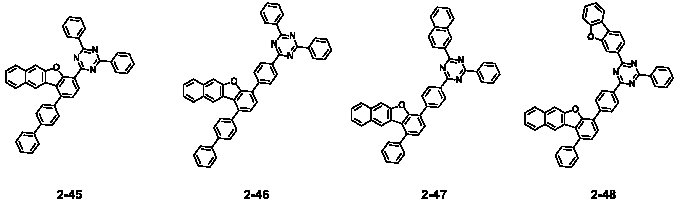

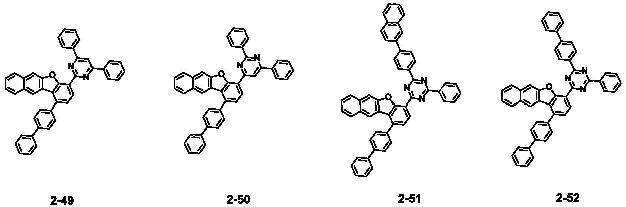

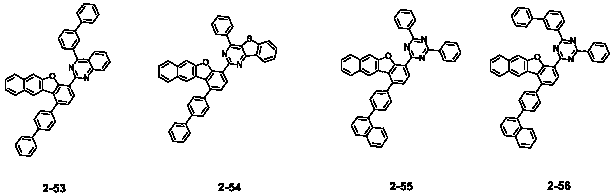

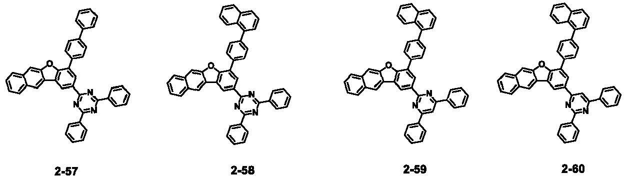

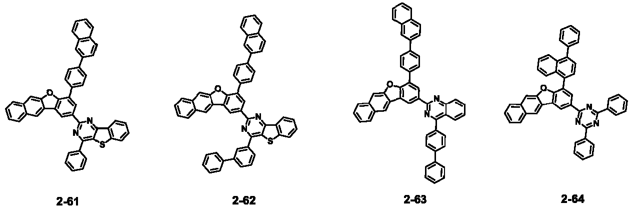

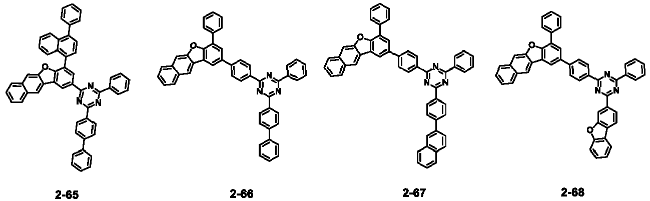

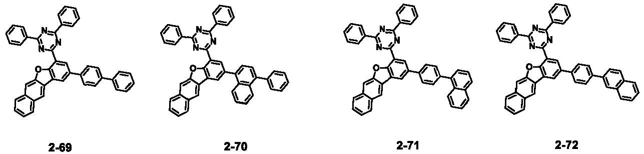

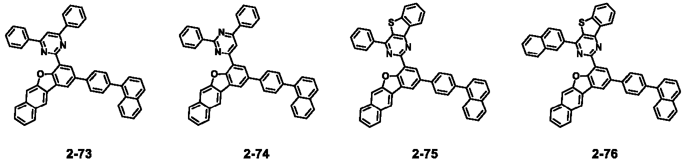

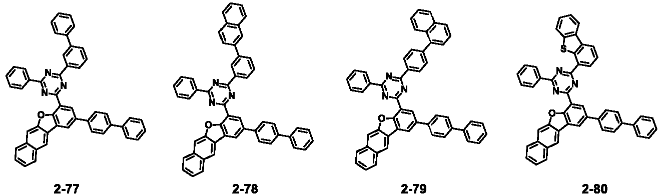

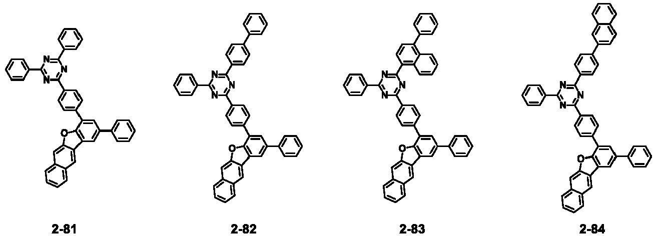

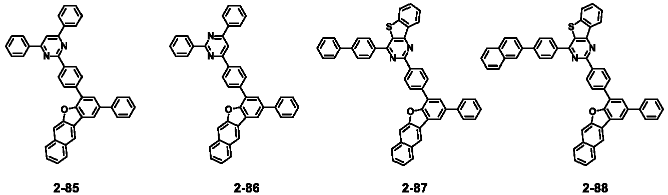

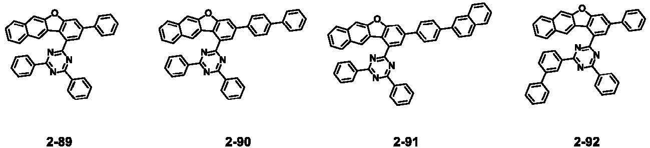

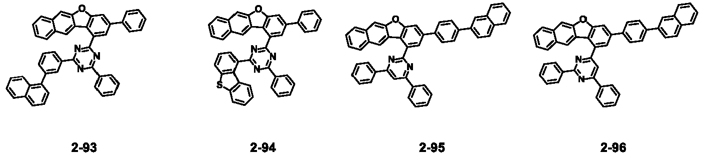

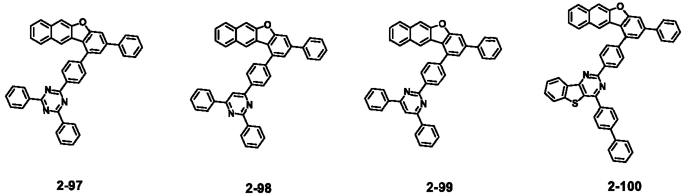

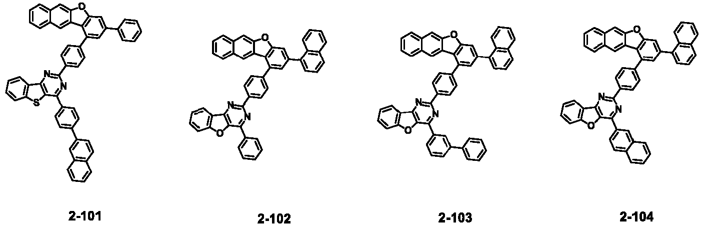

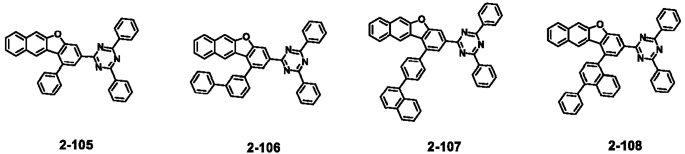

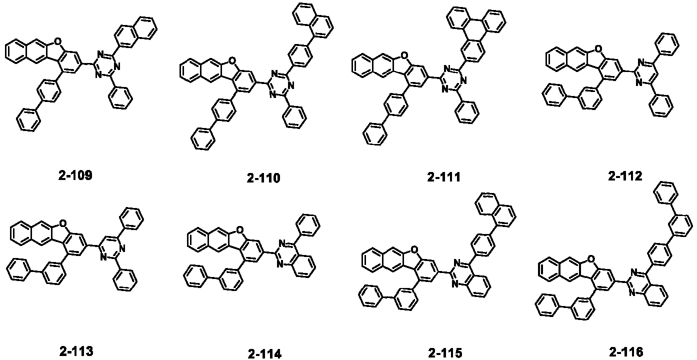

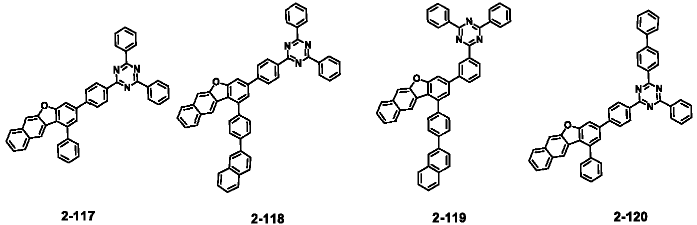

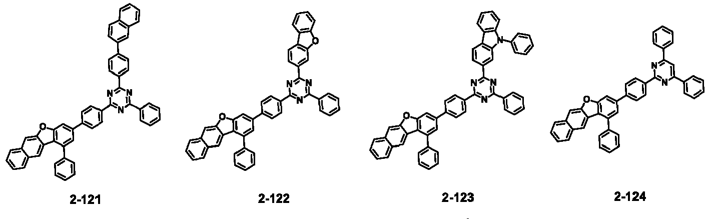

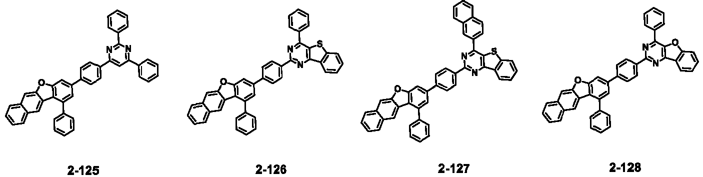

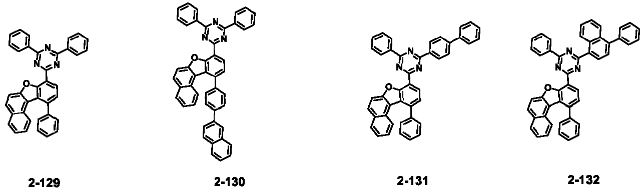

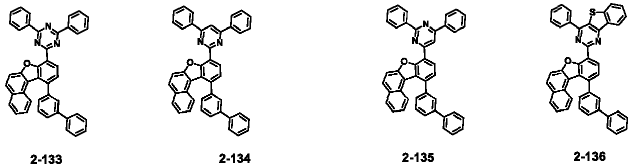

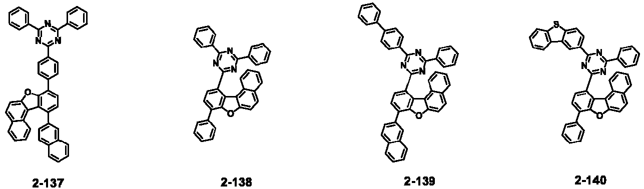

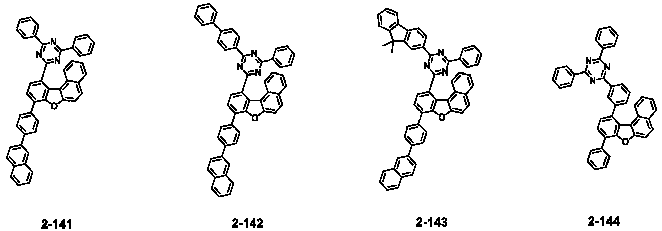

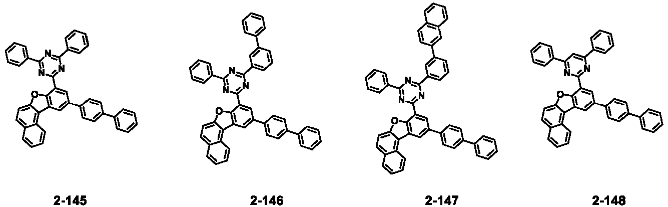

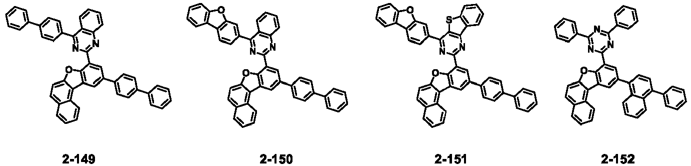

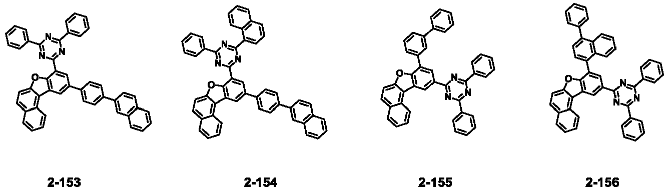

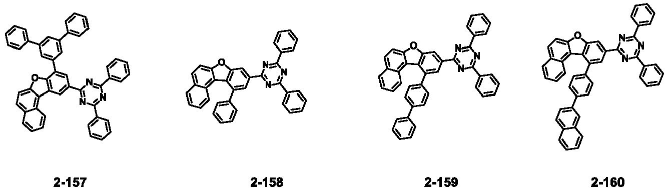

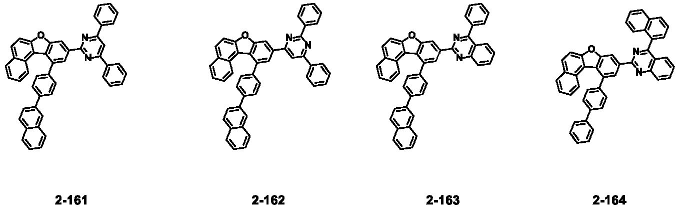

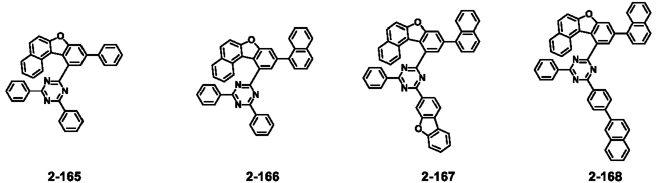

In addition, by introducing various substituents to the structures of Chemical Formulae 1 and 2, compounds having unique properties of the introduced substituents may be synthesized. For example, by introducing substituents normally used as hole injection layer materials, hole transfer layer materials, light emitting layer materials, electron transfer layer materials and charge generation layer materials used for manufacturing an organic light emitting device to the core structure, materials satisfying conditions required for each organic material layer may be synthesized.

In addition, by introducing various substituents to the structures of Chemical Formulae 1 and 2, the energy band gap may be finely controlled, and meanwhile, properties at interfaces between organic materials are enhanced, and material applications may become diverse.

Meanwhile, the heterocyclic compound has a high glass transition temperature (Tg), and has excellent thermal stability. Such an increase in the thermal stability becomes an important factor providing driving stability to a device.

The heterocyclic compound according to one embodiment of the present application may be prepared using a multi-step chemical reaction. Some intermediate compounds are prepared first, and from the intermediate compounds, the heterocyclic compound of Chemical Formula 1 or 2 may be prepared. More specifically, the heterocyclic compound according to one embodiment of the present application may be prepared based on preparation examples to describe later.

In addition, another embodiment of the present application provides a composition for an organic material layer of an organic light emitting device, the composition including the heterocyclic compound represented by Chemical Formula 1 and the compound represented by Chemical Formula 2.

Specific descriptions on the heterocyclic compound represented by Chemical Formula 1 and the compound represented by Chemical Formula 2 are the same as the descriptions provided above.

In the composition, the heterocyclic compound represented by Chemical Formula 1:the compound represented by Chemical Formula 2 may have a weight ratio of 1:10 to 10:1, 1:8 to 8:1, 1:5 to 5:1 or 1:2 to 2:1, however, the weight ratio is not limited thereto.

The composition may be used when forming an organic material of an organic light emitting device, and may be more preferably used when forming a host of a light emitting layer.

In one embodiment of the present application, the organic material layer includes the heterocyclic compound represented by Chemical Formula 1 and the heterocyclic compound represented by Chemical Formula 2, and a phosphorescent dopant may be used therewith.

In one embodiment of the present application, the organic material layer includes the heterocyclic compound represented by Chemical Formula 1 and the heterocyclic compound represented by Chemical Formula 2, and an iridium-based dopant may be used therewith.

As a material of the phosphorescent dopant, those known in the art may be used.

For example, phosphorescent dopant materials represented by LL'MX', LL'L"M, LMX'X", L₂MX' and L₃M may be used, however, the scope of the present disclosure is not limited to these examples.

Herein, L, L', L", X' and X" are a bidentate ligand different from each other, and M is a metal forming an octahedral complex.

M may include iridium, platinum, osmium and the like.

L is an anionic bidentate ligand coordinated to M as the iridium-based dopant by sp2 carbon and heteroatom, and X may function to trap electrons or holes. Nonlimiting examples of L may include 2-(1-naphthyl)benzoxazole, (2-phenylbenzoxazole), (2-phenylbenzothiazole), (2-phenylbenzothiazole), (7,8-benzoquinoline), (thiophene group pyrizine), phenylpyridine, benzothiophene group pyrizine, 3-methoxy-2-phenylpyridine, thiophene group pyrizine, tolylpyridine and the like. Nonlimiting examples of X' and X" may include acetylacetonate (acac), hexafluoroacetylacetonate, salicylidene, picolinate, 8-hydroxyquinolinate and the like.

More specific examples thereof are described below, however, the phosphorescent dopant is not limited to these examples.

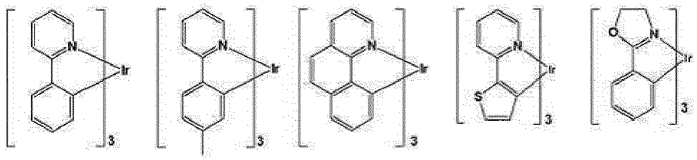

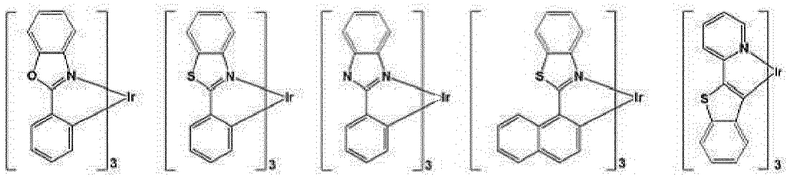

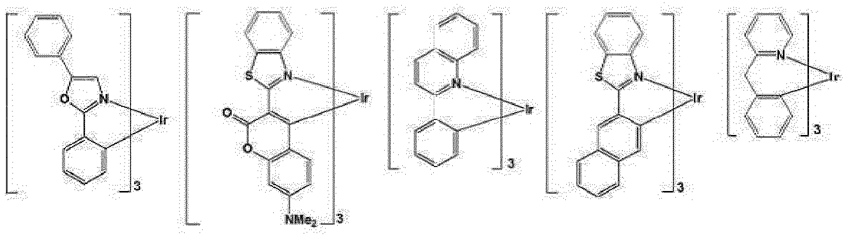

In one embodiment of the present application, as the iridium-based dopant, Ir(ppy)₃ may be used as a green phosphorescent dopant.

In one embodiment of the present application, a content of the dopant may be from 1% to 15%, preferably from 3% to 10% and more preferably from 5% to 10% based on the whole light emitting layer.

In one embodiment of the present application, the composition has a form in which two or more compounds are simply mixed, and materials in a powder state may be mixed before forming the organic material layer of the organic light emitting device, or compounds in a liquid state may be mixed at a proper temperature or higher. The composition is in a solid state below the melting point of each material, and may be maintained in a liquid state when adjusting a temperature.

The composition may further include materials known in the art such as solvents and additives.

The organic light emitting device according to one embodiment of the present application may be manufactured using common organic light emitting device manufacturing methods and materials except that one or more organic material layers are formed using the heterocyclic compound represented by Chemical Formula 1 and the heterocyclic compound represented by Chemical Formula 2 described above.

The heterocyclic compound represented by Chemical Formula 1 and the heterocyclic compound represented by Chemical Formula 2 may be formed into an organic material layer using a solution coating method as well as a vacuum deposition method when manufacturing the organic light emitting device. Herein, the solution coating method means spin coating, dip coating, inkjet printing, screen printing, a spray method, roll coating and the like, but is not limited thereto.

The organic material layer of the organic light emitting device of the present disclosure may be formed in a single layer structure, or may also be formed in a multilayer structure in which two or more organic material layers are laminated. For example, the organic light emitting device of the present disclosure may have a structure including a hole injection layer, a hole transfer layer, a light emitting layer, an electron transfer layer, an electron injection layer and the like as the organic material layer. However, the structure of the organic light emitting device is not limited thereto, and may include a smaller number of organic material layers.

Specifically, the organic light emitting device according to one embodiment of the present application includes a first electrode, a second electrode, and one or more organic material layers provided between the first electrode and the second electrode, wherein one or more layers of the organic material layers include the heterocyclic compound represented by Chemical Formula 1 and the heterocyclic compound represented by Chemical Formula 2.

In one embodiment of the present application, the first electrode may be an anode, and the second electrode may be a cathode.

In another embodiment, the first electrode may be a cathode, and the second electrode may be an anode.

In one embodiment of the present application, the organic light emitting device may be a blue organic light emitting device, and the heterocyclic compound according to Chemical Formula 1 and the heterocyclic compound according to Chemical Formula 2 may be used as a material of the blue organic light emitting device.

In one embodiment of the present application, the organic light emitting device may be a green organic light emitting device, and the heterocyclic compound represented by Chemical Formula 1 and the heterocyclic compound represented by Chemical Formula 2 may be used as a material of the green organic light emitting device.

In one embodiment of the present application, the organic light emitting device may be a red organic light emitting device, and the heterocyclic compound represented by Chemical Formula 1 and the heterocyclic compound represented by Chemical Formula 2 may be used as a material of the red organic light emitting device.

The organic light emitting device of the present disclosure may further include one, two or more layers selected from the group consisting of a light emitting layer, a hole injection layer, a hole transfer layer, an electron injection layer, an electron transfer layer, an electron blocking layer and a hole blocking layer.

In the organic light emitting device provided in one embodiment of the present application, the organic material layer includes at least one of a hole blocking layer, an electron injection layer and an electron transfer layer, and the at least one of a hole blocking layer, an electron injection layer and an electron transfer layer includes the heterocyclic compound represented by Chemical Formula 1 and the heterocyclic compound represented by Chemical Formula 2.

In one embodiment of the present application, the organic material layer includes a light emitting layer, and the light emitting layer includes the heterocyclic compound represented by Chemical Formula 1 and the heterocyclic compound represented by Chemical Formula 2.

In one embodiment of the present application, the organic material layer includes a light emitting layer, the light emitting layer includes a host material, and the host material includes the heterocyclic compound represented by Chemical Formula 1 and the heterocyclic compound represented by Chemical Formula 2.

FIG. 1 to FIG. 3 illustrate a lamination order of electrodes and organic material layers of an organic light emitting device according to one embodiment of the present application. However, the scope of the present application is not limited to these diagrams, and structures of organic light emitting devices known in the art may also be used in the present application.

FIG. 1 illustrates an organic light emitting device in which an anode (200), an organic material layer (300) and a cathode (400) are consecutively laminated on a substrate (100). However, the structure is not limited to such a structure, and as illustrated in FIG. 2, an organic light emitting device in which a cathode, an organic material layer and an anode are consecutively laminated on a substrate may also be obtained.

FIG. 3 illustrates a case of the organic material layer being a multilayer. The organic light emitting device according to FIG. 3 includes a hole injection layer (301), a hole transfer layer (302), a light emitting layer (303), a hole blocking layer (304), an electron transfer layer (305) and an electron injection layer (306). However, the scope of the present application is not limited to such a lamination structure, and as necessary, layers other than the light emitting layer may not be included, and other necessary functional layers may be further added.

One embodiment of the present application provides a method for manufacturing an organic light emitting device, the method including preparing a substrate; forming a first electrode on the substrate; forming one or more organic material layers on the first electrode; and forming a second electrode on the organic material layer, wherein the forming of organic material layers includes forming one or more organic material layers using the composition for an organic material layer according to one embodiment of the present application.

In the method for manufacturing an organic light emitting device provided in one embodiment of the present application, the forming of organic material layers is forming the heterocyclic compound of Chemical Formula 1 and the heterocyclic compound of Chemical Formula 2 using a thermal vacuum deposition method after pre-mixing.

The pre-mixing means first mixing the heterocyclic compound of Chemical Formula 1 and the heterocyclic compound of Chemical Formula 2 in one source of supply before depositing on the organic material layer.

The premixed material may be referred to as the composition for an organic material layer according to one embodiment of the present application.

In the organic light emitting device according to one embodiment of the present application, materials other than the heterocyclic compound of Chemical Formula 1 and the heterocyclic compound of Chemical Formula 2 are illustrated below, however, these are for illustrative purposes only and not for limiting the scope of the present application, and may be replaced by materials known in the art.

As the anode material, materials having relatively large work function may be used, and transparent conductive oxides, metals, conductive polymers or the like may be used. Specific examples of the anode material include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, and the like, but are not limited thereto.

As the cathode material, materials having relatively small work function may be used, and metals, metal oxides, conductive polymers or the like may be used. Specific examples of the cathode material include metals such as magnesium, calcium, sodium, potassium, titanium, indium, yttrium, lithium, gadolinium, aluminum, silver, tin and lead, or alloys thereof; multilayer structure materials such as LiF/Al or LiO₂/Al, and the like, but are not limited thereto.

As the hole injection material, known hole injection materials may be used, and for example, phthalocyanine compounds such as copper phthalocyanine disclosed in US Patent No. 4,356,429, or starburst-type amine derivatives such as tris(4-carbazoyl-9-ylphenyl)amine (TCTA), 4,4',4"-tri[phenyl(m-tolyl)amino]triphenylamine (m-MTDATA) or 1,3,5-tris[4-(3-methylphenylphenylamino)phenyl]benzene (m-MTDAPB) described in the literature [Advanced Material, 6, p.677 (1994)], polyaniline/dodecylbenzene sulfonic acid, poly(3,4-ethylenedioxythiophene)/poly(4-styrenesulfonate), polyaniline/camphor sulfonic acid or polyaniline/poly(4-styrene-sulfonate) that are conductive polymers having solubility, and the like, may be used.

As the hole transfer material, pyrazoline derivatives, arylamine-based derivatives, stilbene derivatives, triphenyldiamine derivatives and the like may be used, and low molecular or high molecular materials may also be used.

As the electron transfer material, metal complexes of oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, 8-hydroxyquinoline and derivatives thereof, and the like, may be used, and high molecular materials may also be used as well as low molecular materials.

As examples of the electron injection material, LiF is typically used in the art, however, the present application is not limited thereto.

As the light emitting material, red, green or blue light emitting materials may be used, and as necessary, two or more light emitting materials may be mixed and used. Herein, two or more light emitting materials may be used by being deposited as individual sources of supply or by being premixed and deposited as one source of supply. In addition, fluorescent materials may also be used as the light emitting material, however, phosphorescent materials may also be used. As the light emitting material, materials emitting light by bonding electrons and holes injected from an anode and a cathode, respectively, may be used alone, however, materials having a host material and a dopant material involving in light emission together may also be used.

When mixing light emitting material hosts, same series hosts may be mixed, or different series hosts may be mixed. For example, any two or more types of materials among n-type host materials or p-type host materials may be selected and used as a host material of a light emitting layer.

The organic light emitting device according to one embodiment of the present application may be a top-emission type, a bottom-emission type or a dual-emission type depending on the materials used.

The heterocyclic compound according to one embodiment of the present application may also be used in an organic electronic device including an organic solar cell, an organic photo conductor, an organic transistor and the like under a similar principle used in the organic light emitting device.

Hereinafter, the present specification will be described in more detail with reference to examples, however, these are for illustrative purposes only, and the scope of the present application is not limited thereto.

### <Preparation Example>

### <Preparation Example 1> Preparation of Compound 1-25

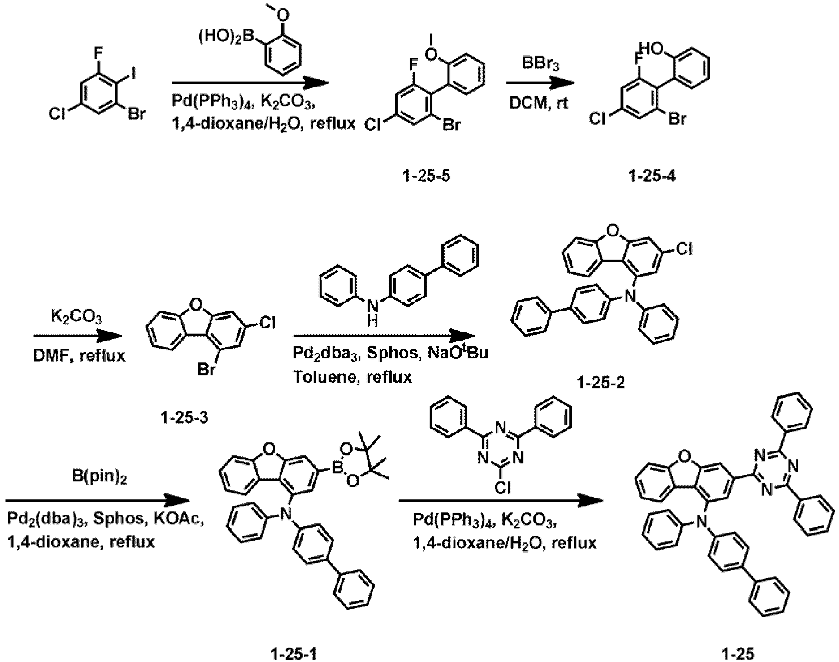

### 1) Preparation of Compound 1-25-5

1-Bromo-5-chloro-3-fluoro-2-iodobenzene (200.0 g, 596.4 mM), (2-methoxyphenyl)boronic acid (82.4 g, 542.2 mM), Pd(PPh₃)₄ (31.3 g, 27.1 mM) and K₂CO₃ (150.0 g, 1084.4 mM) were dissolved in 1,4-dioxane/H₂O (1 L/200 mL), and then refluxed for 24 hours. After the reaction was completed, the result was extracted by introducing distilled water and dichloromethane (DCM) thereto at room temperature, and after drying the organic layer with MgSO₄, the solvent was removed using a rotary evaporator. The reaction material was purified by column chromatography (DCM:Hex=1:10) to obtain Compound 1-25-5 (137 g, 80.0%).

### 2) Preparation of Compound 1-25-4

Compound 1-25-5 (82 g, 259.8 mM) and BBr₃ (49 mL, 519.7 mM) were dissolved in DCM (800 mL), and then refluxed for 1 hour. After the reaction was completed, the result was extracted by introducing distilled water and DCM thereto at room temperature, and after drying the organic layer with MgSO₄, the solvent was removed using a rotary evaporator. The reaction material was purified by column chromatography (DCM:Hex=1:1) to obtain Compound 1-25-4 (65.3 g, 83.0%).

### 3) Preparation of Compound 1-25-3

Compound 1-25-4 (65.3 g, 216.5 mM) and K₂CO₃ (59.9 g, 433.1 mM) were dissolved in dimethylformamide (DMF) (300 mL), and then refluxed for 4 hours. After the reaction was completed, the result was extracted by introducing distilled water and DCM thereto at room temperature, and after drying the organic layer with MgSO₄, the solvent was removed using a rotary evaporator. The reaction material was purified by column chromatography (DCM:Hex=1:5), and recrystallized with methanol to obtain Compound 1-25-3 (54.8 g, 90.0%).

### 4) Preparation of Compound 1-25-2

Compound 1-25-3 (10.0 g, 35.5 mM), N-phenyl-[1,1'-biphenyl]-4-amine (8.7 g, 35.5 mM), Pd₂(dba)₃ (1.6 g, 1.8 mM), Sphos (1.5 g, 3.6 mM) and NaOtBu (10.2 g, 106.5 mM) were dissolved in toluene (100 mL), and then refluxed for 1 hour. After the reaction was completed, the result was filtered under vacuum at room temperature, and then the solvent of the filtrate was removed using a rotary evaporator. The reaction material was purified by column chromatography (DCM:Hex=1:4), and recrystallized with methanol to obtain Compound 1-25-2 (14.2 g, 89.6%).

### 5) Preparation of Compound 1-25-1

Compound 1-25-2 (14.0 g, 31.4 mM), 4,4,4',4',5,5,5',5'-octamethyl-2,2'-bi(1,3,2-dioxaborolane) (12.0 g, 47.1 mM), Pd₂(dba)₃ (2.2 g, 2.4 mM), Sphos (1.3 g, 3.1 mM) and KOAc (9.2 g, 94.2 mM) were dissolved in 1,4-dioxane (140 mL), and then refluxed for 1 hour. After the reaction was completed, the result was filtered under vacuum at room temperature, and then the solvent of the filtrate was removed using a rotary evaporator. The reaction material was purified by column chromatography (DCM:Hex=1:3), and recrystallized with methanol to obtain Compound 1-25-1 (15.3 g, 90.8%).

### 6) Preparation of Compound 1-25

Compound 1-25-1 (15.0 g, 27.9 mM), 2-chloro-4,6-diphenyl-1,3,5-triazine (8.2 g, 30.7 mM), Pd(PPh₃)₄ (1.6 g, 1.4 mM) and K₂CO₃ (11.6 g, 83.7 mM) were dissolved in 1,4-dioxane/H₂O (150 mL/30 mL), and then refluxed for 1 hour. After the reaction was completed, the result was extracted at room temperature, and then the solvent of the filtrate was removed using a rotary evaporator. The reaction material was purified by column chromatography (DCM:Hex=1:1), and recrystallized with methanol to obtain target Compound 1-25 (16.5 g, 92.1%).

The following target compounds were synthesized in the same manner as in Preparation Example 1 except that Intermediate A of the following Table 1 was used instead of N-phenyl-[1,1'-biphenyl]-4-amine, and Intermediate B of the following Table 1 was used instead of 2-chloro-4,6-diphenyl-1,3,5-triazine.

**[Table 1]**

| Compound No. | Intermediate A | Intermediate B | Target Compound | Yield |
|---|---|---|---|---|
| 1-25 | 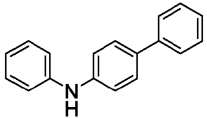 | 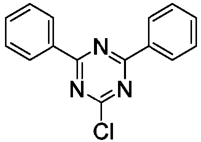 | 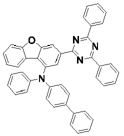 | 92.1% |
| 1-26 | | 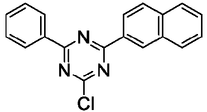 | 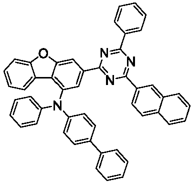 | 91.8% |
| 1-27 | | 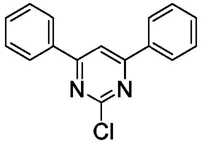 | 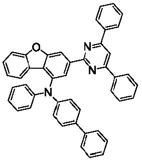 | 90.9% |
| 1-28 | | 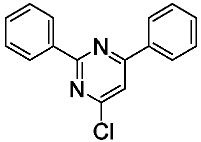 | 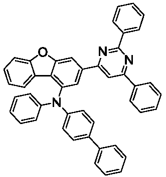 | 91.9% |
| 1-33 | 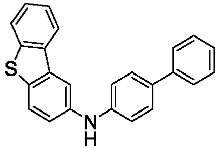 | 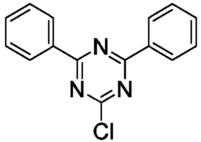 | 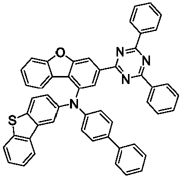 | 85.1% |
| 1-37 | 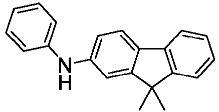 | 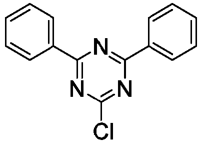 | 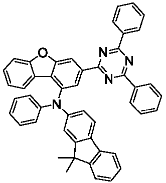 | 85.7% |
| 1-38 | 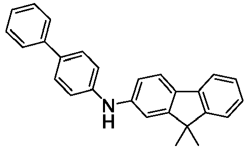 | 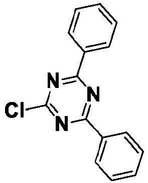 | 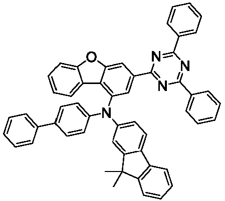 | 86.5% |
| 1-39 | | 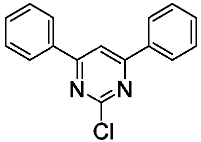 | 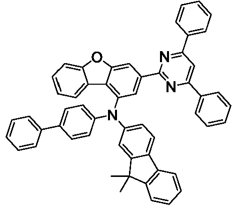 | 84.9% |

### <Preparation Example 2> Preparation of Compound 1-56

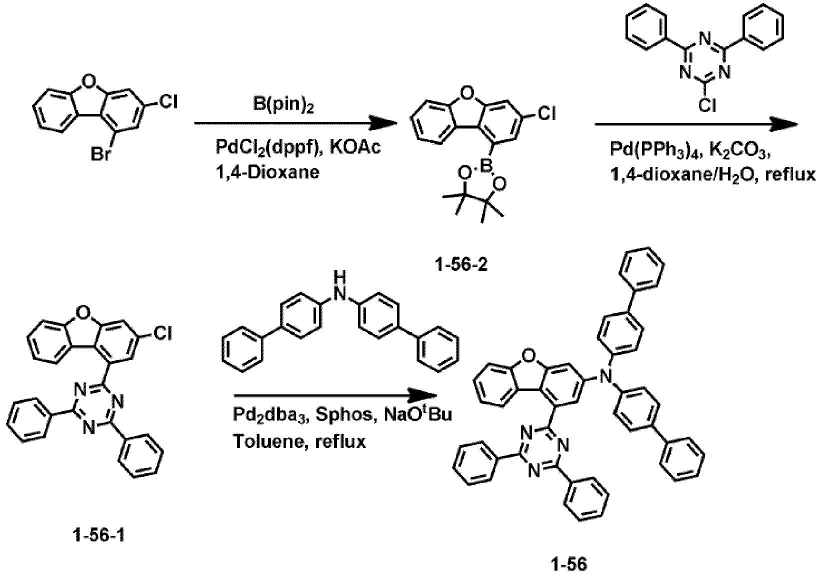

### 1) Preparation of Compound 1-56-2

1-Bromo-3-chlorodibenzo[b,d]furan (10.0 g, 35.5 mM), 4,4,4',4',5,5,5',5'-octamethyl-2,2'-bi(1,3,2-dioxaborolane) (13.5 g, 53.3 mM), PdCl₂(dppf) (1.3 g, 1.8 mM) and KOAc (10.5 g, 106.5 mM) were dissolved in 1,4-dioxane (100 mL), and then refluxed for 1 hour. After the reaction was completed, the result was filtered under vacuum at room temperature, and then the solvent of the filtrate was removed using a rotary evaporator. The reaction material was purified by column chromatography (DCM:Hex=1:5) to obtain Compound 1-56-2 (9.8 g, 81.4%).

### 2) Preparation of Compound 1-56-1

Compound 1-56-2 (9.0 g, 27.4 mM), 2-chloro-4,6-diphenyl-1,3,5-triazine (8.1 g, 30.1 mM), Pd(PPh₃)₄ (1.6 g, 1.4 mM) and K₂CO₃ (11.4 g, 82.2 mM) were dissolved in 1,4-dioxane/H₂O (100 mL/20 mL), and then refluxed for 1 hour. After the reaction was completed, the result was filtered under vacuum at room temperature. The result was dissolved in DCB to be silica purified, and then recrystallized with MeOH to obtain Compound 1-56-1 (10.9 g, 91.6%).

### 3) Preparation of Compound 1-56

Compound 1-56-1 (10.0 g, 23.0 mM), di([1,1'-biphenyl]-4-yl)amine (8.1 g, 25.3 mM), Pd₂(dba)₃ (1.1 g, 1.2 mM), Sphos (0.9 g, 2.3 mM) and NaOtBu (6.6 g, 69.0 mM) were dissolved in xylene (100 mL), and then refluxed for 1 hour. After the reaction was completed, the result was filtered under vacuum at room temperature. The result was dissolved in DCB to be silica purified, and then recrystallized with MeOH to obtain target Compound 1-56 (15.7 g, 94.8%).

### <Preparation Example 3> Preparation of Compound 1-91

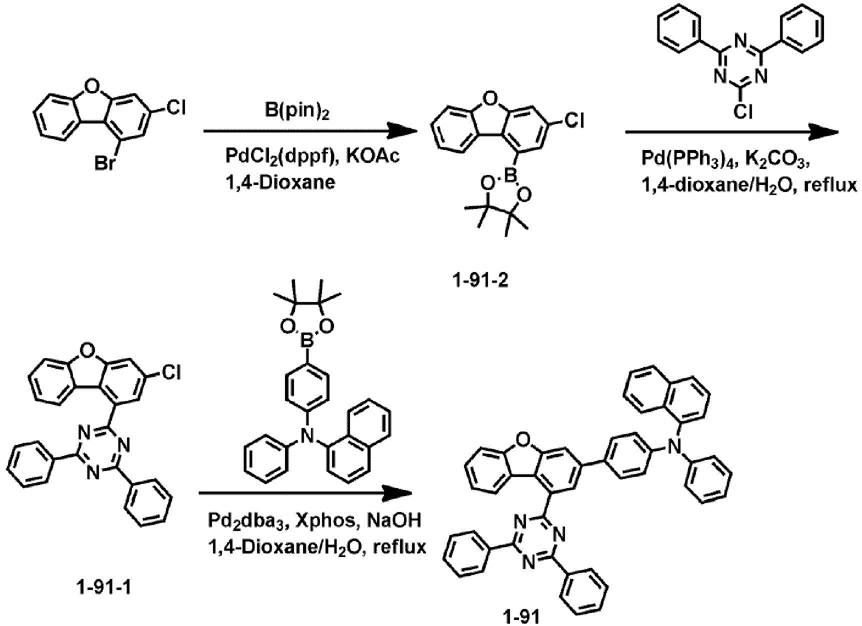

### 1) Preparation of Compound 1-91-2

Preparation was made in the same manner as the preparation of Compound 1-56-2 in Preparation Example 2.

### 2) Preparation of Compound 1-91-1

Preparation was made in the same manner as the preparation of Compound 1-56-1 in Preparation Example 2.

### 3) Preparation of Compound 1-91

Compound 1-91-1 (10.0 g, 23.0 mM), N-phenyl-N-(4-(4,4,5,5-tetramethyl-1,3,2-dioxaborolan-2-yl)phenyl)naphthalen-1-amine (10.7 g, 25.3 mM), Pd₂(dba)₃ (1.1 g, 1.2 mM), Xphos (1.1 g, 2.3 mM) and NaOH (2.8 g, 69.0 mM) were dissolved in 1,4-dioxane/H₂O (100 mL/20 mL), and then refluxed for 1 hour. After the reaction was completed, the result was filtered under vacuum at room temperature. The result was dissolved in DCB to be silica purified, and then recrystallized with MeOH to obtain target Compound 1-91 (14.7 g, 92.2%).

The following target compounds were synthesized in the same manner as in Preparation Example 3 except that Intermediate A of the following Table 2 was used instead of 2-chloro-4,6-diphenyl-1,3,5-triazine, and Intermediate B of the following Table 2 was used instead of N-phenyl-N-(4-(4,4,5,5-tetramethyl-1,3,2-dioxaborolan-2-yl)phenyl)naphthalen-1-amine.

**[Table 2]**

| Compound No. | Intermediate A | Intermediate B | Target Compound | Yield |
|---|---|---|---|---|
| 1-85 | 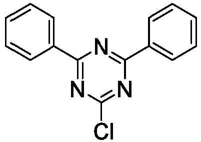 | | 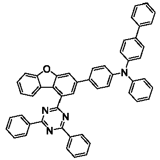 | 92.1% |
| 1-86 | 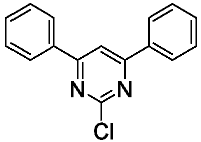 | 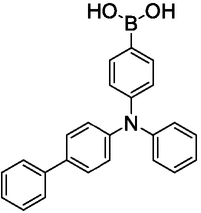 | 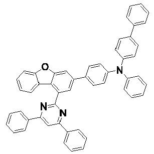 | 91.8% |
| 1-87 | 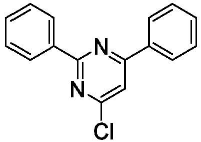 | | 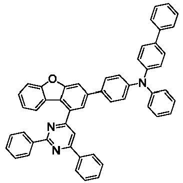 | 90.9% |
| 1-88 | 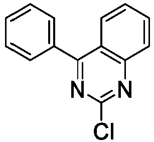 | | 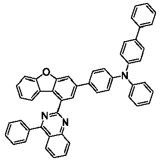 | 91.9% |
| 1-89 | 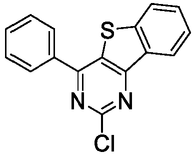 | | 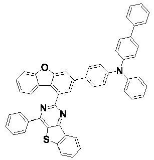 | 85.1% |
| 1-91 | 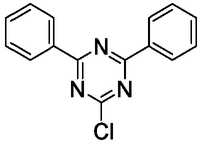 | 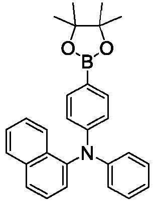 | 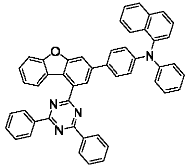 | 85.7% |
| 1-92 | 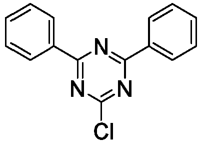 | 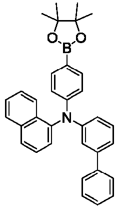 | 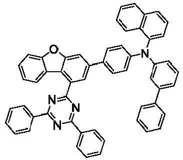 | 86.5% |
| 1-94 | 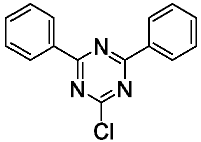 | 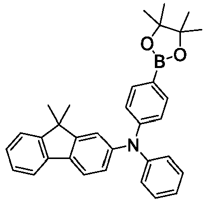 | 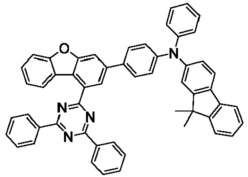 | 84.9% |
| 1-97 | 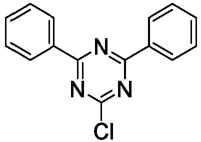 | 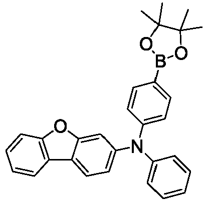 | 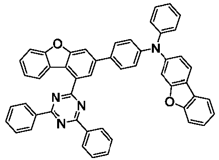 | 85.8% |
| 1-98 | 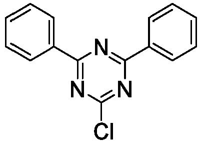 | 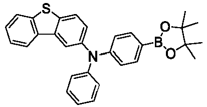 | 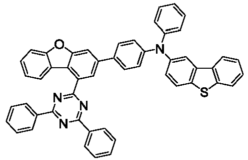 | 80.9% |
| 1-99 | 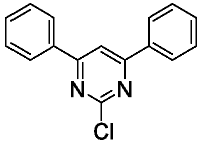 | 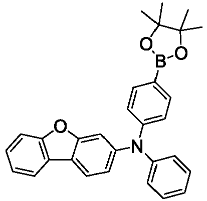 | 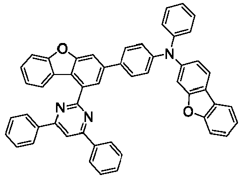 | 81.3% |
| 1-100 | 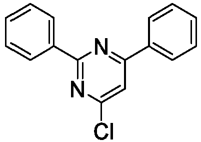 | 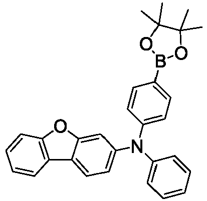 | 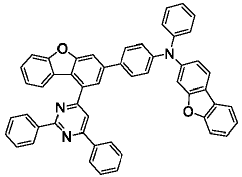 | 80.1% |

### <Preparation Example 4> Synthesis of Compound 2-33

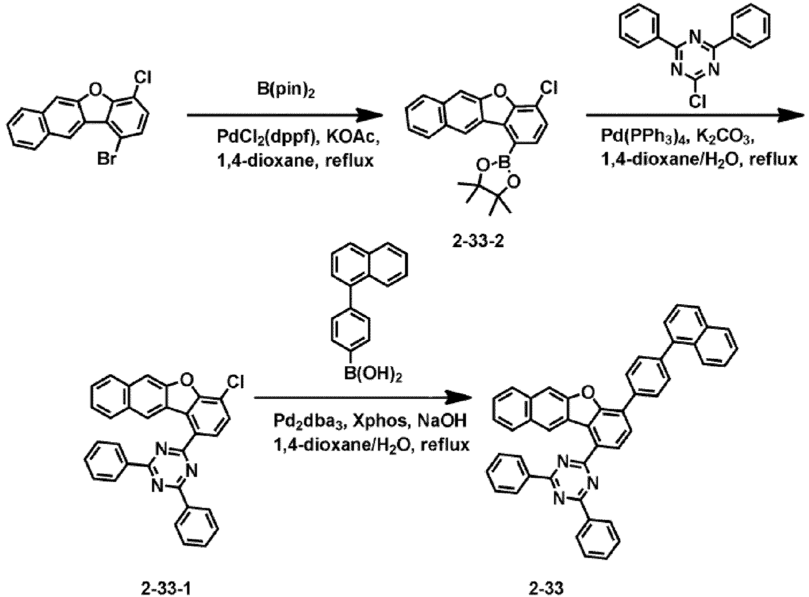

### 1) Preparation of Compound 2-33-2

1-Bromo-4-chloronaphtho[2,3-b]benzofuran (30.0 g, 90.5 mM), 4,4,4',4',5,5,5',5'-octamethyl-2,2'-bi(1,3,2-dioxaborolane) (34.5 g, 135.8 mM), PdCl₂(dppf) (3.3 g, 4.5 mM) and KOAc (26.6 g, 271.5 mM) were dissolved in 1,4-dioxane (300 mL), and then refluxed for 24 hours. After the reaction was completed, the result was filtered under vacuum at room temperature, and then the solvent of the filtrate was removed using a rotary evaporator. The reaction material was purified by column chromatography (DCM:Hex=1:4) to obtain Compound 2-33-2 (31.2 g, 91.0%).

### 2) Preparation of Compound 2-33-1

Compound 2-33-2 (30 g, 79.2 mM), 2-chloro-4,6-diphenyl-1,3,5-triazine (23.3 g, 87.1 mM), Pd(PPh₃)₄ (4.6 g, 4.0 mM) and K₂CO₃ (32.8 g, 237.6 mM) were dissolved in 1,4-dioxane/H₂O (300 mL/60 mL), and then refluxed for 1 hour. After the reaction was completed, the result was filtered under vacuum at room temperature, and then dissolved in DCB to be silica purified. The result was recrystallized with MeOH to obtain Compound 2-33-1 (35.3 g, 92.0%).

### 3) Preparation of Compound 2-33

Compound 2-33-1 (10.0 g, 20.7 mM), (4-(naphthalen-1-yl)phenyl)boronic acid (6.2 g, 24.8 mM), Pd₂(dba)₃ (0.9 g, 1.0 mM), Xphos (1.0 g, 2.1 mM) and NaOH (2.5 g, 62.1 mM) were dissolved in 1,4-dioxane/H₂O (100 mL/20 mL), and then refluxed for 2 hours. After the reaction was completed, the result was filtered under vacuum at room temperature, and then dissolved in DCB to be silica purified. The result was recrystallized with methanol to obtain target Compound 2-33 (12.5 g, 92.8%).

The following target compounds were synthesized in the same manner as in Preparation Example 4 except that Intermediate A of the following Table 3 was used instead of 2-chloro-4,6-diphenyl-1,3,5-triazine, and Intermediate B of the following Table 3 was used instead of (4-(naphthalen-1-yl)phenyl)boronic acid.

**[Table 3]**

| Compound No. | Intermediate A | Intermediate B | Target Compound | Yield |
|---|---|---|---|---|
| 2-33 | 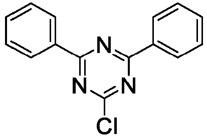 | 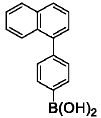 | 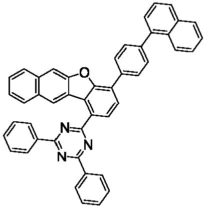 | 92.8% |
| 2-34 | 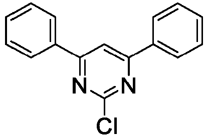 | 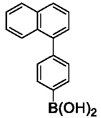 | 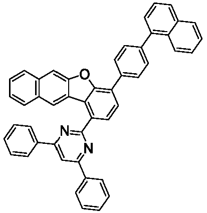 | 90.1% |
| 2-35 | 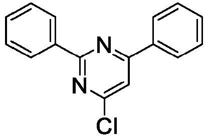 | 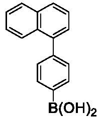 | 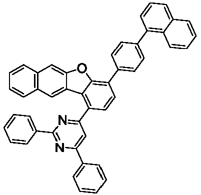 | 85.9% |
| 2-37 | 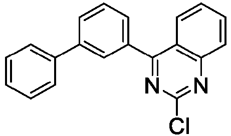 | 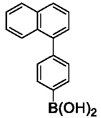 | 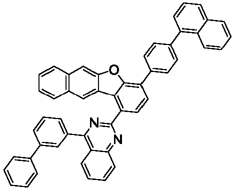 | 91.9% |
| 2-40 | 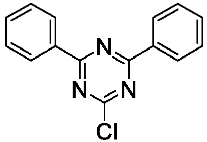 | 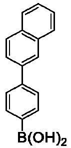 | 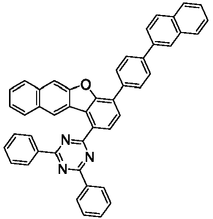 | 93.1% |

### <Preparation Example 5> Synthesis of Compound 2-45

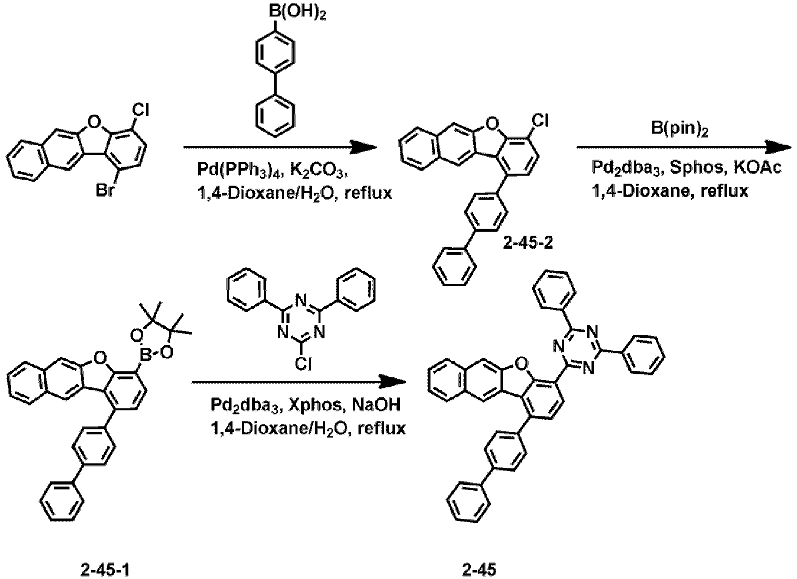

### 1) Preparation of Compound 2-45-2

1-Bromo-4-chloronaphtho[2,3-b]benzofuran (30.0 g, 90.5 mM), [1,1'-biphenyl]-4-ylboronic acid (17.9 g, 90.5 mM), Pd(PPh₃)₄ (5.2 g, 4.5 mM) and K₂CO₃ (31.3 g, 226.3 mM) were dissolved in 1,4-dioxane/H₂O (300 mL/60 mL), and then refluxed for 2 hours. After the reaction was completed, the result was extracted with DCM at room temperature, and then the solvent was removed using a rotary evaporator. The reaction material was purified by column chromatography (DCM:Hex=1:5) to obtain Compound 2-45-2 (29.7 g, 81.1%).

### 2) Preparation of Compound 2-45-1

Compound 2-45-2 (29.0 g, 71.6 mM), 4,4,4',4',5,5,5',5'-octamethyl-2,2'-bi(1,3,2-dioxaborolane) (27.3 g, 107.4 mM), Pd₂(dba)₃ (3.3 g, 3.6 mM), Sphos (3.0 g, 7.2 mM) and KOAc (21.1 g, 214.8 mM) were dissolved in 1,4-dioxane (300 mL), and then refluxed for 1 hour. After the reaction was completed, the result was filtered under vacuum at room temperature, and then the solvent of the filtrate was removed using a rotary evaporator. The reaction material was purified by column chromatography (DCM:Hex=1:2) to obtain Compound 2-45-1 (32.7 g, 92.0%).

### 3) Preparation of Compound 2-45

Compound 2-45-1 (10.0 g, 20.1 mM), 2-chloro-4,6-diphenyl-1,3,5-triazine (5.9 g, 22.1 mM), Pd₂(dba)₃ (0.9 g, 1.0 mM), Xphos (1.0 g, 2.0 mM) and NaOH (2.4 g, 60.3 mM) were dissolved in 1,4-dioxane/H₂O (100 mL/20 mL), and then refluxed for 1 hour. After the reaction was completed, the result was extracted at room temperature, and then the solvent of the filtrate was removed using a rotary evaporator. The reaction material was purified by column chromatography (DCM:Hex=1:2), and then recrystallized with MeOH to obtain target Compound 2-45 (10.3 g, 85.1%).

The following target compounds were synthesized in the same manner as in Preparation Example 5 except that Intermediate A of the following Table 4 was used instead of [1,1'-biphenyl]-4-ylboronic acid, and Intermediate B of the following Table 4 was used instead of 2-chloro-4,6-diphenyl-1,3,5-triazine.

**[Table 4]**

| Compound No. | Intermediate A | Intermediate B | Target Compound | Yield |
|---|---|---|---|---|
| 2-45 | 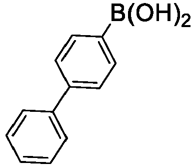 | 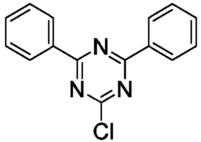 | 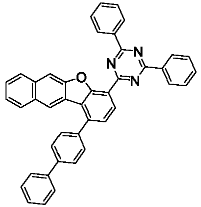 | 85.1% |
| 2-46 | | 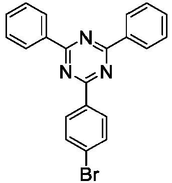 | 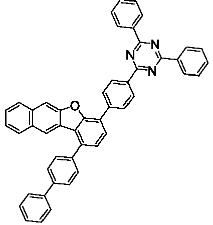 | 80.3% |
| 2-47 | 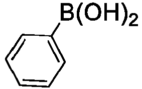 | 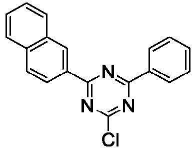 | 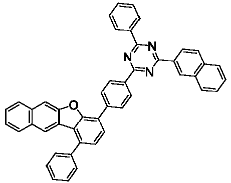 | 81.9% |

### <Preparation Example 6> Synthesis of Compound 2-90

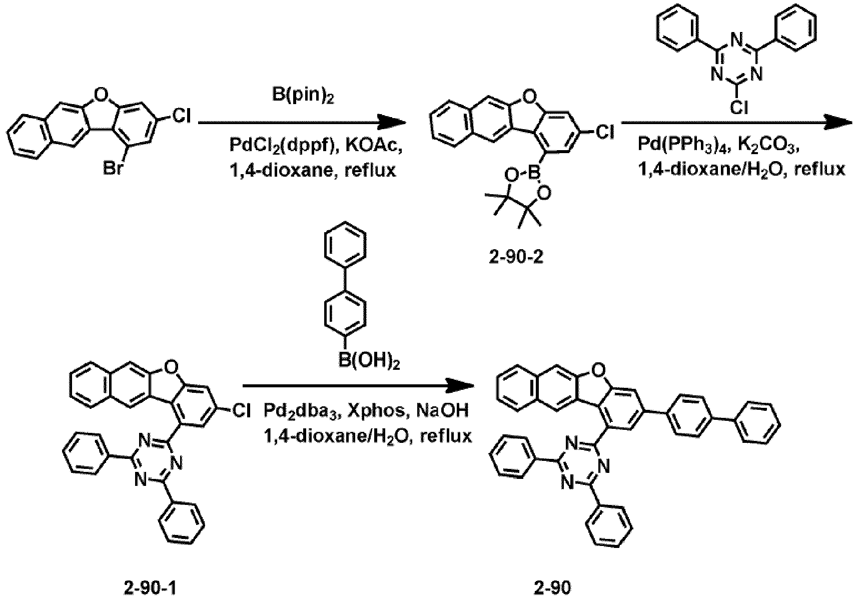

### 1) Preparation of Compound 2-90-2

Synthesis was made in the same manner as the preparation of Compound 2-33-2 in Preparation Example 4 except that 1-bromo-3-chloronaphtho[2,3-b]benzofuran was used instead of 1-bromo-4-chloronaphtho[2,3-b]benzofuran.

### 2) Preparation of Compound 2-90-1

Synthesis was made in the same manner as the preparation of Compound 2-33-1 in Preparation Example 4 except that Compound 2-90-2 was used instead of Compound 2-33-2.

### 3) Preparation of Compound 2-90

Synthesis was made in the same manner as the preparation of Compound 2-33 in Preparation Example 4 except that Compound 2-90-1 was used instead of Compound 2-33-1, and [1,1'-biphenyl]-4-ylboronic acid was used instead of (4-(naphthalen-1-yl)phenyl)boronic acid.

The following target compounds were synthesized in the same manner as in Preparation Example 6 except that Intermediate A of the following Table 5 was used instead of 2-chloro-4,6-diphenyl-1,3,5-triazine, and Intermediate B of the following Table 5 was used instead of (4-(naphthalen-1-yl)phenyl)boronic acid.

**[Table 5]**

| Compound No. | Intermediate A | Intermediate B | Target Compound | Yield |
|---|---|---|---|---|
| 2-90 | 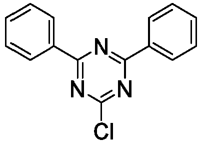 | 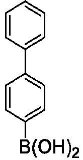 | 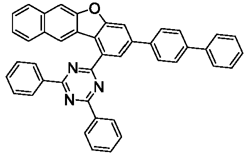 | 80.3% |
| 2-91 | | 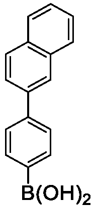 | 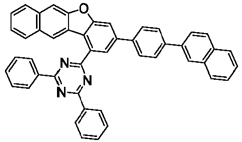 | 81.8% |
| 2-93 | 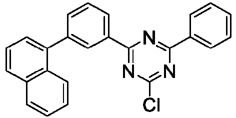 | 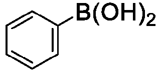 | 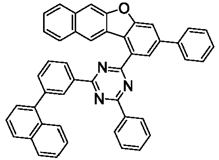 | 75.9% |

### <Preparation Example 7> Synthesis of Compound 2-165

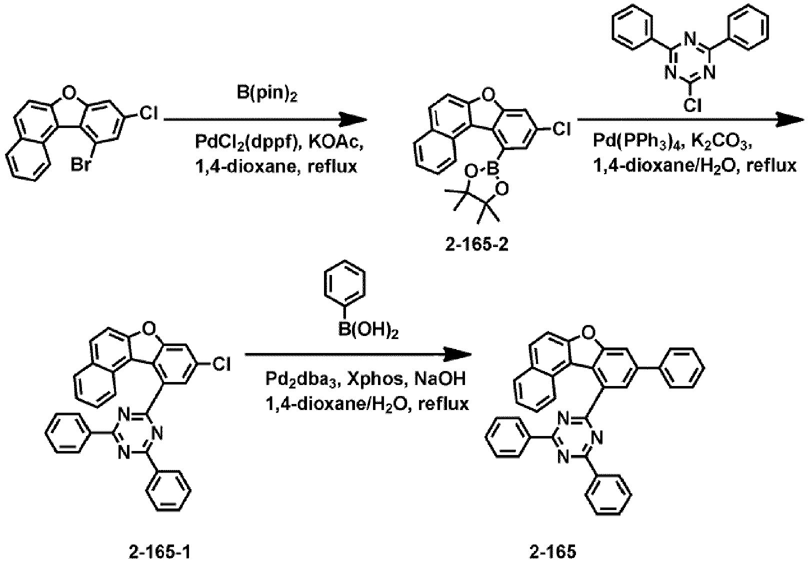

### 1) Preparation of Compound 2-165-2

Synthesis was made in the same manner as the preparation of Compound 2-33-2 in Preparation Example 4 except that 1-bromo-3-chloronaphtho[2,1-b]benzofuran was used instead of 1-bromo-4-chloronaphtho[2,3-b]benzofuran.

### 2) Preparation of Compound 2-165-1

Synthesis was made in the same manner as the preparation of Compound 2-33-1 in Preparation Example 4 except that Compound 2-165-2 was used instead of Compound 2-33-2.

### 3) Preparation of Compound 2-165

Synthesis was made in the same manner as the preparation of Compound 2-33 in Preparation Example 4 except that Compound 2-165-1 was used instead of Compound 2-33-1.

The following target compounds were synthesized in the same manner as in Preparation Example 7 except that Intermediate A of the following Table 6 was used instead of 2-chloro-4,6-diphenyl-1,3,5-triazine, and Intermediate B of the following Table 6 was used instead of (4-(naphthalen-1-yl)phenyl)boronic acid.

**[Table 6]**

| Compou nd No. | Intermediate A | Intermediate B | Target Compound | Yield |
|---|---|---|---|---|
| 2-165 | 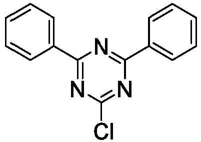 | 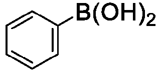 | 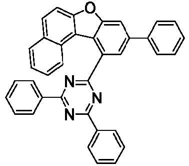 | 81.9% |
| 2-167 | 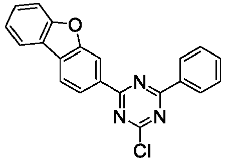 | 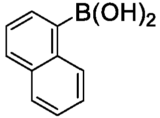 | 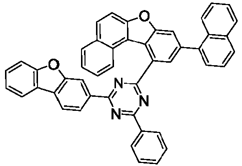 | 82.3% |
| 2-168 | 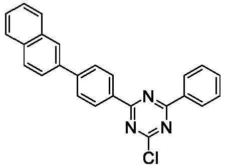 | 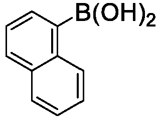 | 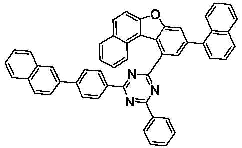 | 76.3% |

The rest of the heterocyclic compounds of Chemical Formula 1 and Chemical Formula 2 of the present application other than the compounds described in Preparation Example 1 to Preparation Example 7 were also prepared in the same manner as in the preparation examples described above.

The following Table 7 and Table 8 show ¹H NMR data and FD-MS data of the synthesized compounds, and through the following data, syntheses of the target compounds were identified.

**[Table 7]**

| Compound No. | ¹H NMR (CDCl₃, 400 Mz) |
|---|---|
| 1-25 | δ=8.83~8.79(d, 4H), 8.55(s, 1H), 8.35~8.33(d, 1H), 7.89~7.70(m, 5H), 7.65~7.41(m, 10H), 7.36~7.21(m, 8H), 7.12~7.07(t, 1H), |
| 1-26 | δ=8.82~8.80(d, 2H), 8.79~8.60(m, 4H), 8.12~8.08(m, 3H), 7.98(s, 1H), 7.90~7.81(m, 3H), 7.60~7.41(m, 10H), 7.36~7.21(m, 8H), 7.12~7.07(t, 1H), |
| 1-27 | δ=8.85(s, 1H), 8.79~8.75(d, 4H), 8.53(s, 1H), 8.32~8.30(d, 1H), 7.89~7.70(m, 5H), 7.65~7.41(m, 10H), 7.36~7.21(m, 8H), 7.12~7.07(t, 1H), |
| 1-28 | δ=8.82~8.80(d, 2H), 8.64(s, 1H), 8.35~8.32(m, 3H), 7.98(s, 1H), 7.89~7.70(m, 5H), 7.63~7.41(m, 10H), 7.35~7.21(m, 8H), 7.12~7.07(t, 1H), |
| 1-33 | δ=8.83~8.79(d, 4H), 8.57(s, 1H), 8.33~8.32(d, 1H), 7.89~7.70(m, 5H), 7.65~7.41(m, 10H), 7.38~7.21(m, 10H), 7.11~7.07(t, 1H), |
| 1-37 | δ=8.80(s, 1H), 8.68~8.66(d, 4H), 8.45(s, 1H), 7.80~7.75(m, 4H), 7.65~7.58(m, 3H), 7.49~7.46(m, 4H), 7.45~7.29(m, 4H), 7.24~7.22(m, 4H), 7.15~7.12(d, 1H), 7.08~7.00(m, 2H), 1.38(s, 6H) |
| 1-38 | δ=8.80(s, 1H), 8.68~8.66(d, 4H), 8.45(s, 1H), 7.80~7.75(m, 4H), 7.66~7.55(m, 5H), 7.50~7.46(m, 4H), 7.43~7.29(m, 6H), 7.24~7.22(m, 4H), 7.15~7.12(d, 1H), 7.08~7.00(m, 2H), 1.38(s, 6H) |
| 1-39 | δ=8.85~8.76(m, 2H), 8.65~8.62(d, 4H), 8.43(s, 1H), 7.79~7.73(m, 4H), 7.67~7.55(m, 5H), 7.49~7.46(m, 4H), 7.43~7.29(m, 6H), 7.24~7.22(m, 4H), 7.15~7.12(d, 1H), 7.08~7.00(m, 2H), 1.37(s, 6H) |
| 1-56 | δ=8.83~8.79(d, 4H), 8.59(s, 1H), 8.55~8.54(d, 1H), 7.99(s, 1H), 7.68~7.41(m, 14H), 7.35~7.21(m, 12H), 7.12~7.07(t, 1H), |
| 1-85 | δ=8.84~8.80(d, 4H), 8.64(s, 1H), 8.58~8.56(d, 1H), 8.00(s, 1H), 7.75~7.70(d, 4H), 7.68~7.41(m, 14H), 7.36~7.21(m, 8H), 7.12~7.07(t, 1H), |
| 1-86 | δ=8.48(s, 1H), 8.40~8.38(d, 1H), 8.37~8.33(m, 4H), 8.23(s, 1H), 7.94(s, 1H), 7.72~7.70(d, 2H), 7.63~7.51(m, 11H), 7.47~7.22(m, 12H), 7.16~7.06(m, 2H) |
| 1-87 | δ=8.82~8.80(d, 2H), 8.64(s, 1H), 8.55~8.53(m, 3H), 7.98(s, 1H), 7.74~7.70(d, 4H), 7.68~7.41(m, 15H), 7.36~7.21(m, 8H), 7.05~7.03(t, 1H), |
| 1-88 | δ=8.57~8.54(m, 2H), 8.30~8.24(m, 2H), 8.02~7.93(m, 3H), 7.72~7.59(m, 9H), 7.53~7.41(m, 5H), 7.54~7.30(t, 3H), 7.26~7.21(m, 8H), 7.10~7.06(t, 1H) |
| 1-89 | δ=8.50~8.46(m, 2H), 8.28~8.26(m, 2H), 7.99~7.93(m, 3H), 7.68~7.59(m, 9H), 7.52~7.30(m, 8H), 7.26~7.21(m, 8H), 7.10~7.06(t, 1H) |
| 1-91 | δ=8.84~8.80(d, 4H), 8.63(s, 1H), 8.57~8.56(d, 1H), 8.00(s, 1H), 7.70~7.70(d, 4H), 7.68~7.41(m, 14H), 7.36~7.21(m, 7H), 7.12~7.07(t, 1H), |
| 1-92 | δ=8.85~8.84(d, 4H), 8.64(s, 1H), 8.57~8.56(d, 1H), 7.98(s, 1H), 7.75~7.74(d, 4H), 7.67~7.44(m, 14H), 7.35~7.20(m, 10H), 7.12~7.07(t, 1H), |
| 1-94 | δ=8.84~8.80(d, 4H), 8.60(s, 1H), 8.44~8.43(d, 1H), 7.99(s, 1H), 7.76~7.74 (4, 4H), 7.68~7.41(m, 12H), 7.36~7.21(m, 8H), 7.12~7.07(t, 1H), 1.33(s, 6H) |
| 1-97 | δ=8.83~8.81(d, 4H), 8.63(s, 1H), 8.57~8.55(d, 1H), 8.01(s, 1H), 7.89~7.81(m, 2H), 7.74~7.71(d, 2H), 7.66~7.57(m, 7H), 7.52~7.35(m, 3H), 7.31~7.17(m, 10H), 7.12~7.09(t, 1H) |
| 1-98 | δ=8.82~8.80(d, 4H), 8.60(s, 1H), 8.55~8.53(d, 1H), 7.99(s, 1H), 7.86~7.84(d, 2H), 7.70~7.68(d, 2H), 7.63~7.57(m, 7H), 7.50~7.40 (m, 3H), 7.31~7.17(m, 10H), 7.12~7.09(t, 1H) |
| 1-99 | δ=8.79~8.76(d, 4H), 8.65(s, 1H), 8.59(s, 1H), 8.44~8.43(d, 1H), 7.98(s, 1H), 7.86~7.81(m, 2H), 7.74~7.71(d, 2H), 7.64~7.58(m, 7H), 7.52~7.35(m, 3H), 7.31~7.17(m, 10H), 7.12~7.09(t, 1H) |
| 1-100 | δ=8.81~8.80(d, 2H), 8.64(s, 1H), 8.55~8.53(m, 3H), 7.98(s, 1H), 7.85~7.84(d, 2H), 7.70~7.68(d, 2H), 7.63~7.57(m, 8H), 7.49~7.40(m, 3H), 7.30~7.18(m, 10H), 7.12~7.09(t, 1H) |
| 2-33 | δ=9.36(s, 1H), 8.90~8.88(d, 4H), 8.62~8.60(d, 1H), 8.17~8.08(m, 4H), 8.00~7.92(m, 4H), 7.77~7.75(d, 2H), 7.70~7.67(t, 3H), 7.64~7.50(m, 9H), 7.40~7.37(t, 1H) |
| 2-34 | δ=8.82~8.79(m, 3H), 8.42~8.39(d, 2H), 8.16~8.06(m, 5H), 7.98~7.84 (m, 5H), 7.76~7.74(d, 2H), 7.67~7.49 (m, 12H), 7.38~7.25(t, 1H) |
| 2-35 | δ=8.81~8.79(m, 3H), 8.41~8.39(d, 2H), 8.15~8.07(m, 5H), 7.97~7.84 (m, 5H), 7.75~7.73(d, 2H), 7.63~7.49 (m, 12H), 7.38~7.25(t, 1H) |
| 2-37 | δ=9.15(s, 1H), 8.40~8.38(d, 1H), 8.28~8.21(m, 2H), 8.06~7.81(m, 15H), 7.65~7.40(m, 12H), 7.31~7.27(t, 1H) |
| 2-40 | δ=9.35(s, 1H), 8.90~8.88(d, 4H), 8.61~8.59(d, 1H), 8.19~8.15(m, 3H), 8.06~7.88(m, 9H), 7.70~7.52(m, 10H), 7.40~7.36(t, 1H) |
| 2-45 | δ=8.93~8.92(d, 4H), 8.89~8.87(d, 1H), 8.25(s, 1H), 8.13(s, 1H), 8.04~8.00(m, 4H), 7.95~7.89(m, 4H), 7.85~7.82(d, 1H), 7.67~7.65(m, 6H), 7.60~7.52(m, 4H), 7.41~7.39(t, 1H) |
| 2-46 | δ=8.81~8.80(d, 4H), 8.77~8.76(d, 2H), 8.20(s, 1H), 8.10(s, 1H), 8.08~7.97(m, 6H), 7.93~7.85(m, 4H), 7.80~7.75(d, 1H), 7.67~7.65(m, 7H), 7.60~7.52(m, 4H), 7.41~7.39(t, 1H) |
| 2-47 | δ=8.92~8.90(m, 3H), 8.88~8.86(d, 2H), 8.35~8.34(d, 1H), 8.20(s, 1H), 8.11(s, 1H), 8.08~7.90(m, 9H), 7.83~7.72(m, 4H), 7.67~7.65(m, 4H), 7.60~7.52(m, 3H), 7.41~7.39(t, 1H) |
| 2-90 | δ=9.27(s, 1H), 8.91~8.89(d, 4H), 8.79(s, 1H), 8.15(s, 1H), 8.10(s, 1H), 8.00~7.85(m, 8H), 7.68~7.60(m, 7H), 7.56~7.54(m, 3H), 7.41~7.37(t, 1H) |
| 2-91 | δ=9.28(s, 1H), 8.91~8.89(d, 4H), 8.80(s, 1H), 8.16(s, 1H), 8.11(s, 1H), 8.02~7.85(m, 10H), 7.69~7.60(m, 7H), 7.56~7.54(m, 3H), 7.41~7.37(t, 1H) |
| 2-93 | δ=9.25(s, 1H), 8.91~8.89(m, 3H), 8.79~8.68(m, 2H), 8.15(s, 1H), 8.10(s, 1H), 8.00~7.85(m, 10H), 7.68~7.60(m, 7H), 7.56~7.54(m, 3H), 7.41~7.37(t, 1H) |
| 2-165 | δ=8.95~8.93(d, 4H), 8.85(s, 1H), 8.50(s, 1H), 8.15~8.10(m, 3H), 8.00~7.85(m, 7H), 7.69~7.60(m, 3H), 7.55~7.50(m, 3H), 7.41~7.37(t, 1H) |
| 2-167 | δ=8.96~8.91(m, 5H), 8.54~8.50(m, 3H), 8.15~8.11(m, 3H), 8.00~7.89(m, 7H), 7.71~7.60(m, 5H), 7.55~7.50(m, 3H), 7.41~7.37(t, 1H) |
| 2-168 | δ=8.95~8.90(m, 5H), 8.55~8.50(m, 3H), 8.16~8.10(m, 3H), 7.99~7.85(m, 9H), 7.70~7.59(m, 7H), 7.55~7.50(m, 3H), 7.41~7.37(t, 1H) |

**[Table 8]**

| Compound | FD-Mass | Compound | FD-Mass |
|---|---|---|---|
| 1-25 | m/z=542.7620 (C45H30N4O, 642.2420) | 1-26 | m/z=692.8220 (C49H32N4O, 692.2576) |
| 1-27 | m/z=641.7740 (C46H31N3O, 641.2467) | 1-28 | m/z=641.7740 (C46H31N3O, 641.2467) |
| 1-33 | m/z=748.9040 (C51H32N4OS, 748.2297) | 1-37 | m/z=682.8270 (C48H34N4O, 682.2733) |
| 1-38 | m/z=758.9250 (C54H38N4O, 758.3046) | 1-39 | m/z=757.9370 (C55H39N3O, 757.3093) |
| 1-56 | m/z=718.8600 (C51H34N4O, 718.2733) | 1-85 | m/z=718.8600 (C51H34N4O, 718.2733) |
| 1-86 | m/z=717.8720 (C52H35N3O, 717.2780) | 1-87 | m/z=717.8720 (C52H35N3O, 717.2780) |
| 1-88 | m/z=691.8340 (C50H33N3O, 691.2624) | 1-89 | m/z=747.9160 (C52H33N3OS, 747.2344) |
| 1-91 | m/z=692.8220 (C49H32N4O, 692.2576) | 1-92 | m/z=768.9200 (C55H36N4O, 768.2889) |
| 1-94 | m/z=758.9250 (C54H38N4O, 758.3046) | 1-97 | m/z=732.8430 (C51H32N4O2, 732.2525) |
| 1-98 | m/z=748.9040 (C51H32N4OS, 748.2297) | 1-99 | m/z=731.8550 (C52H33N3O2, 731. 2573) |
| 1-100 | m/z=731.8550 (C52H33N3O2, 731.2573) | | |
| 2-33 | m/z=651.7690 (C47H29N3O, 651.2311) | 2-34 | m/z=650.7810 (C48H30N2O, 650.2358) |
| 2-35 | m/z=650.7810 (C48H30N2O, 650.2358) | 2-37 | m/z=700.8410 (C52H32N2O, 700.2515) |
| 2-40 | m/z=651.7690 (C47H29N3O, 651.2311) | 2-45 | m/z=601.7090 (C43H27N3O, 601.2154) |
| 2-46 | m/z=677.8070 (C49H31N3O, 677.2467 | 2-47 | m/z=651.7690 (C47H29N3O, 651. 2311) |
| 2-90 | m/z=601.7090 (C43H27N3O, 601.2154) | 2-91 | m/z=651.7690 (C47H29N3O, 651. 2311) |
| 2-93 | m/z=651.7690 (C47H29N3O, 651.2311) | 2-165 | m/z=525.6110 (C37H23N3O, 525.1841) |
| 2-167 | m/z=665.7520 (C47H27N3O2, 665.2103) | 2-168 | m/z=701.8290 (C51H31N3O, 701.2467) |

### <Experimental Example 1>

### - Manufacture of Organic Light Emitting Device (Red Single Host & Mixed Host)

### 1-1) Experimental Example (Red Single Host & Mixed Host)

A glass substrate on which indium tin oxide (ITO) was coated as a thin film to a thickness of 1,500 Å was cleaned with distilled water ultrasonic waves. After the cleaning with distilled water was finished, the substrate was ultrasonic cleaned with solvents such as acetone, methanol and isopropyl alcohol, then dried, and UVO treatment was conducted for 5 minutes using UV in a UV cleaner. After that, the substrate was transferred to a plasma cleaner (PT), and after conducting plasma treatment under vacuum for ITO work function and residual film removal, the substrate was transferred to a thermal deposition apparatus for organic deposition.

On the transparent ITO electrode (anode), a hole injection layer 2-TNATA (4,4',4"-tris[2-naphthyl (phenyl)amino]triphenylamine) and a hole transfer layer NPB (N,N'-di(1-naphthyl)-N,N'-diphenyl-(1,1'-biphenyl)-4,4'-diamine), which are common layers, were formed.

A light emitting layer was thermal vacuum deposited thereon as follows. The light emitting layer was deposited to 500 Å using a combination compound of Chemical Formula 1 and Chemical Formula 2 described in the following Table 9 as a host and (piq)₂(Ir) (acac) as a red phosphorescent dopant, and doping the (piq)₂(Ir) (acac) to the host by 3%. After that, BCP was deposited to 60 Å as a hole blocking layer, and Alq₃ was deposited to 200 Å thereon as an electron transfer layer. Lastly, an electron injection layer was formed on the electron transfer layer by depositing lithium fluoride (LiF) to a thickness of 10 Å, and then a cathode was formed on the electron injection layer by depositing an aluminum (Al) cathode to a thickness of 1,200 Å, and as a result, an organic electroluminescent device was manufactured.

Meanwhile, all the organic compounds required to manufacture the OLED were vacuum sublimation purified under 10⁻⁸ torr to 10⁻⁶ torr for each material to be used in the OLED manufacture.

For each of the organic electroluminescent devices manufactured as above, electroluminescent (EL) properties were measured using M7000 manufactured by McScience Inc., and with the measurement results, T₉₀ was measured when standard luminance was 6,000 cd/m² through a lifetime measurement system (M6000) manufactured by McScience Inc.. Properties of the organic electroluminescent devices of the present disclosure are as shown in the following Table 9.

**[Table 9]**

| | Compound | Ratio (N:P) | Turn-on (V) | Driving Voltage (V) | Efficiency (cd/A) | Color Coordinate (x, y) | Lifetime (T₉₀) |
|---|---|---|---|---|---|---|---|
| Comparative Example 1 | A | - | 3.59 | 5.91 | 20.8 | (0.681, 0.319) | 30 |
| Comparative Example 2 | B | - | 3.21 | 5.65 | 19.9 | (0.682, 0.316) | 25 |
| Comparative Example 3 | C | - | 3.57 | 5.99 | 26.0 | (0.683, 0.315) | 36 |
| Comparative Example 4 | D | - | 3.55 | 5.90 | 22.0 | (0.681, 0.318) | 35 |
| Comparative Example 5 | E | - | 3.49 | 5.91 | 21.9 | (0.680, 0.319) | 65 |
| Comparative Example 6 | F | - | 3.61 | 5.95 | 24.9 | (0.683, 0.316) | 70 |
| Comparative Example 7 | 1-25 | - | 2.53 | 3.73 | 39.48 | (0.685, 0.315) | 100 |
| Comparative Example 8 | 1-26 | - | 2.49 | 3.68 | 37.88 | (0.687, 0.312) | 97 |
| Comparative Example 9 | 1-27 | - | 2.89 | 3.99 | 30.39 | (0.686, 0.313) | 71 |
| Comparative Example 10 | 1-28 | - | 3.31 | 4.52 | 25.55 | (0.686, 0.313) | 55 |
| Comparative Example 11 | 1-33 | - | 2.40 | 3.45 | 45.29 | (0.686, 0.313) | 200 |
| Comparative Example 12 | 1-37 | - | 2.30 | 3.37 | 56.49 | (0.685, 0.315) | 438 |
| Comparative Example 13 | 1-38 | - | 2.35 | 3.38 | 52.05 | (0.686, 0.313) | 278 |
| Comparative Example 14 | 1-39 | - | 2.71 | 3.79 | 41.31 | (0.686, 0.313) | 168 |
| Comparative Example 15 | 1-56 | - | 2.41 | 3.65 | 30.14 | (0.685, 0.315) | 105 |
| Comparative Example 16 | 1-85 | - | 2.25 | 3.37 | 73.98 | (0.687, 0.312) | 400 |
| Comparative Example 17 | 1-86 | - | 2.48 | 4.00 | 49.39 | (0.686, 0.313) | 109 |
| Comparative Example 18 | 1-87 | - | 2.77 | 4.37 | 34.79 | (0.686, 0.313) | 67 |
| Comparative Example 19 | 1-88 | - | 2.25 | 3.80 | 54.64 | (0.684, 0.315) | 250 |
| Comparative Example 20 | 1-89 | - | 2.45 | 3.72 | 43.86 | (0.685, 0.315) | 105 |
| Comparative Example 21 | 1-91 | - | 2.40 | 3.38 | 49.27 | (0.684, 0.315) | 150 |
| Comparative Example 22 | 1-92 | - | 2.44 | 3.41 | 47.91 | (0.685, 0.315) | 141 |
| Comparative Example 23 | 1-94 | - | 2.34 | 3.38 | 55.48 | (0.686, 0.313) | 440 |
| Comparative Example 24 | 1-97 | - | 2.33 | 3.52 | 51.26 | (0.685, 0.315) | 205 |
| Comparative Example 25 | 1-98 | - | 2.20 | 3.25 | 52.70 | (0.685, 0.315) | 200 |
| Comparative Example 26 | 1-99 | - | 2.41 | 3.39 | 35.90 | (0.685, 0.315) | 100 |
| Comparative Example 27 | 1-100 | - | 2.80 | 3.79 | 29.13 | (0.684, 0.315) | 67 |
| Comparative Example 28 | 2-33 | - | 2.45 | 3.90 | 35.21 | (0.685, 0.314) | 73 |
| Comparative Example 29 | 2-34 | - | 2.90 | 4.41 | 30.11 | (0.687, 0.312) | 55 |
| Comparative Example 30 | 2-35 | - | 3.40 | 5.00 | 25.39 | (0.686, 0.313) | 30 |
| Comparative Example 31 | 2-37 | - | 2.40 | 4.01 | 33.15 | (0.686, 0.313) | 70 |
| Comparative Example 32 | 2-40 | - | 2.43 | 3.92 | 34.29 | (0.686, 0.313) | 69 |
| Comparative Example 33 | 2-45 | - | 2.49 | 4.30 | 32.49 | (0.685, 0.315) | 50 |
| Comparative Example 34 | 2-46 | - | 2.43 | 3.85 | 30.15 | (0.686, 0.313) | 67 |
| Comparative Example 35 | 2-47 | - | 2.50 | 4.00 | 33.31 | (0.685, 0.315) | 80 |
| Comparative Example 36 | 2-90 | - | 2.51 | 4.21 | 28.30 | (0.685, 0.314) | 50 |
| Comparative Example 37 | 2-91 | - | 2.45 | 3.90 | 31.00 | (0.686, 0.313) | 63 |
| Comparative Example 38 | 2-93 | - | 2.40 | 3.82 | 33.40 | (0.685, 0.314) | 70 |
| Comparative Example 39 | 2-165 | - | 2.60 | 4.22 | 28.00 | (0.686, 0.313) | 35 |
| Comparative Example 40 | 2-167 | - | 2.49 | 4.00 | 54.64 | (0.685, 0.314) | 60 |
| Comparative Example 41 | 2-168 | - | 2.44 | 4.01 | 43.86 | (0.684, 0.315) | 75 |
| Comparative Example 42 | 1-85:A | 1:1 | 3.20 | 5.00 | 45.30 | (0.686, 0.313) | 150 |
| Comparative Example 43 | 1-85:D | 1:1 | 3.25 | 5.05 | 45.90 | (0.686, 0.313) | 155 |
| Comparative Example 44 | C:2-33 | 1:1 | 2.60 | 4.05 | 40.10 | (0.685, 0.314) | 110 |
| Comparative Example 45 | D:2-34 | 1:1 | 2.61 | 4.10 | 40.15 | (0.685, 0.314) | 115 |
| Example 36 | 1-85:2-33 | 5:1 | 2.23 | 3.38 | 68.35 | (0.686, 0.313) | 768 |
| Example 37 | 1-85:2-33 | 3:1 | 2.21 | 3.37 | 72.10 | (0.686, 0.313) | 800 |
| Example 38 | 1-85:2-33 | 1:1 | 2.20 | 3.30 | 75.11 | (0.686, 0.313) | 825 |
| Example 39 | 1-85:2-33 | 1:3 | 2.22 | 3.28 | 71.50 | (0.686, 0.313) | 797 |
| Example 40 | 1-85:2-33 | 1:5 | 2.24 | 3.25 | 66.32 | (0.686, 0.313) | 755 |
| Example 41 | 1-86:2-33 | 5:1 | 2.40 | 3.92 | 55.13 | (0.687, 0.312) | 630 |
| Example 42 | 1-86:2-33 | 3:1 | 2.31 | 3.71 | 62.10 | (0.687, 0.312) | 759 |
| Example 43 | 1-86:2-33 | 1:1 | 2.20 | 3.60 | 65.35 | (0.686, 0.313) | 930 |
| Example 44 | 1-86:2-33 | 1:3 | 2.30 | 3.55 | 60.00 | (0.686, 0.313) | 800 |
| Example 45 | 1-86:2-33 | 1:5 | 2.42 | 3.50 | 55.35 | (0.686, 0.313) | 690 |
| Example 46 | 1-87:2-33 | 3:1 | 2.63 | 4.25 | 45.11 | (0.687, 0.312) | 371 |
| Example 47 | 1-87:2-33 | 1:1 | 2.51 | 3.85 | 49.35 | (0.686, 0.313) | 450 |
| Example 48 | 1-87:2-33 | 1:3 | 2.40 | 3.61 | 46.35 | (0.685, 0.315) | 400 |
| Example 49 | 1-25:2-91 | 1:1 | 2.31 | 3.42 | 50.15 | (0.685, 0.315) | 315 |
| Example 50 | 1-26:2-33 | 1:1 | 2.55 | 3.61 | 55.10 | (0.687, 0.312) | 410 |
| Example 51 | 1-37:2-91 | 1:1 | 2.25 | 3.30 | 65.39 | (0.685, 0.315) | 590 |
| Example 52 | 1-85:2-34 | 1:1 | 2.45 | 3.85 | 60.13 | (0.686, 0.313) | 610 |
| Example 53 | 1-85:2-35 | 1:1 | 2.80 | 4.38 | 49.53 | (0.686, 0.313) | 450 |
| Example 54 | 1-98:2-33 | 1:1 | 2.15 | 3.19 | 72.93 | (0.685, 0.315) | 850 |
| Example 55 | 1:98:2-168 | 1:1 | 2.19 | 3.20 | 63.84 | (0.685, 0.315) | 700 |

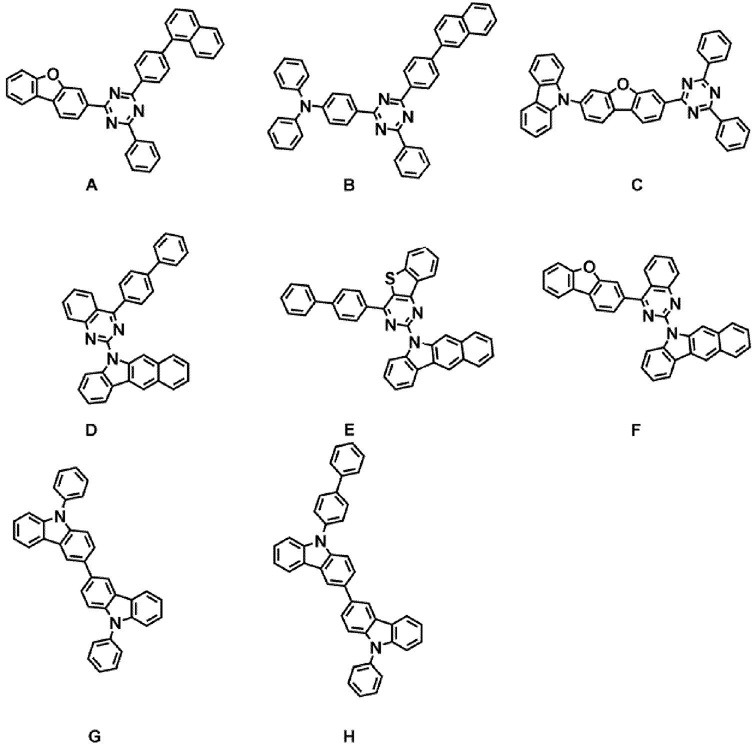

The heterocyclic compound of Chemical Formula 1 of the present disclosure has proper molecular weight and band gap while having high thermal stability. The proper band gap of the light emitting layer prevents a loss of electrons and holes, which helps with effective formation of a recombination zone. Accordingly, as seen from the device evaluation of Table 9, it was identified that the compounds of the present disclosure showed improved performance compared to the compounds of the comparative examples.

Particularly, when the substituent of N-Het is a compound of 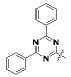 triazine-based, excellent efficiency and lifetime properties are obtained compared to other ET compounds such as 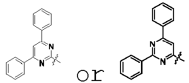 pyrimidine, and it was identified that electrons and holes were efficiently transferred compared to other ET-based resulting in superior performance through forming an efficient recombination zone.

On the other hand, when the substituent of N-Het is 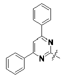 and 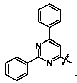 -based, electron and hole transfer properties differ depending on the position of the N atom, which readily controls a turn-on voltage of the device, but leads to unfavorable efficiency and lifetime properties.

As seen from the comparative examples, thermal stability is high when using the heterocyclic compound of Chemical Formula 2 alone, however, holes are not readily injected by failing to have a proper band gap due to the low HOMO level, and performance of high driving voltage and low lifetime is obtained due to the charge imbalance.

In other words, as seen from Table 9, it was identified through the results of device evaluation on the combination of the heterocyclic compound of Chemical Formula 1 and the heterocyclic compound of Chemical Formula 2 that superior effects were obtained in the properties of driving voltage, efficiency and lifetime when using the compound corresponding to the present disclosure as the light emitting layer of the organic light emitting device compared when not using the compound corresponding to the present disclosure.

In addition, when using the combination of the heterocyclic compound of Chemical Formula 1 and the heterocyclic compound of Chemical Formula 2 as the light emitting layer in the organic light emitting device, improved properties of driving voltage, efficiency and lifetime were obtained compared to when using the compound alone as the light emitting layer. This corresponds to results of lowering a driving voltage at which electrons and holes are injected, and enhancing efficiency and lifetime through effective formation of a recombination zone when using both a donor (p-host) having a favorable hole transfer ability and an acceptor (n-host) having a favorable electron transfer ability as a host of the light emitting layer.

### 1-2) Experimental Example (2 Stack Red N+P Mixed Host)

A glass substrate on which indium tin oxide (ITO) was coated as a thin film to a thickness of 1,500 Å was cleaned with distilled water ultrasonic waves. After the cleaning with distilled water was finished, the substrate was ultrasonic cleaned with solvents such as acetone, methanol and isopropyl alcohol, then dried, and ultraviolet ozone (UVO) treatment was conducted for 5 minutes using UV in an ultraviolet (UV) cleaner. After that, the substrate was transferred to a plasma cleaner (PT), and after conducting plasma treatment under vacuum for ITO work function and residual film removal, the substrate was transferred to a thermal deposition apparatus for organic deposition.

On the transparent ITO electrode (anode), a hole injection layer 2-TNATA (4,4',4"-tris[2-naphthyl (phenyl)amino]triphenylamine) and a hole transfer layer NPB (N,N'-di(1-naphthyl)-N,N'-diphenyl-(1,1'-biphenyl)-4,4'-diamine), which are common layers, were formed.

A light emitting layer was thermal vacuum deposited thereon as follows. The light emitting layer was deposited to 400 Å using a compound described in the following Table 10 as a red host and (piq)₂(Ir) (acac) as a red phosphorescent dopant, and doping the (piq)₂(Ir) (acac) to the host by 2%.

After that, Alq₃ was deposited to 120 Å as an electron transfer layer, Bphen was deposited to 120 Å thereon as a charge generation layer, and MoO₃ was also deposited to 100 Å thereon as another charge generation layer. A hole transfer layer NPB (N,N'-di(1-naphthyl)-N,N'-diphenyl-(1,1'-biphenyl)-4,4'-diamine) was formed.

A light emitting layer was thermal vacuum deposited thereon as follows. The light emitting layer was deposited to 400 Å using a compound described in the following Table 10 as a red host and (piq)₂(Ir) (acac) as a red phosphorescent dopant, and doping the (piq)₂(Ir) (acac) to the host by 2%.

After that, Alq₃ was deposited to 300 Å as an electron transfer layer. Lastly, an electron injection layer was formed on the electron transfer layer by depositing lithium fluoride (LiF) to a thickness of 20 Å, and then a cathode was formed on the electron injection layer by depositing an aluminum (Al) cathode to a thickness of 1,200 Å, and as a result, an organic electroluminescent device was manufactured.

Meanwhile, all the organic compounds required to manufacture the OLED were vacuum sublimation purified under 10⁻⁸ torr to 10⁻⁶ torr for each material to be used in the OLED manufacture.

For each of the organic electroluminescent devices manufactured as above, electroluminescent (EL) properties were measured using M7000 manufactured by McScience Inc., and with the measurement results, T₉₀ was measured when standard luminance was 6,000 cd/m² through a lifetime measurement system (M6000) manufactured by McScience Inc.. Properties of the organic electroluminescent devices of the present disclosure are as shown in the following Table 10.

**[Table 10]**

| | Light Emitting Layer Compound | Ratio (p:n) | Turn -on (V) | Driving Voltage (V) | Efficiency (cd/A) | Color Coordinate (x, y) | Lifetime (T₉₀) |
|---|---|---|---|---|---|---|---|
| Comparative Example 2-1 | Single Host (1-85) | - | 4.16 | 5.31 | 93.75 | (0.686, 0.313) | 260 |
| Comparative Example 2-2 | Single Host (1-86) | - | 5.51 | 6.00 | 70.11 | (0.686, 0.313) | 120 |
| Comparative Example 2-3 | 1-86:D | 1:1 | 6.41 | 7.90 | 45.50 | (0.685, 0.315) | 70 |
| Comparative Example 2-4 | G:2-33 | 1:1 | 7.15 | 8.35 | 44.11 | (0.686, 0.313) | 65 |
| Example 2-1 | 1-85:2-33 | 2:1 | 3.70 | 4.98 | 129.39 | (0.686, 0.313) | 790 |
| Example 2-2 | 1-85:2-33 | 1:1 | 3.51 | 4.79 | 135.83 | (0.686, 0.313) | 950 |
| Example 2-3 | 1-85:2-33 | 1:2 | 3.33 | 4.43 | 128.36 | (0.686, 0.313) | 800 |
| Example 2-4 | 1-86:2-33 | 2:1 | 3.98 | 5.80 | 86.37 | (0.686, 0.313) | 480 |
| Example 2-5 | 1-86:2-33 | 1:1 | 3.76 | 5.59 | 110.91 | (0.686, 0.313) | 800 |
| Example 2-6 | 1-86:2-33 | 1:2 | 3.55 | 5.35 | 90.35 | (0.686, 0.313) | 690 |
| Example 2-7 | 1-25:2-33 | 1:1 | 5.11 | 6.35 | 60.37 | (0.686, 0.313) | 300 |
| Example 2-8 | 1-37:2-33 | 1:1 | 4.60 | 5.11 | 113.91 | (0.686, 0.313) | 800 |
| Example 2-9 | 1-88:2-33 | 1:1 | 4.38 | 4.68 | 90.85 | (0.685, 0.315) | 870 |
| Example 2-10 | 1-86:2:34 | 1:1 | 4.99 | 6.05 | 100.95 | (0.685, 0.315) | 750 |

As seen from the device evaluation results, the 2-stack is a case of depositing the light emitting layer twice, and it was identified that efficiency increased compared to the single light emitting layer.

In addition, as seen from Table 10, it was also identified through the results of device evaluation on the combination of the heterocyclic compound of Chemical Formula 1 and the heterocyclic compound of Chemical Formula 2 that superior effects were obtained in the properties of driving voltage, efficiency and lifetime when using the compound corresponding to the present disclosure as the light emitting layer of the organic light emitting device compared when not using the compound corresponding to the present disclosure.

In addition, when using the combination of the heterocyclic compound of Chemical Formula 1 and the heterocyclic compound of Chemical Formula 2 as the light emitting layer in the organic light emitting device, improved properties of driving voltage, efficiency and lifetime were obtained compared to when using the compound alone as the light emitting layer. This corresponds to results of lowering a driving voltage at which electrons and holes are injected, and enhancing efficiency and lifetime through effective formation of a recombination zone when using both a donor (p-host) having a favorable hole transfer ability and an acceptor (n-host) having a favorable electron transfer ability as a host of the light emitting layer.

The scope of the present invention is set forth in the following claims.

## Claims

1. An organic light emitting device comprising:
a first electrode;
a second electrode; and
one or more organic material layers (300) provided between the first electrode and the second electrode,
wherein one or more layers of the organic material layers (300) include a heterocyclic compound represented by the following Chemical Formula 1 and a heterocyclic compound represented by the following Chemical Formula 2: 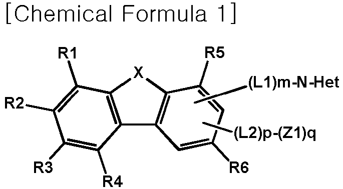 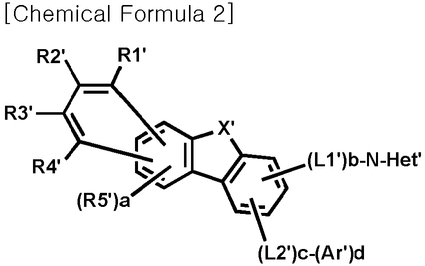
in Chemical Formulae 1 and 2,
X and X' are O,
L1 and L2 are the same as or different from each other, and each independently a direct bond; or a phenylene group,
L1' and L2' are the same as or different from each other, and each independently a direct bond; a phenylene group; a biphenylene group; or a naphthalene group,
N-Het is a triazine group unsubstituted or substituted with one or more substituents selected form the group consisting of a phenyl group, a biphenyl group, a terphenyl group, a naphthyl group, a triphenylenyl group, a dibenzofuran group, a dibenzothiophene group, a pyridine group, a dimethylfluorenyl group, a diphenylfluorenyl group and a spirobifluorene group; a pyrimidine group unsubstituted or substituted with a phenyl group; a pyridine group unsubstituted or substituted with a phenyl group; a quinoline group unsubstituted or substituted with a phenyl group;
a quinazoline group unsubstituted or substituted with a phenyl group; a phenanthroline group; or a benzo[4,5]thieno[2,3-d]pyrimidine group unsubstituted or substituted with a phenyl group,
N-Het is substituted again with -CN; a phenyl group; or SiRR'R",
N-Het' is a triazine group unsubstituted or substituted with one or more substituents selected form the group consisting of a phenyl group, a biphenyl group, a naphthyl group, a triphenylenyl group, a dibenzofuran group, a dibenzothiophene group and a carbazole group unsubstituted or substituted with a phenyl group; a pyrimidine group unsubstituted or substituted with a phenyl group; a pyridine group unsubstituted or substituted with a phenyl group; a quinazoline group unsubstituted or substituted with one or more substituents selected form the group consisting of a phenyl group, a biphenyl group, a terphenyl group, a naphthyl group and a dibenzofuran group; a benzofuro[3,2-d]pyrimidine group unsubstituted or substituted with a phenyl group or a naphthyl group;
or a benzo[4,5]thieno[2,3-d]pyrimidine group unsubstituted or substituted with a phenyl group or a naphthyl group,
N-Het' is substituted again with a phenyl group; or a naphthyl group,
Ar' is selected from the group consisting of a phenyl group; a biphenyl group; a naphthyl group; a terphenyl group; a carbazole group; a phenyl ring-fused carbazole group; and
an amine group unsubstituted or substituted with one or more substituents selected form the group consisting of a phenyl group, a biphenyl group, a naphthyl group, a dimethylfluorenyl group, a dibenzofuran group and a dibenzothiophene group,
wherein Z1 of Chemical Formula 1 is an amine group unsubstituted or substituted with one or more substituents selected from the group consisting of a phenyl group, a biphenyl group, a naphthyl group, a dimethylfluorenyl group, a dibenzothiophene group and a dibenzofuran group, or represented by Chemical Formula 1-1, 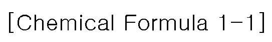 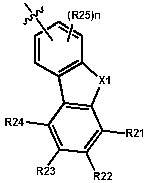
in Chemical Formula 1-1, 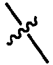 means a position linked to L2 of Chemical Formula 1;
X1 is O or S,
R21 to R25 are the same as or different from each other, and each independently selected from the group consisting of hydrogen; a phenyl group; a biphenyl group; a triphenylenyl group; and a dibenzothiophene group, or groups adjacent to each other may bond to each other to form a phenyl ring
n is an integer of 0 to 3;
when n is 2 or greater, substituents in the parentheses are the same as or different from each other; and
R1 to R6 and R1' to R5' are the same as or different from each other, and each independently selected from the group consisting of hydrogen; and deuterium, R, R' and R" are a phenyl group,
m, p, b and c are an integer of 0 to 3;
q and d are an integer of 1 to 6;
a is an integer of 0 to 2; and
when a is 2 or m, p, b, c, q and d are 2 or greater, substituents in the parentheses are the same as or different from each other.

2. The organic light emitting device of Claim 1, wherein Chemical Formula 1 is represented by the following Chemical Formula 3 or Chemical Formula 4: 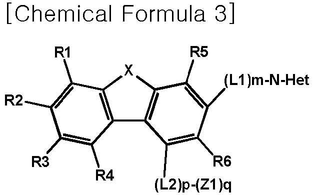 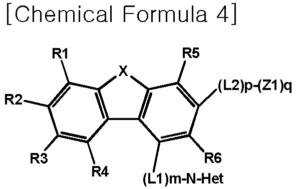
in Chemical Formulae 3 and 4,
R1 to R6, L1, L2, Z1, N-Het, X, m, p and q have the same definitions as in Chemical Formula 1.

3. The organic light emitting device of Claim 1, wherein Chemical Formula 2 is represented by any one of the following Chemical Formulae 2-1 to 2-3: 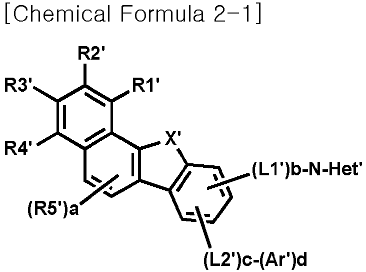 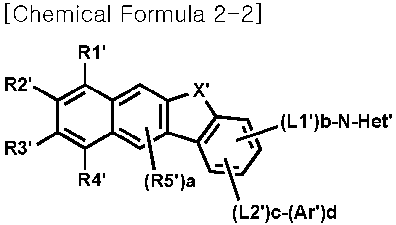 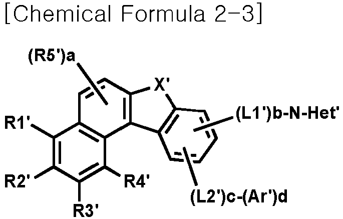
in Chemical Formulae 2-1 to 2-3,
each substituent has the same definition as in Chemical Formula 2.

4. The organic light emitting device of Claim 1, wherein Chemical Formula 2 is represented by any one of the following Chemical Formulae 2-4 to 2-7: 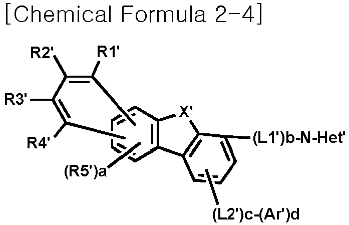 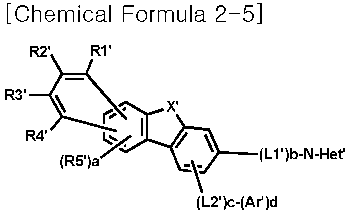 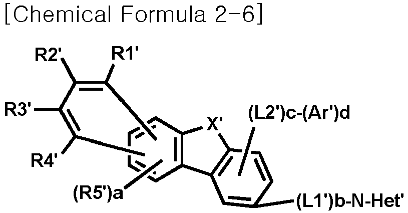 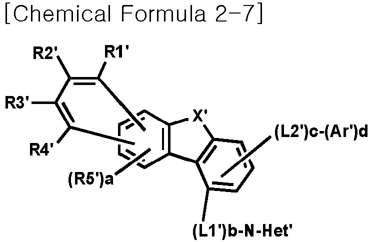
in Chemical Formulae 2-4 to 2-7,
each substituent has the same definition as in Chemical Formula 2.

5. The organic light emitting device of Claim 1, wherein R1 to R6 and R1' to R5' are hydrogen.

6. The organic light emitting device of Claim 1, wherein Chemical Formula 1 is represented by any one of the following compounds:

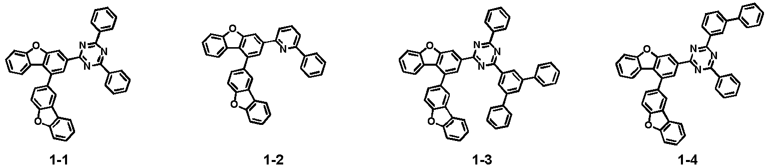

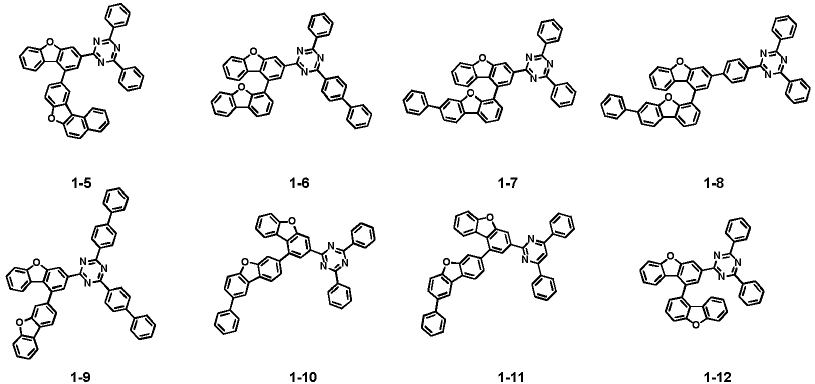

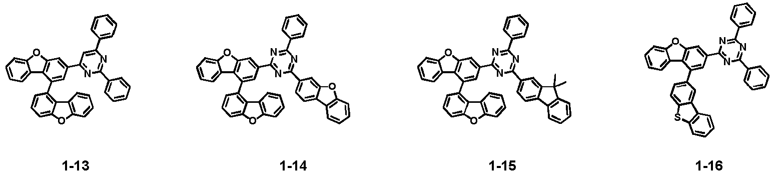

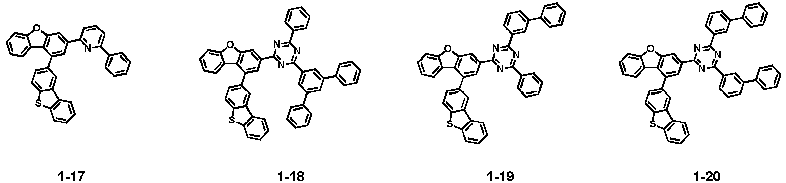

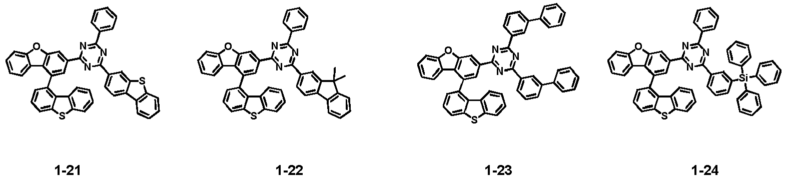

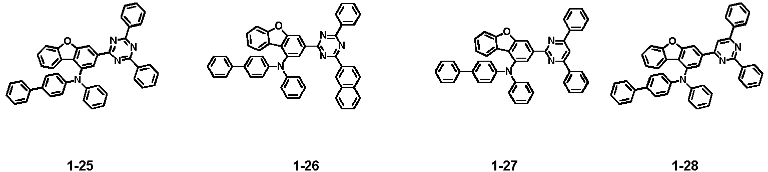

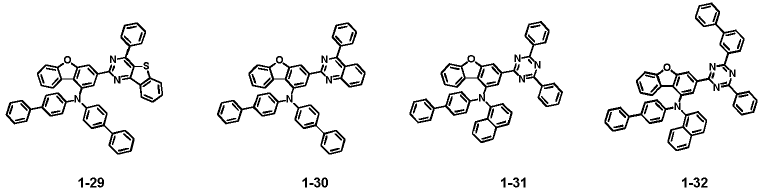

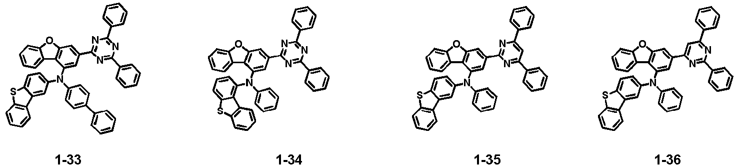

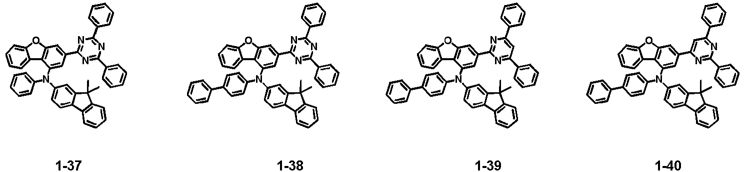

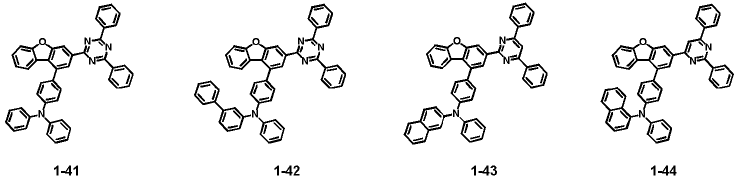

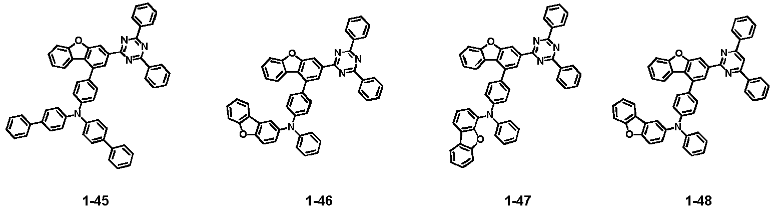

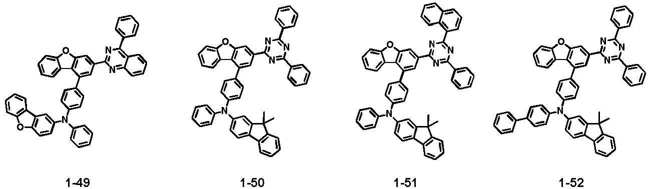

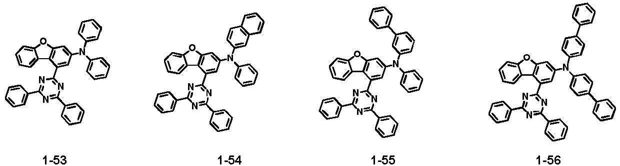

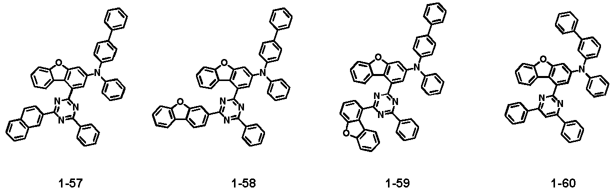

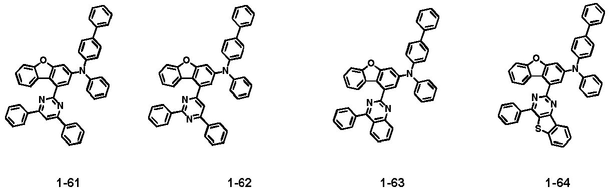

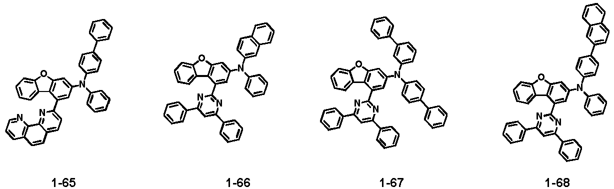

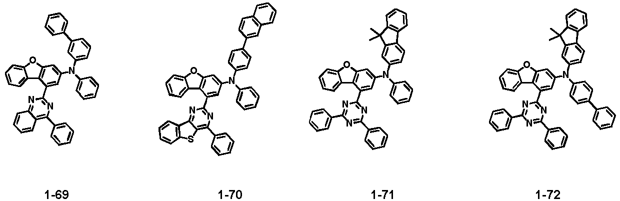

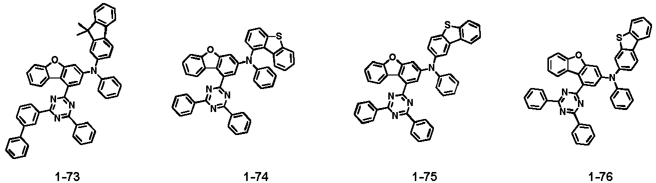

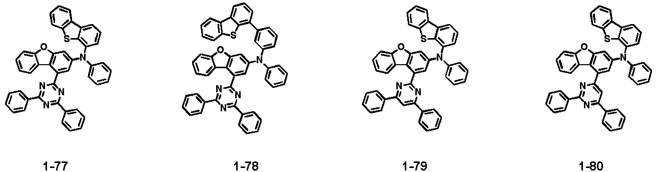

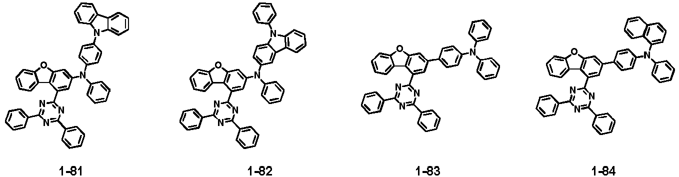

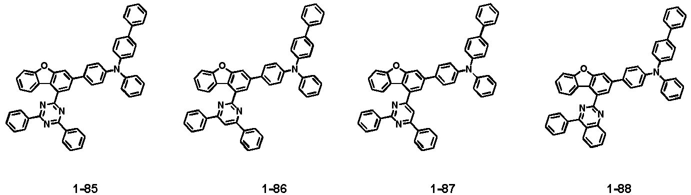

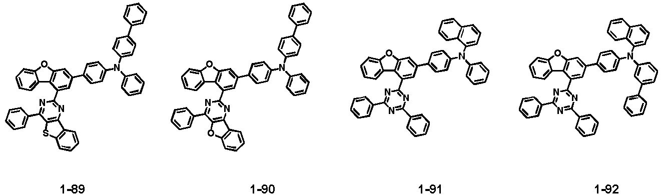

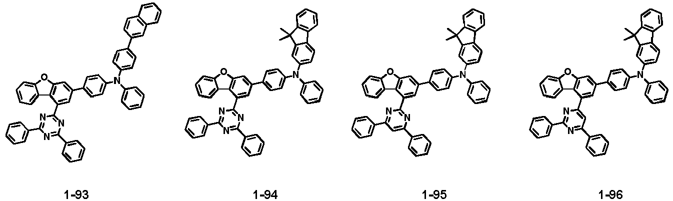

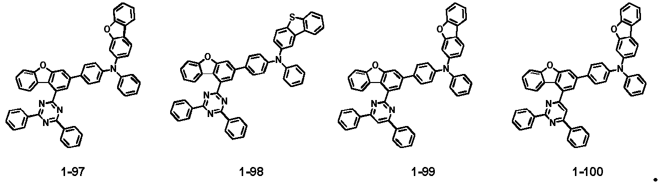

7. The organic light emitting device of Claim 1, wherein Chemical Formula 2 is represented by any one of the following compounds:

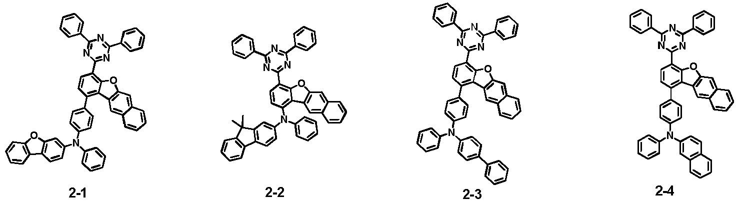

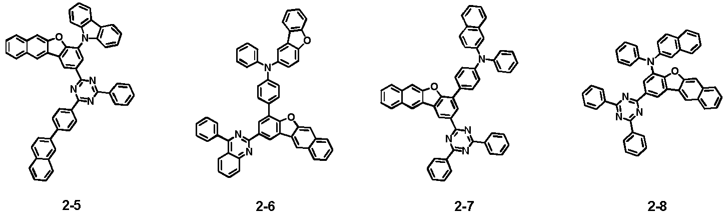

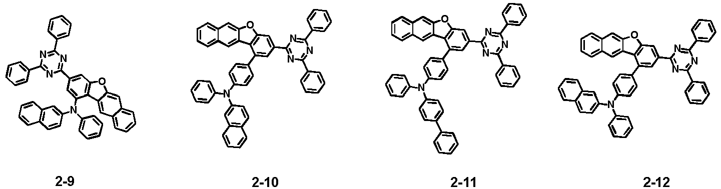

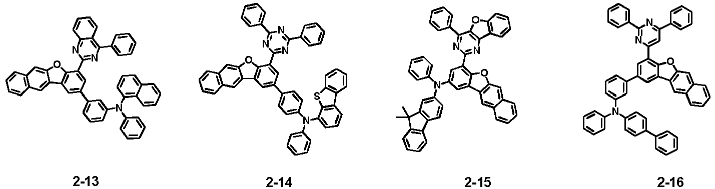

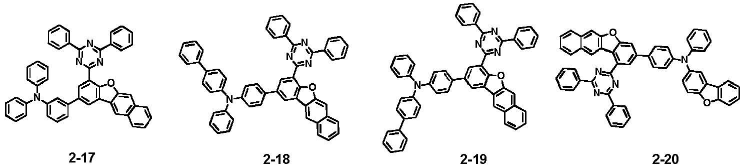

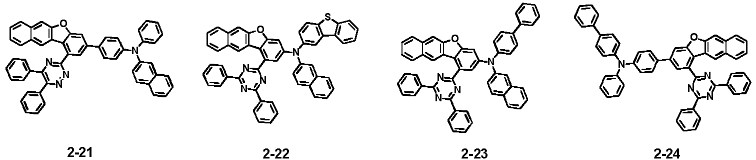

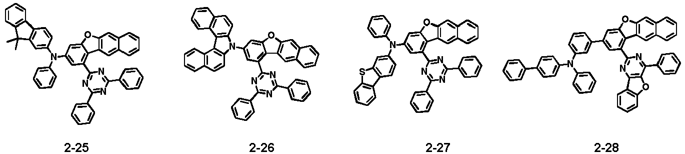

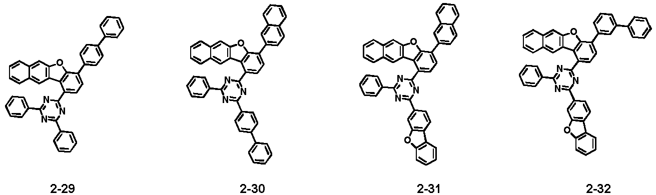

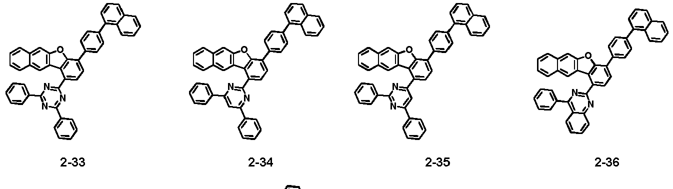

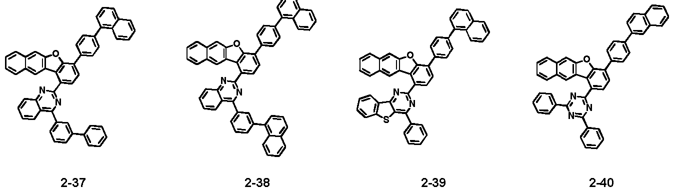

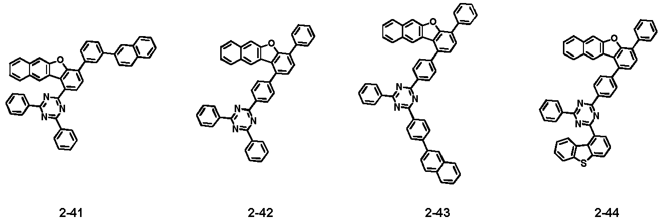

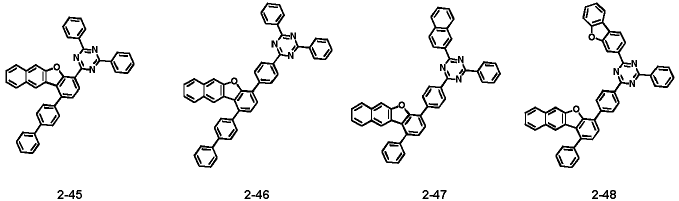

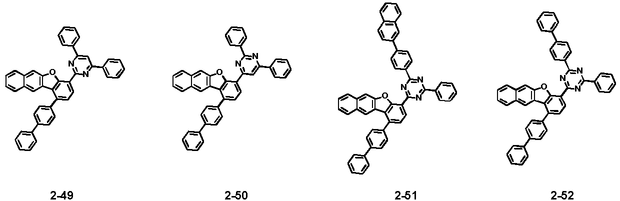

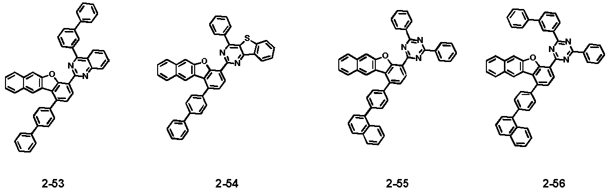

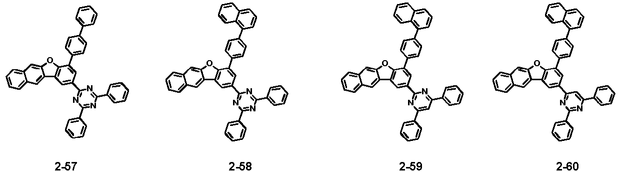

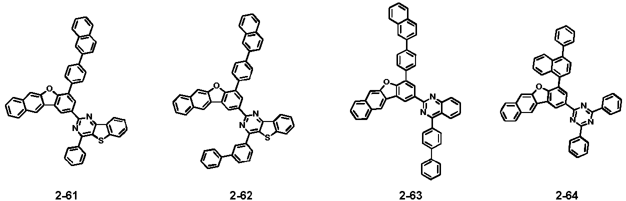

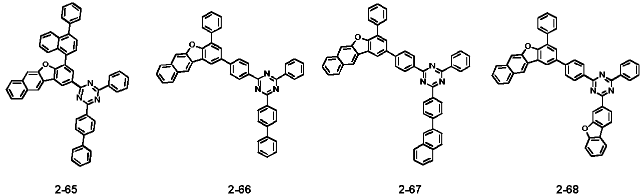

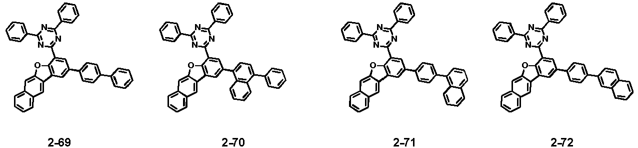

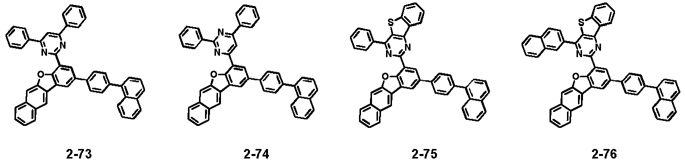

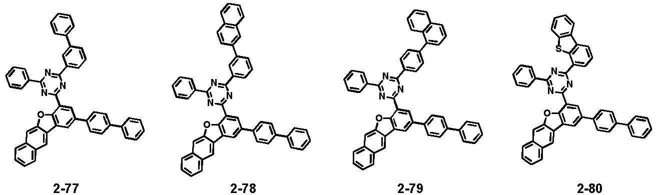

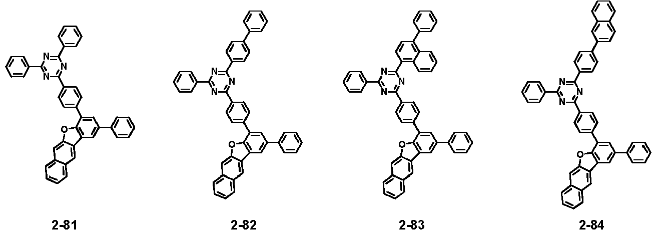

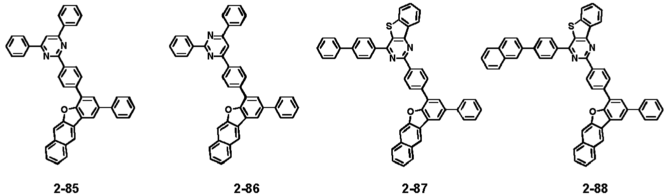

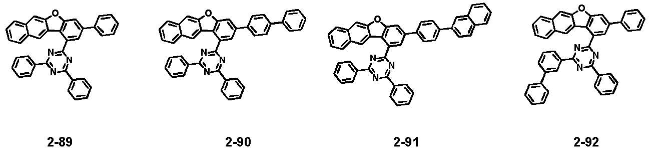

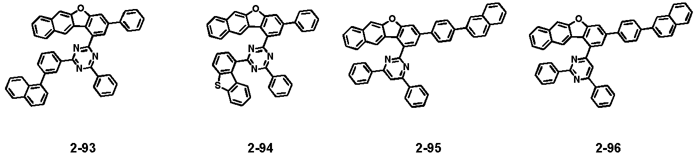

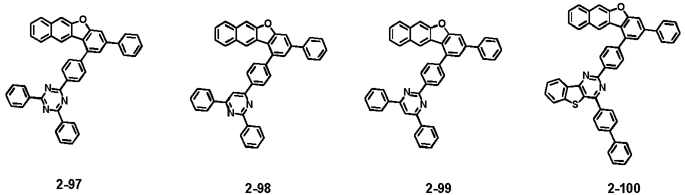

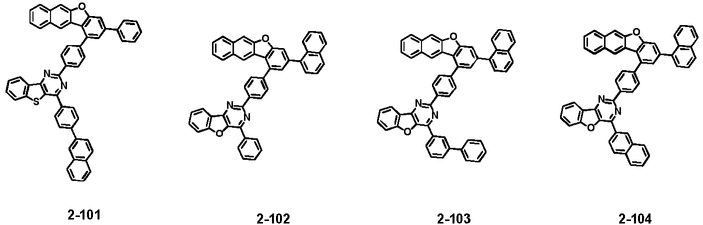

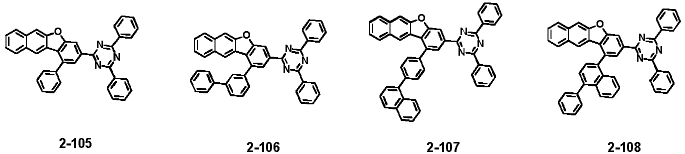

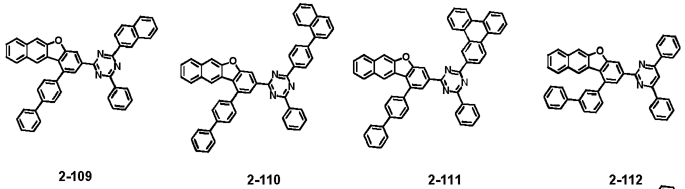

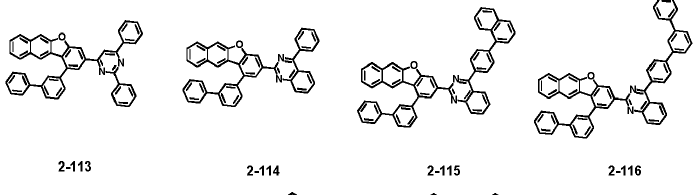

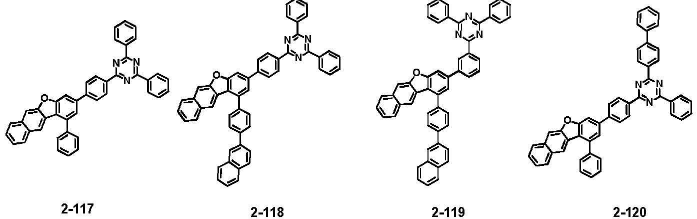

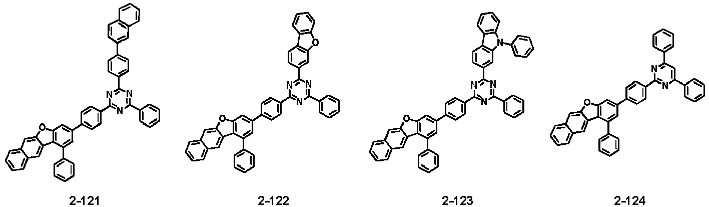

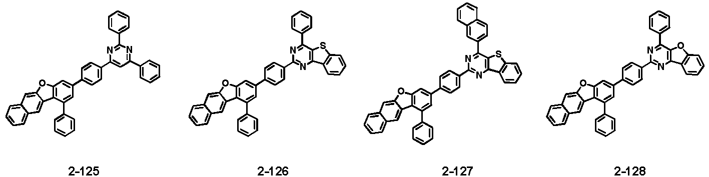

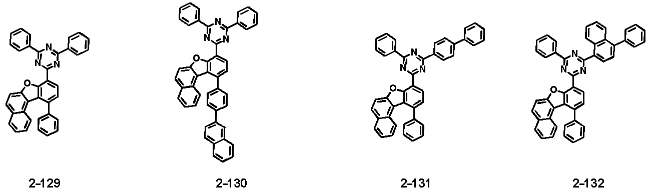

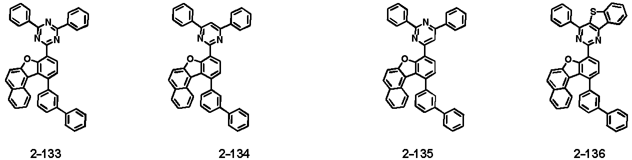

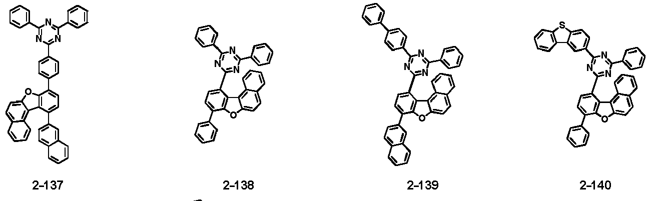

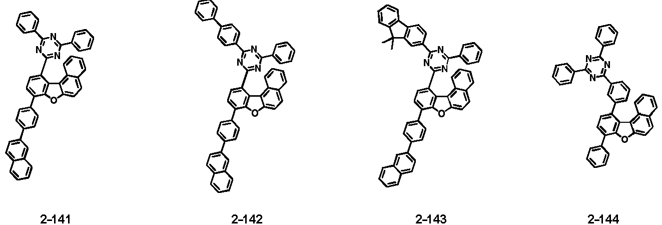

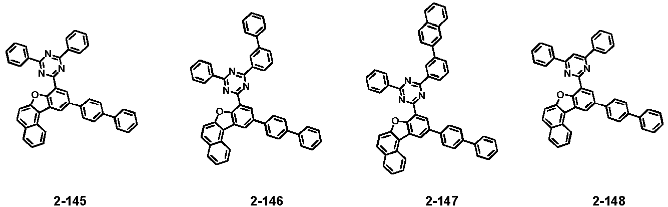

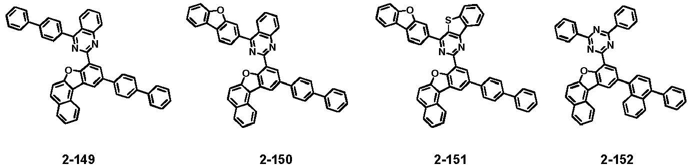

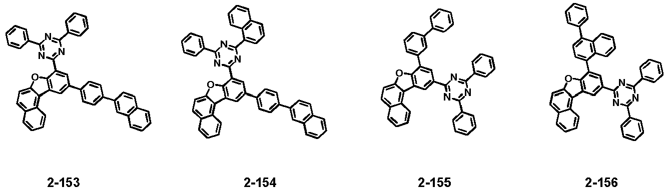

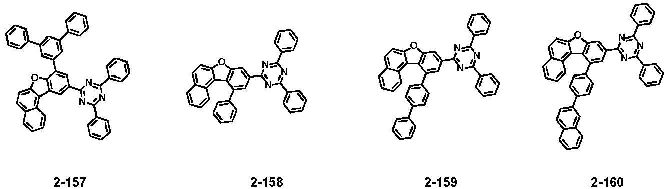

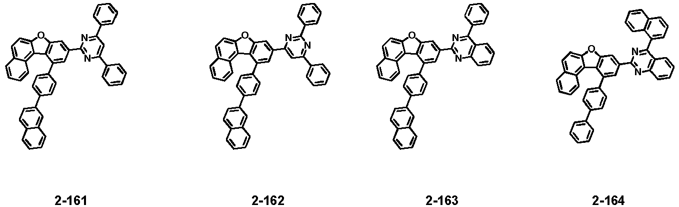

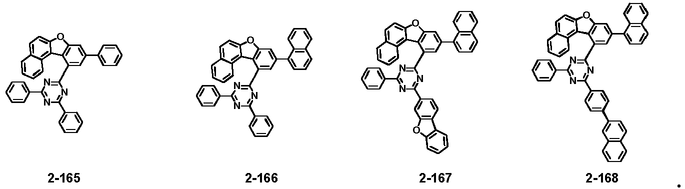

8. The organic light emitting device of Claim 1, wherein the organic material layer (300) includes at least one of a hole blocking layer (304), an electron injection layer (306) and an electron transfer layer (305), and the at least one of a hole blocking layer (304), an electron injection layer (306) and an electron transfer layer (305) includes the heterocyclic compound represented by Chemical Formula 1 and the heterocyclic compound represented by Chemical Formula 2.

9. The organic light emitting device of Claim 1, wherein the organic material layer (300) includes a light emitting layer (303), the light emitting layer (303) includes a host material, and the host material includes the heterocyclic compound represented by Chemical Formula 1 and the heterocyclic compound represented by Chemical Formula 2.

10. The organic light emitting device of Claim 1, further comprising one, two or more layers selected from the group consisting of a light emitting layer (303), a hole injection layer (301), a hole transfer layer (302), an electron injection layer (306), an electron transfer layer (305), an electron blocking layer and a hole blocking layer (304).

11. A composition for an organic material layer (300) of an organic light emitting device, the composition comprising:
a heterocyclic compound represented by the following Chemical Formula 1; and
a compound represented by the following Chemical Formula 2: 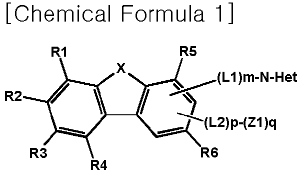 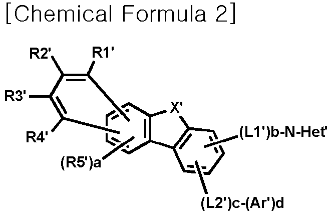
in Chemical Formulae 1 and 2,
X and X' are O,
L1 and L2 are the same as or different from each other, and each independently a direct bond; or a phenylene group,
L1' and L2' are the same as or different from each other, and each independently a direct bond; a phenylene group; a biphenylene group; or a naphthalene group,
N-Het is a triazine group unsubstituted or substituted with one or more substituents selected form the group consisting of a phenyl group, a biphenyl group, a terphenyl group, a naphthyl group, a triphenylenyl group, a dibenzofuran group, a dibenzothiophene group, a pyridine group, a dimethylfluorenyl group, a diphenylfluorenyl group and a spirobifluorene group; a pyrimidine group unsubstituted or substituted with a phenyl group; a pyridine group unsubstituted or substituted with a phenyl group; a quinoline group unsubstituted or substituted with a phenyl group;
a quinazoline group unsubstituted or substituted with a phenyl group; a phenanthroline group; or a benzo [4,5]thieno[2,3-d]pyrimidine group unsubstituted or substituted with a phenyl group,
N-Het is substituted again with -CN; a phenyl group; or SiRR'R",
N-Het' is a triazine group unsubstituted or substituted with one or more substituents selected form the group consisting of a phenyl group, a biphenyl group, a naphthyl group, a triphenylenyl group, a dibenzofuran group, a dibenzothiophene group and a carbazole group unsubstituted or substituted with a phenyl group; a pyrimidine group unsubstituted or substituted with a phenyl group; a pyridine group unsubstituted or substituted with a phenyl group; a quinazoline group unsubstituted or substituted with one or more substituents selected form the group consisting of a phenyl group, a biphenyl group, a terphenyl group, a naphthyl group and a dibenzofuran group; a benzofuro[3,2-d]pyrimidine group unsubstituted or substituted with a phenyl group or a naphthyl group; or a benzo[4,5]thieno[2,3-d]pyrimidine group unsubstituted or substituted with a phenyl group or a naphthyl group,
N-Het' is substituted again with a phenyl group; or a naphthyl group,
Ar' is selected from the group consisting of a phenyl group; a biphenyl group; a naphthyl group; a terphenyl group; a carbazole group; a phenyl ring-fused carbazole group; and an amine group unsubstituted or substituted with one or more substituents selected form the group consisting of a phenyl group, a biphenyl group, a naphthyl group, a dimethylfluorenyl group, a dibenzofuran group and a dibenzothiophene group,
wherein Z1 of Chemical Formula 1 is an amine group unsubstituted or substituted with one or more substituents selected from the group consisting of a phenyl group, a biphenyl group, a naphthyl group, a dimethylfluorenyl group, a dibenzothiophene group and a dibenzofuran group, or represented by Chemical Formula 1-1, 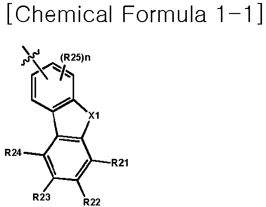
in Chemical Formula 1-1, 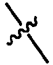 means a position linked to L2 of Chemical Formula 1;
X1 is O or S,
R21 to R25 are the same as or different from each other, and each independently selected from the group consisting of hydrogen; a phenyl group; a biphenyl group; a triphenylenyl group; and a dibenzothiophene group, or groups adjacent to each other may bond to each other to form a phenyl ring
n is an integer of 0 to 3;
when n is 2 or greater, substituents in the parentheses are the same as or different from each other; and
R1 to R6 and R1' to R5' are the same as or different from each other, and each independently selected from the group consisting of hydrogen; and deuterium, R, R' and R" are a phenyl group,
m, p, b and c are an integer of 0 to 3;
q and d are an integer of 1 to 6;
a is an integer of 0 to 2; and
when a is 2 or m, p, b, c, q and d are 2 or greater, substituents in the parentheses are the same as or different from each other.

12. The composition for an organic material layer (300) of an organic light emitting device of Claim 11, wherein the heterocyclic compound represented by Chemical Formula 1:the heterocyclic compound represented by Chemical Formula 2 have a weight ratio of 1:10 to 10:1 in the composition.

13. A method for manufacturing an organic light emitting device, the method comprising:
preparing a substrate (100);
forming a first electrode on the substrate (100);
forming one or more organic material layers (300) on the first electrode; and
forming a second electrode on the organic material layer (300),
wherein the forming of organic material layers (300) includes forming one or more organic material layers (300) using the composition for an organic material layer (300) of Claim 11.

14. The method for manufacturing an organic light emitting device of Claim 13, wherein the forming of organic material layers (300) is forming using a thermal vacuum deposition method after pre-mixing the heterocyclic compound of Chemical Formula 1 and the heterocyclic compound of Chemical Formula 2.

## Patentansprüche

1. Organische lichtemittierende Vorrichtung, umfassend:
eine erste Elektrode;
eine zweite Elektrode; und
eine oder mehrere organische Materialschichten (300), die zwischen der ersten Elektrode und der zweiten Elektrode bereitgestellt sind,
wobei eine oder mehrere Schichten der organischen Materialschichten (300) eine heterocyclische Verbindung, die durch die folgende chemische Formel 1 dargestellt ist, und eine heterocyclische Verbindung, die durch die folgende chemische Formel 2 dargestellt ist, umfassen: 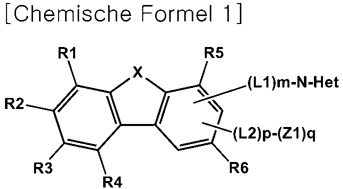 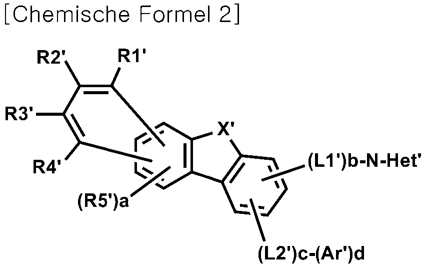
wobei in den chemischen Formeln 1 und 2
X und X' O sind,
L1 und L2 gleich oder verschieden voneinander sind und jeweils unabhängig eine direkte Bindung; oder eine Phenylengruppe sind,
L1' und L2' gleich oder verschieden voneinander sind und jeweils unabhängig eine direkte Bindung; eine Phenylengruppe; eine Biphenylengruppe; oder eine Naphthalingruppe sind,
N-Het eine Triazingruppe, unsubstituiert oder substituiert mit einem oder mehreren Substituenten, ausgewählt aus der Gruppe, bestehend aus einer Phenylgruppe, einer Biphenylgruppe, einer Terphenylgruppe, einer Naphthylgruppe, einer Triphenylenylgruppe, einer Dibenzofurangruppe, einer Dibenzothiophengruppe, einer Pyridingruppe, einer Dimethylfluorenylgruppe, einer Diphenylfluorenylgruppe und einer Spirobifluorengruppe; eine Pyrimidingruppe, unsubstituiert oder substituiert mit einer Phenylgruppe; eine Pyridingruppe, unsubstituiert oder substituiert mit einer Phenylgruppe; eine Chinolingruppe, unsubstituiert oder substituiert mit einer Phenylgruppe;
eine Chinazolingruppe, unsubstituiert oder substituiert mit einer Phenylgruppe; eine Phenanthrolingruppe; oder eine Benzo[4,5]thieno[2,3-d]pyrimidingruppe, unsubstituiert oder substituiert mit einer Phenylgruppe, ist,
N-Het wiederum mit -CN; einer Phenylgruppe; oder SiRR'R" substituiert ist,
N-Het' eine Triazingruppe, unsubstituiert oder substituiert mit einem oder mehreren Substituenten, ausgewählt aus der Gruppe, bestehend aus einer Phenylgruppe, einer Biphenylgruppe, einer Naphthylgruppe, einer Triphenylenylgruppe, einer Dibenzofurangruppe, einer Dibenzothiophengruppe und einer Carbazolgruppe, unsubstituiert oder substituiert mit einer Phenylgruppe; eine Pyrimidingruppe, unsubstituiert oder substituiert mit einer Phenylgruppe; eine Pyridingruppe, unsubstituiert oder substituiert mit einer Phenylgruppe; eine Chinazolingruppe, unsubstituiert oder substituiert mit einem oder mehreren Substituenten, ausgewählt aus der Gruppe, bestehend aus einer Phenylgruppe, einer Biphenylgruppe, einer Terphenylgruppe, einer Naphthylgruppe und einer Dibenzofurangruppe; eine Benzofuro[3,2-d]pyrimidingruppe, unsubstituiert oder substituiert mit einer Phenylgruppe oder einer Naphthylgruppe; oder eine Benzo[4,5]thieno[2,3-d]pyrimidingruppe, unsubstituiert oder substituiert mit einer Phenylgruppe oder einer Naphthylgruppe, ist,
N-Het' wiederum mit einer Phenylgruppe; oder einer Naphthylgruppe substituiert ist,
Ar' ausgewählt ist aus der Gruppe, bestehend aus einer Phenylgruppe; einer Biphenylgruppe; einer Naphthylgruppe; einer Terphenylgruppe; einer Carbazolgruppe; einer Phenylring-kondensierten Carbazolgruppe; und einer Amingruppe, unsubstituiert oder substituiert mit einem oder mehreren Substituenten, ausgewählt aus der Gruppe, bestehend aus einer Phenylgruppe, einer Biphenylgruppe, einer Naphthylgruppe, einer Dimethylfluorenylgruppe, einer Dibenzofurangruppe und einer Dibenzothiophengruppe, wobei Z1 der chemischen Formel 1 eine Amingruppe, unsubstituiert oder substituiert mit einem oder mehreren Substituenten, ausgewählt aus der Gruppe, bestehend aus einer Phenylgruppe, einer Biphenylgruppe, einer Naphthylgruppe, einer Dimethylfluorenylgruppe, einer Dibenzothiophengruppe und einer Dibenzofurangruppe, oder dargestellt durch die chemische Formel 1-1 ist, 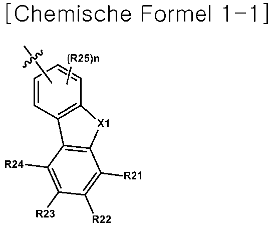
wobei in der chemischen Formel 1-1 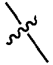 eine Position bedeutet, die mit L2 der chemischen Formel 1 verknüpft ist;
X1 O oder S ist,
R21 bis R25 gleich oder verschieden voneinander sind und jeweils unabhängig ausgewählt sind aus der Gruppe, bestehend aus Wasserstoff; einer Phenylgruppe; einer Biphenylgruppe; einer Triphenylenylgruppe; und einer Dibenzothiophengruppe, oder Gruppen, die zueinander benachbart sind, aneinander binden können, um einen Phenylring zu bilden,
n eine ganze Zahl von 0 bis 3 ist;
wenn n 2 oder größer ist, Substituenten in den Klammern gleich oder verschieden voneinander sind; und
R1 bis R6 und R1' bis R5' gleich oder verschieden voneinander sind und jeweils unabhängig ausgewählt sind aus der Gruppe, bestehend aus Wasserstoff; und Deuterium,
R, R' und R" eine Phenylgruppe sind,
m, p, b und c eine ganze Zahl von 0 bis 3 sind;
q und d eine ganze Zahl von 1 bis 6 sind;
a eine ganze Zahl von 0 bis 2 ist; und
wenn a 2 oder m ist, p, b, c, q und d 2 oder größer sind, Substituenten in den Klammern gleich oder verschieden voneinander sind.

2. Organische lichtemittierende Vorrichtung nach Anspruch 1, wobei die chemische Formel 1 durch die folgende chemische Formel 3 oder chemische Formel 4 dargestellt ist: 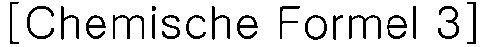 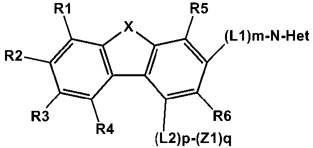 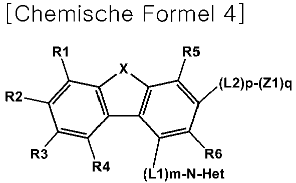
wobei in den chemischen Formeln 3 und 4
R1 bis R6, L1, L2, Z1, N-Het, X, m, p und q die gleichen Definitionen wie in der chemischen Formel 1 haben.

3. Organische lichtemittierende Vorrichtung nach Anspruch 1, wobei die chemische Formel 2 durch eine der folgenden chemischen Formeln 2-1 bis 2-3 dargestellt ist: 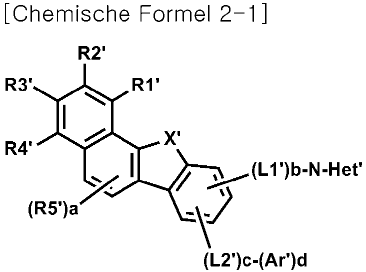 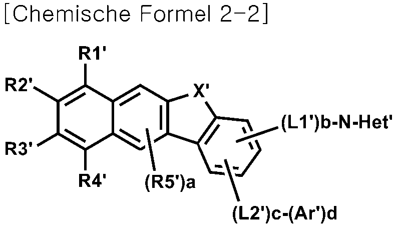 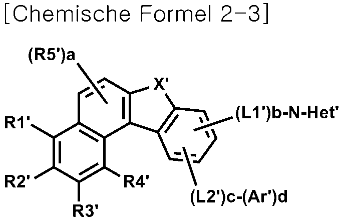
wobei in den chemischen Formeln 2-1 bis 2-3
jeder Substituent die gleiche Definition wie in der chemischen Formel 2 hat.

4. Organische lichtemittierende Vorrichtung nach Anspruch 1, wobei die chemische Formel 2 durch eine der folgenden chemischen Formeln 2-4 bis 2-7 dargestellt ist: 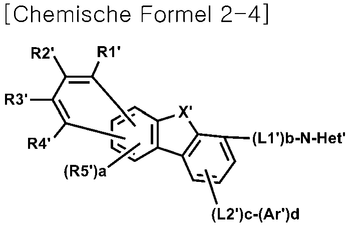 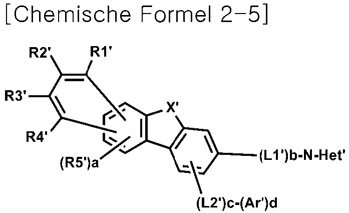 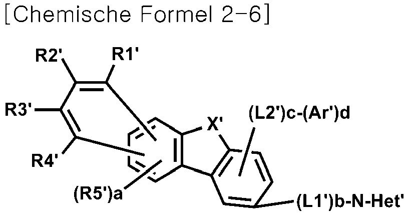 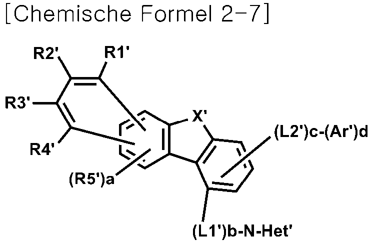
wobei in den chemischen Formeln 2-4 bis 2-7
jeder Substituent die gleiche Definition wie in der chemischen Formel 2 hat.

5. Organische lichtemittierende Vorrichtung nach Anspruch 1, wobei R1 bis R6 und R1' bis R5' Wasserstoff sind.

6. Organische lichtemittierende Vorrichtung nach Anspruch 1, wobei die chemische Formel 1 durch eine der folgenden Verbindungen dargestellt ist:

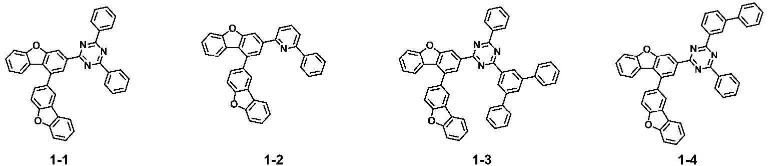

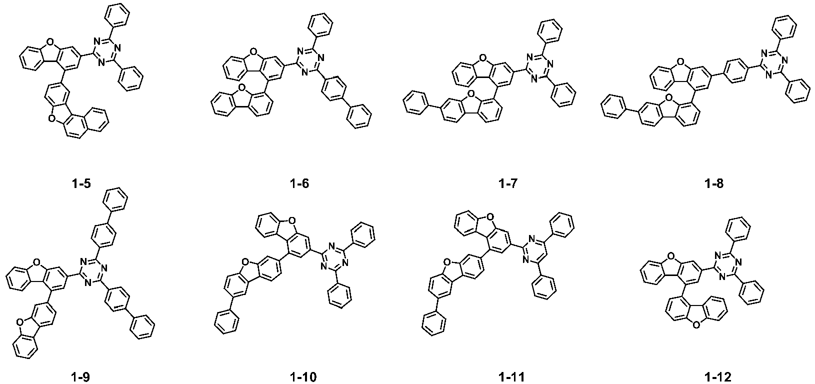

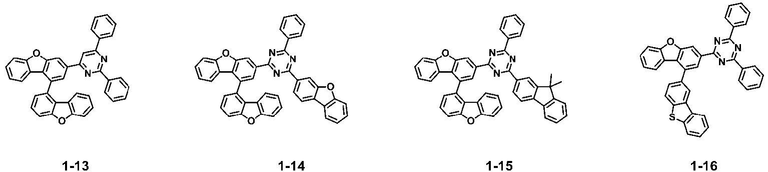

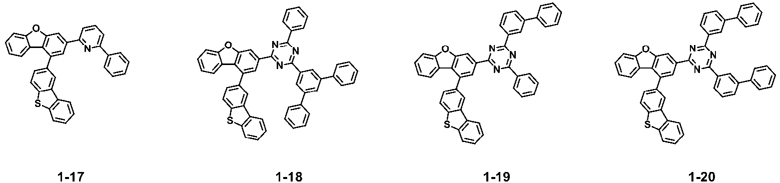

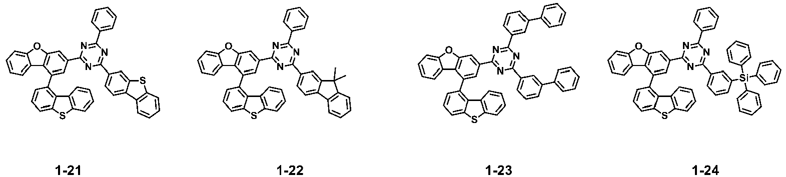

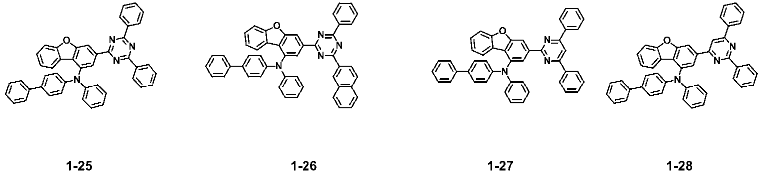

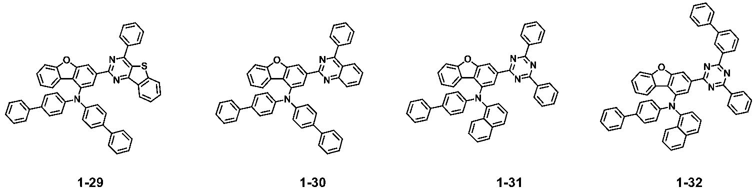

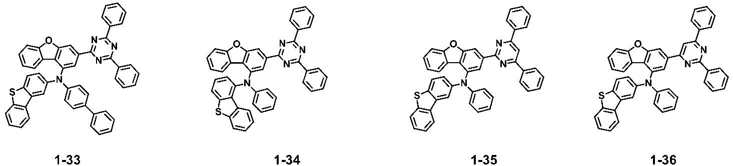

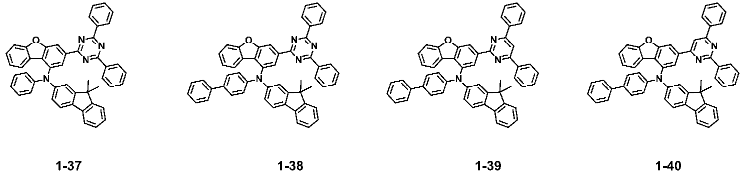

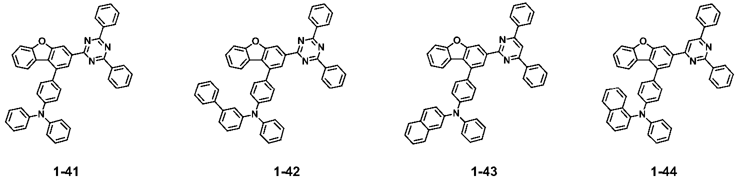

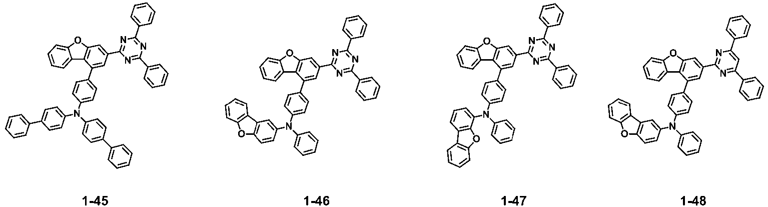

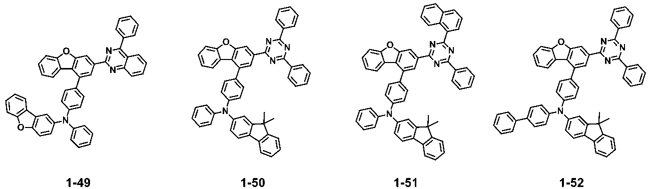

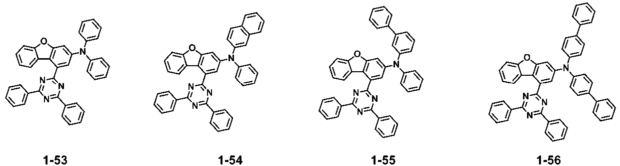

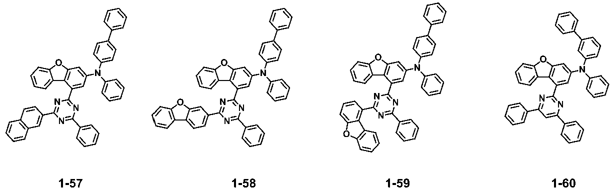

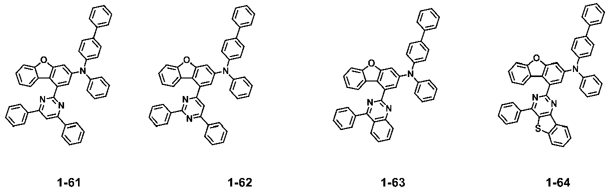

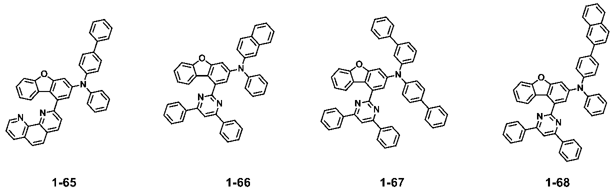

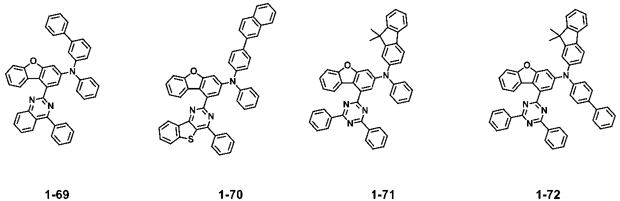

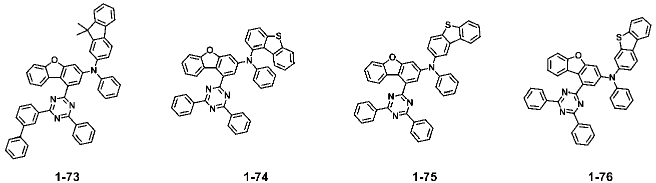

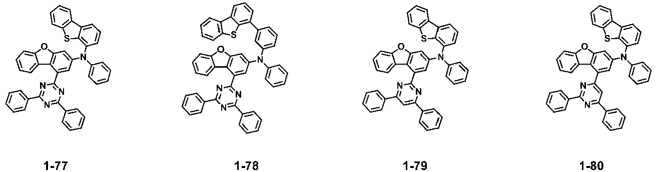

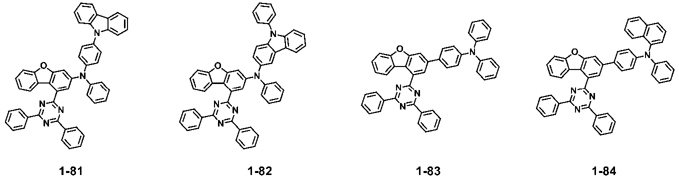

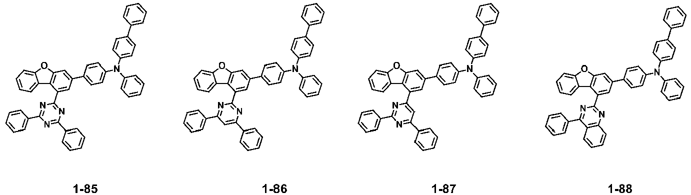

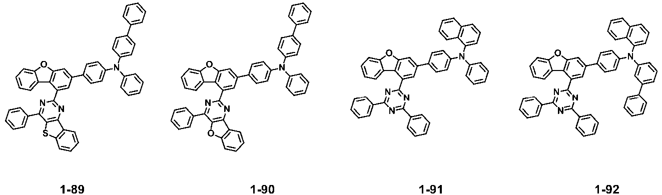

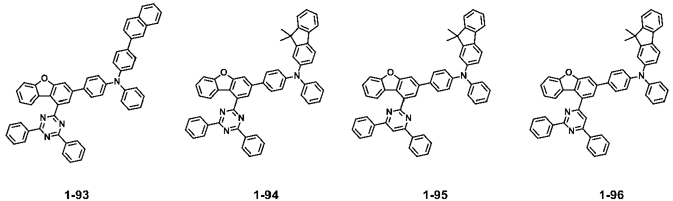

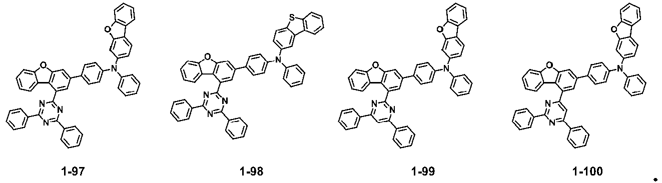

7. Organische lichtemittierende Vorrichtung nach Anspruch 1, wobei die chemische Formel 2 durch eine der folgenden Verbindungen dargestellt ist:

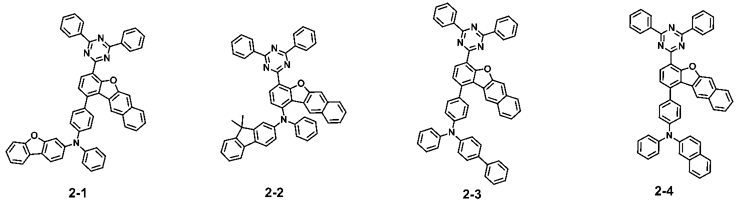

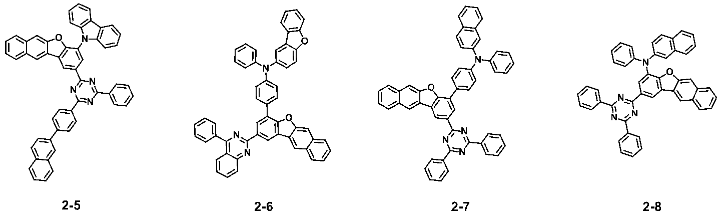

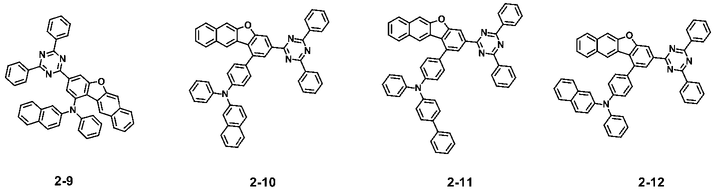

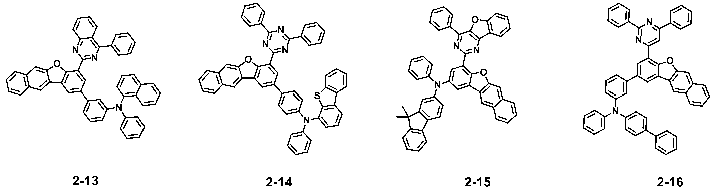

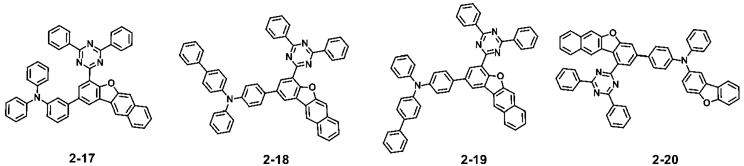

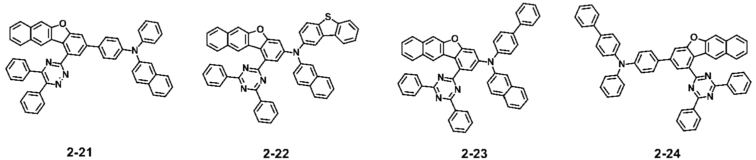

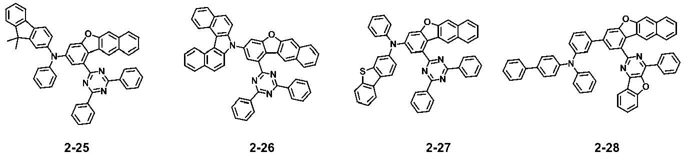

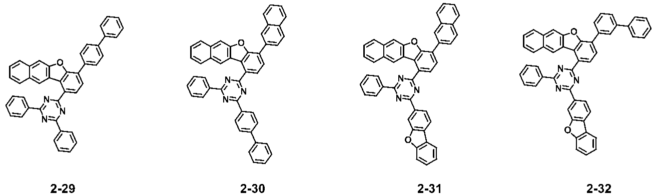

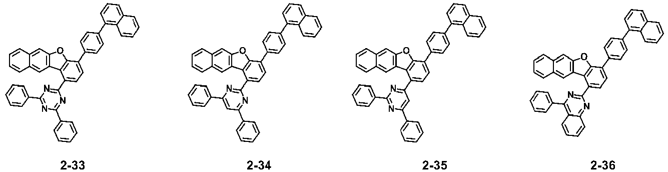

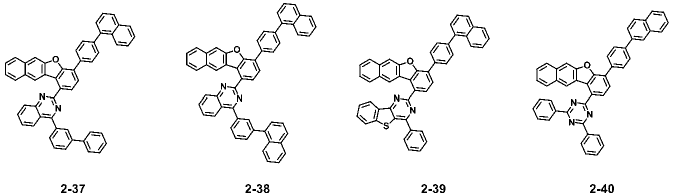

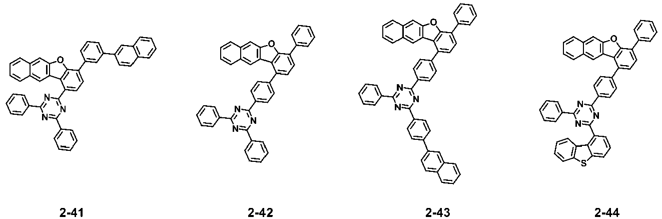

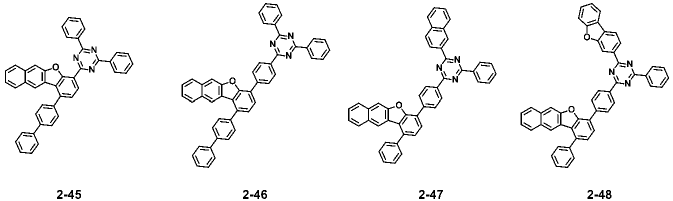

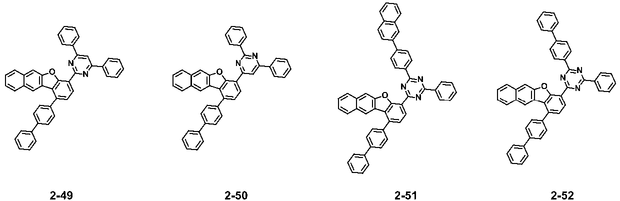

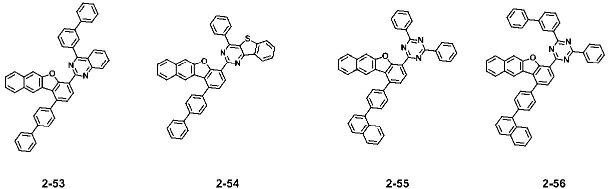

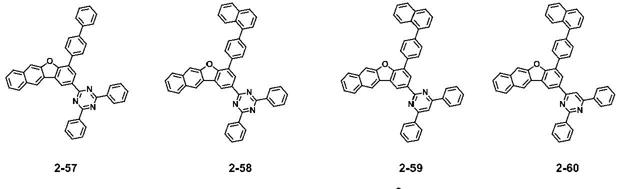

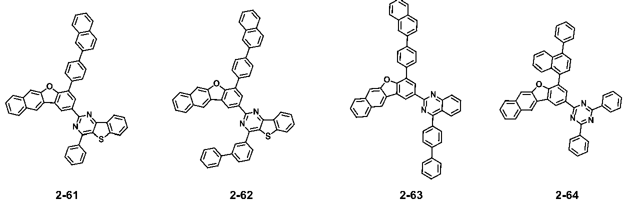

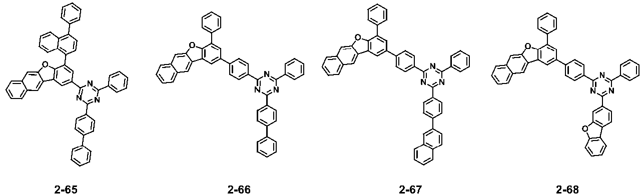

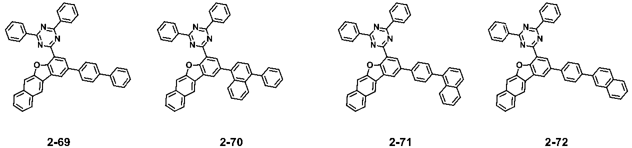

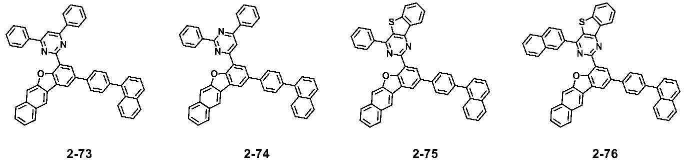

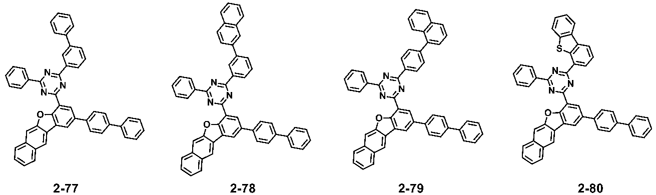

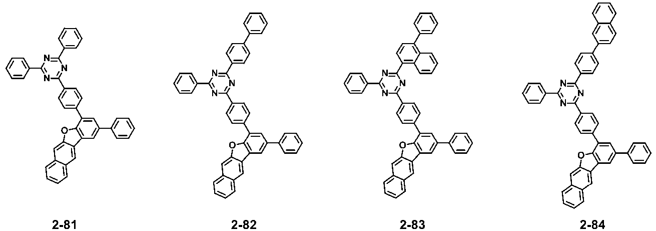

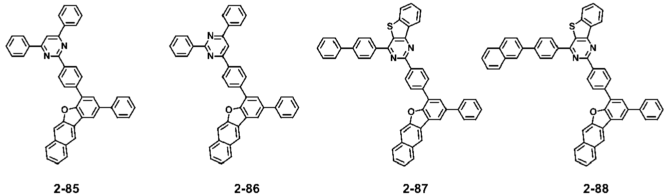

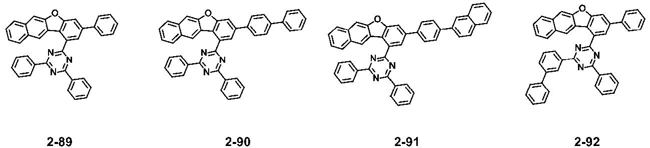

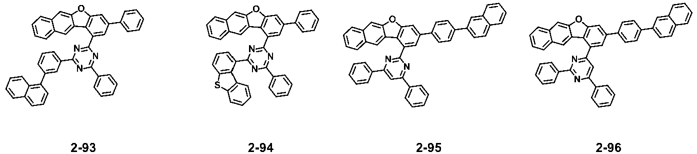

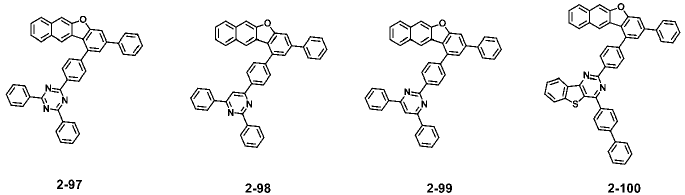

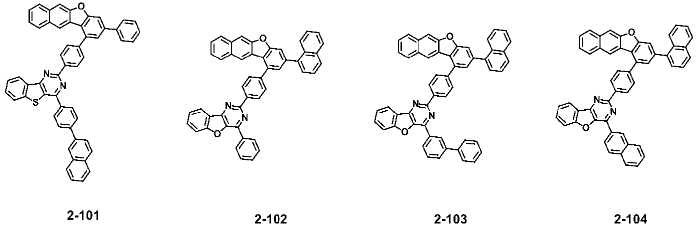

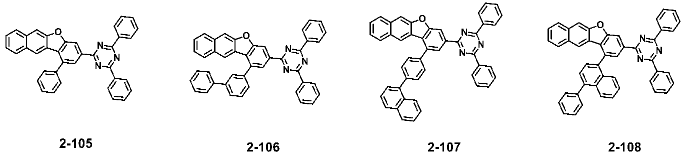

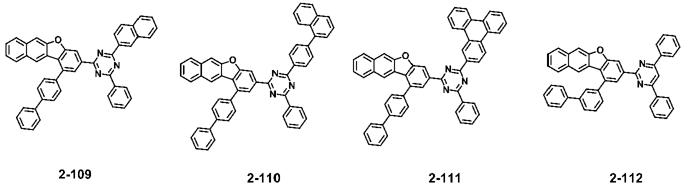

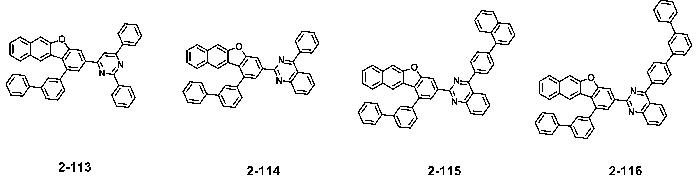

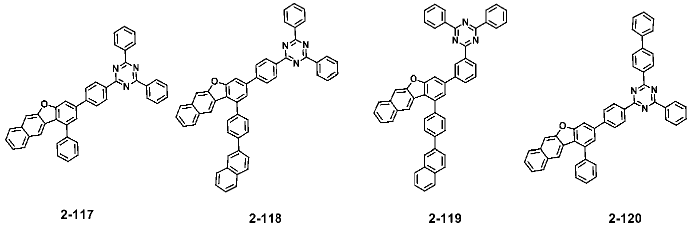

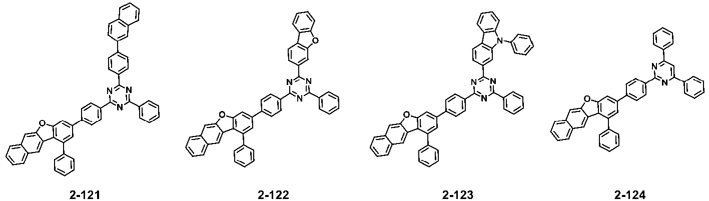

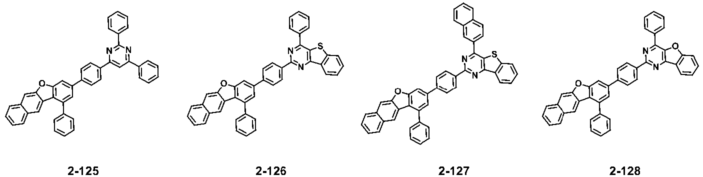

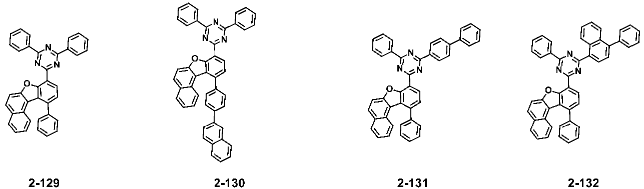

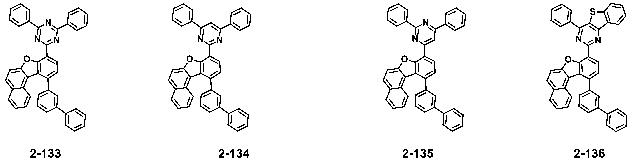

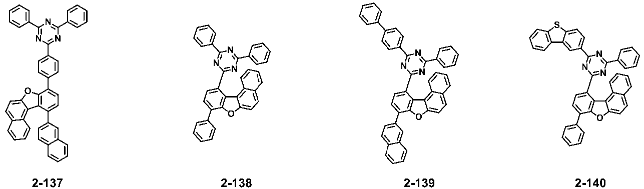

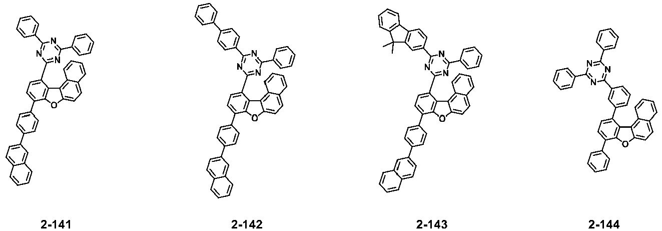

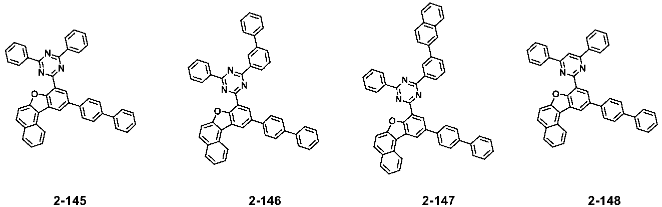

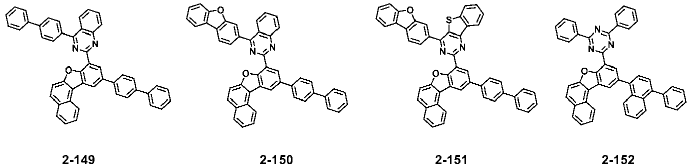

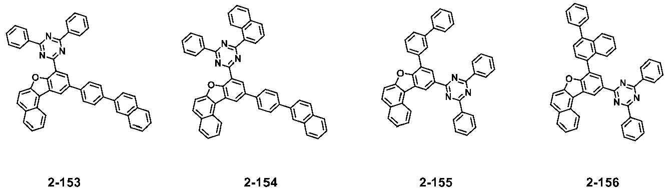

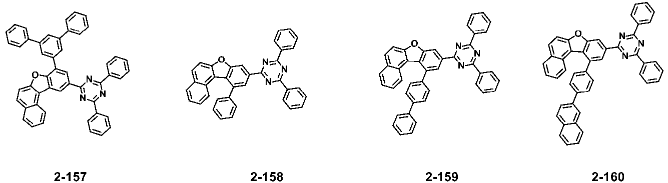

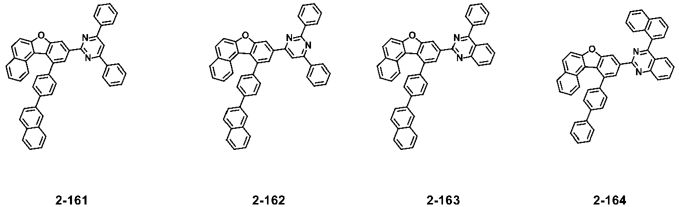

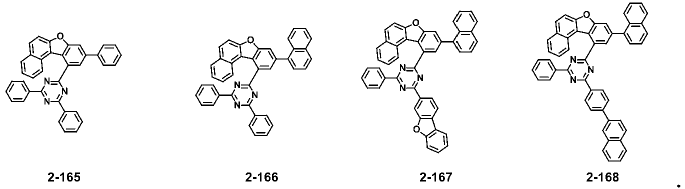

8. Organische lichtemittierende Vorrichtung nach Anspruch 1, wobei die organische Materialschicht (300) mindestens eine von einer Lochblockierschicht (304), einer Elektroneninjektionsschicht (306) und einer Elektronentransferschicht (305) umfasst, und die mindestens eine von einer Lochblockierschicht (304), einer Elektroneninjektionsschicht (306) und einer Elektronentransferschicht (305) die heterocyclische Verbindung, die durch die chemische Formel 1 dargestellt ist, und die heterocyclische Verbindung, die durch die chemische Formel 2 dargestellt ist, umfasst.

9. Organische lichtemittierende Vorrichtung nach Anspruch 1, wobei die organische Materialschicht (300) eine lichtemittierende Schicht (303) umfasst, die lichtemittierende Schicht (303) ein Wirtsmaterial umfasst, und das Wirtsmaterial die heterocyclische Verbindung, die durch die chemische Formel 1 dargestellt ist, und die heterocyclische Verbindung, die durch die chemische Formel 2 dargestellt ist, umfasst.

10. Organische lichtemittierende Vorrichtung nach Anspruch 1, ferner umfassend eine, zwei oder mehr Schichten, ausgewählt aus der Gruppe, bestehend aus einer lichtemittierenden Schicht (303), einer Lochinjektionsschicht (301), einer Lochtransferschicht (302), einer Elektroneninjektionsschicht (306), einer Elektronentransferschicht (305), einer Elektronenblockierschicht und einer Lochblockierschicht (304).

11. Zusammensetzung für eine organische Materialschicht (300) einer organischen lichtemittierenden Vorrichtung, wobei die Zusammensetzung umfasst:
eine heterocyclische Verbindung, die durch die folgende chemische Formel 1 dargestellt ist; und
eine Verbindung, die durch die folgende chemische Formel 2 dargestellt ist: 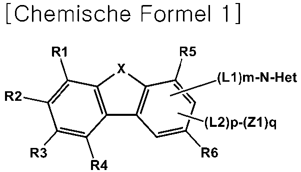 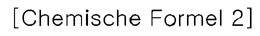 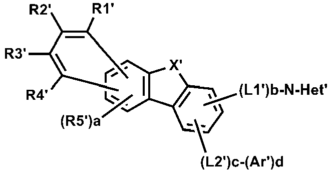
wobei in den chemischen Formeln 1 und 2
X und X' O sind,
L1 und L2 gleich oder verschieden voneinander sind und jeweils unabhängig eine direkte Bindung; oder eine Phenylengruppe sind,
L1' und L2' gleich oder verschieden voneinander sind und jeweils unabhängig eine direkte Bindung; eine Phenylengruppe; eine Biphenylengruppe; oder eine Naphthalingruppe sind,
N-Het eine Triazingruppe, unsubstituiert oder substituiert mit einem oder mehreren Substituenten, ausgewählt aus der Gruppe, bestehend aus einer Phenylgruppe, einer Biphenylgruppe, einer Terphenylgruppe, einer Naphthylgruppe, einer Triphenylenylgruppe, einer Dibenzofurangruppe, einer Dibenzothiophengruppe, einer Pyridingruppe, einer Dimethylfluorenylgruppe, einer Diphenylfluorenylgruppe und einer Spirobifluorengruppe; eine Pyrimidingruppe, unsubstituiert oder substituiert mit einer Phenylgruppe; eine Pyridingruppe, unsubstituiert oder substituiert mit einer Phenylgruppe; eine Chinolingruppe, unsubstituiert oder substituiert mit einer Phenylgruppe ist;
eine Chinazolingruppe, unsubstituiert oder substituiert mit einer Phenylgruppe; eine Phenanthrolingruppe; oder eine Benzo[4,5]thieno[2,3-d]pyrimidingruppe, unsubstituiert oder substituiert mit einer Phenylgruppe, ist,
N-Het wiederum mit -CN; einer Phenylgruppe; oder SiRR'R" substituiert ist,
N-Het' eine Triazingruppe, unsubstituiert oder substituiert mit einem oder mehreren Substituenten, ausgewählt aus der Gruppe, bestehend aus einer Phenylgruppe, einer Biphenylgruppe, einer Naphthylgruppe, einer Triphenylenylgruppe, einer Dibenzofurangruppe, einer Dibenzothiophengruppe und einer Carbazolgruppe, unsubstituiert oder substituiert mit einer Phenylgruppe; eine Pyrimidingruppe, unsubstituiert oder substituiert mit einer Phenylgruppe; eine Pyridingruppe, unsubstituiert oder substituiert mit einer Phenylgruppe; eine Chinazolingruppe, unsubstituiert oder substituiert mit einem oder mehreren Substituenten, ausgewählt aus der Gruppe, bestehend aus einer Phenylgruppe, einer Biphenylgruppe, einer Terphenylgruppe, einer Naphthylgruppe und einer Dibenzofurangruppe; eine Benzofuro[3,2-d]pyrimidingruppe, unsubstituiert oder substituiert mit einer Phenylgruppe oder einer Naphthylgruppe; oder eine Benzo[4,5]thieno[2,3-d]pyrimidingruppe, unsubstituiert oder substituiert mit einer Phenylgruppe oder einer Naphthylgruppe, ist,
N-Het' wiederum mit einer Phenylgruppe; oder einer Naphthylgruppe substituiert ist,
Ar' ausgewählt ist aus der Gruppe, bestehend aus einer Phenylgruppe; einer Biphenylgruppe; einer Naphthylgruppe; einer Terphenylgruppe; einer Carbazolgruppe; einer Phenylring-kondensierten Carbazolgruppe; und einer Amingruppe, unsubstituiert oder substituiert mit einem oder mehreren Substituenten, ausgewählt aus der Gruppe, bestehend aus einer Phenylgruppe, einer Biphenylgruppe, einer Naphthylgruppe, einer Dimethylfluorenylgruppe, einer Dibenzofurangruppe und einer Dibenzothiophengruppe, wobei Z1 der chemischen Formel 1 eine Amingruppe, unsubstituiert oder substituiert mit einem oder mehreren Substituenten, ausgewählt aus der Gruppe, bestehend aus einer Phenylgruppe, einer Biphenylgruppe, einer Naphthylgruppe, einer Dimethylfluorenylgruppe, einer Dibenzothiophengruppe und einer Dibenzofurangruppe, oder dargestellt durch die chemische Formel 1-1 ist, 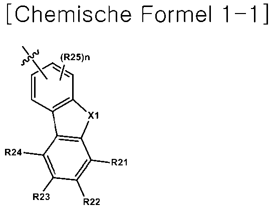
wobei in der chemischen Formel 1-1 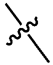 eine Position bedeutet, die mit L2 der chemischen Formel 1 verknüpft ist;
X1 O oder S ist,
R21 bis R25 gleich oder verschieden voneinander sind und jeweils unabhängig ausgewählt sind aus der Gruppe, bestehend aus Wasserstoff; einer Phenylgruppe; einer Biphenylgruppe; einer Triphenylenylgruppe; und einer Dibenzothiophengruppe, oder Gruppen, die zueinander benachbart sind, aneinander binden können, um einen Phenylring zu bilden,
n eine ganze Zahl von 0 bis 3 ist;
wenn n 2 oder größer ist, Substituenten in den Klammern gleich oder verschieden voneinander sind; und
R1 bis R6 und R1' bis R5' gleich oder verschieden voneinander sind und jeweils unabhängig ausgewählt sind aus der Gruppe, bestehend aus Wasserstoff; und Deuterium,
R, R' und R" eine Phenylgruppe sind,
m, p, b und c eine ganze Zahl von 0 bis 3 sind;
q und d eine ganze Zahl von 1 bis 6 sind;
a eine ganze Zahl von 0 bis 2 ist; und
wenn a 2 oder m ist, p, b, c, q und d 2 oder größer sind, Substituenten in den Klammern gleich oder verschieden voneinander sind.

12. Zusammensetzung für eine organische Materialschicht (300) einer organischen lichtemittierenden Vorrichtung nach Anspruch 11, wobei die heterocyclische Verbindung, die durch die chemische Formel 1 dargestellt ist:die heterocyclische Verbindung, die durch die chemische Formel 2 dargestellt ist, ein Gewichtsverhältnis von 1:10 bis 10:1 in der Zusammensetzung aufweisen.

13. Verfahren zur Herstellung einer organischen lichtemittierenden Vorrichtung, wobei das Verfahren umfasst:
Herstellen eines Substrats (100);
Bilden einer ersten Elektrode auf dem Substrat (100);
Bilden einer oder mehrerer organischer Materialschichten (300) auf der ersten Elektrode;
und
Bilden einer zweiten Elektrode auf der organischen Materialschicht (300),
wobei das Bilden von organischen Materialschichten (300) das Bilden einer oder
mehrerer organischer Materialschichten (300) unter Verwendung der Zusammensetzung für eine organische Materialschicht (300) nach Anspruch 11 umfasst.

14. Verfahren zur Herstellung einer organischen lichtemittierenden Vorrichtung nach Anspruch 13, wobei das Bilden von organischen Materialschichten (300) das Bilden unter Verwendung eines thermischen Vakuumabscheidungsverfahrens nach dem Vormischen der heterocyclischen Verbindung der chemischen Formel 1 und der heterocyclischen Verbindung der chemischen Formel 2 ist.

## Revendications

1. Dispositif électroluminescent organique comprenant :
une première électrode ;
une deuxième électrode ; et
une ou plusieurs couches de matériau organique (300) fournies entre la première électrode et
la deuxième électrode,
dans lequel une ou plusieurs couches de la couche de matériau organique (300) incluent un composé hétérocyclique représenté par la Formule chimique 1 ci-après et un composé hétérocyclique représenté par la Formule chimique 2 ci-après : 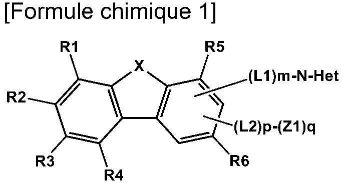 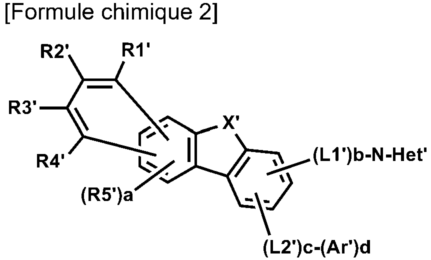
dans les Formules chimiques 1 et 2,
X et X' sont O,
L1 et L2 sont identiques ou différents l'un de l'autre, et chacun indépendamment une liaison directe ; ou un groupe phénylène,
L1' et L2' sont identiques ou différents l'un de l'autre, et chacun indépendamment une liaison directe ; un groupe phénylène ; un groupe biphénylène ; ou un groupe naphtalène,
N-Het est un groupe triazine non substitué ou substitué par un ou plusieurs substituants sélectionnés dans le groupe constitué d'un groupe phényle, un groupe biphényle, un groupe terphényle, un groupe naphtyle, un groupe triphénylényle, un groupe dibenzofurane, un groupe dibenzothiophène, un groupe pyridine, un groupe diméthylfluorényle, un groupe diphénylfluorényle et un groupe spirobifluorène ; un groupe pyrimidine non substitué ou substitué par un groupe phényle ; un groupe pyridine non substitué ou substitué par un groupe phényle ; un groupe quinoline non substitué ou substitué par un groupe phényle ;
un groupe quinazoline non substitué ou substitué par un groupe phényle ; un groupe phénanthroline ; ou un groupe benzo[4,5]thiéno[2,3-d]pyrimidine non substitué ou substitué par un groupe phényle,
N-Het est substitué encore par -CN ; un groupe phényle ; ou SiRR'R",
N-Het' est un groupe triazine non substitué ou substitué par un ou plusieurs substituants sélectionnés dans le groupe constitué d'un groupe phényle, un groupe biphényle, un groupe naphtyle, un groupe triphénylényle, un groupe dibenzofurane, un groupe dibenzothiophène et un groupe carbazole non substitué ou substitué par un groupe phényle ; un groupe pyrimidine non substitué ou substitué par un groupe phényle ; un groupe pyridine non substitué ou substitué par un groupe phényle ; un groupe quinazoline non substitué ou substitué par un ou plusieurs substituants sélectionnés dans le groupe constitué d'un groupe phényle, un groupe biphényle, un groupe terphényle, un groupe naphtyle et un groupe dibenzofurane ; un groupe benzofuro[3,2-d]pyrimidine non substitué ou substitué par un groupe phényle ou un groupe naphtyle ; ou un groupe benzo[4,5]thiéno[2,3-d]pyrimidine non substitué ou substitué par un groupe phényle ou un groupe naphtyle,
N-Het' est substitué encore par un groupe phényle ; ou un groupe naphtyle,
Ar' est sélectionné dans le groupe constitué d'un groupe phényle ; un groupe biphényle ; un groupe naphtyle ; un groupe terphényle ; un groupe carbazole ; un groupe carbazole fusionné par cycle phényle ; et un groupe amine non substitué ou substitué par un ou plusieurs substituants sélectionnés dans le groupe constitué d'un groupe phényle, un groupe biphényle, un groupe naphtyle, un groupe diméthylfluorényle, un groupe dibenzofurane et un groupe dibenzothiophène,
dans lequel Z1 de la Formule chimique 1 est un groupe amine non substitué ou substitué par un ou plusieurs substituants sélectionnés dans le groupe constitué d'un groupe phényle, un groupe biphényle, un groupe naphtyle, un groupe diméthylfluorényle, un groupe dibenzothiophène et un groupe dibenzofurane, ou représenté par la Formule chimique 1-1, 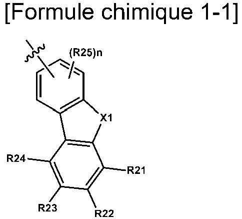
dans la Formule chimique 1-1, 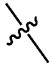 indique une position liée à L2 de la Formule chimique 1 ;
X1 est O ou S,
R21 à R25 sont identiques ou différents les uns des autres, et chacun indépendamment sélectionné dans le groupe constitué d'un hydrogène ; un groupe phényle ; un groupe biphényle ; un groupe triphénylényle ; et un groupe dibenzothiophène, ou des groupes adjacents l'un à l'autre peuvent se lier l'un à l'autre pour former un cycle phényle n est un nombre entier de 0 à 3 ;
quand n est 2 ou plus, les substituants entre parenthèses sont identiques ou différents les uns des autres ; et
R1 à R6 et R1' à R5' sont identiques ou différents les uns des autres, et chacun indépendamment sélectionnés dans le groupe constitué d'un hydrogène ; et un deutérium, R, R' et R" sont un groupe phényle,
m, p, b et c sont un nombre entier de 0 à 3 ;
q et d sont un nombre entier de 1 à 6 ;
a est un nombre entier de 0 à 2 ; et
quand a est 2 ou m, p, b, c, q et d sont 2 ou plus, les substituants entre parenthèses sont identiques ou différents les uns des autres.

2. Dispositif électroluminescent organique selon la revendication 1, dans lequel la Formule chimique 1 est représentée par la Formule chimique 3 ou la Formule chimique 4 ci-après : 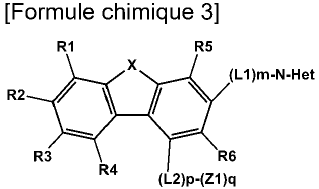 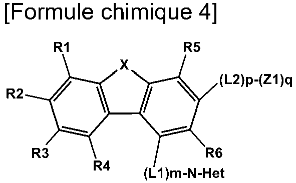
dans les Formules chimiques 3 et 4,
R1 à R6, L1, L2, Z1, N-Het, X, m, p et q ont les mêmes définitions que dans la Formule chimique 1.

3. Dispositif électroluminescent organique selon la revendication 1, dans lequel la Formule chimique 2 est représentée par l'une quelconque des Formules chimiques 2-1 à 2-3 ci-après : 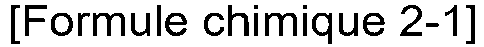 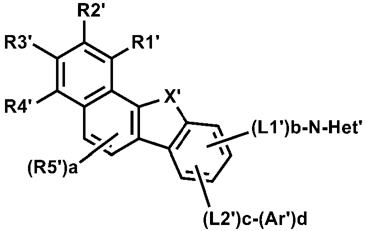 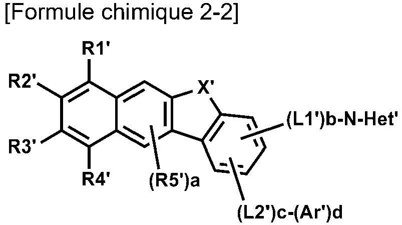 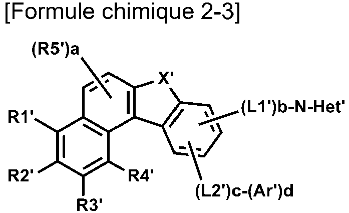
dans les Formules chimiques 2-1 à 2-3,
chaque substituant a la même définition que dans la Formule chimique 2.

4. Dispositif électroluminescent organique selon la revendication 1, dans lequel la Formule chimique 2 est représentée par l'une quelconque des Formules chimiques 2-4 à 2-7 ci-après : 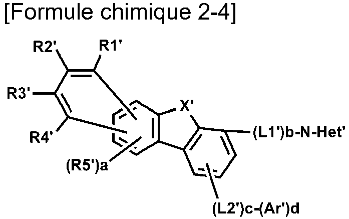 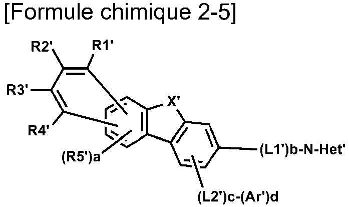 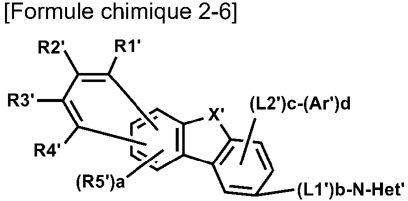 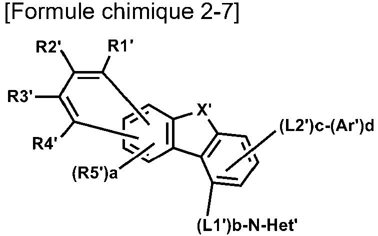
dans les Formules chimiques 2-4 à 2-7,
chaque substituant a la même définition que dans la Formule chimique 2.

5. Dispositif électroluminescent organique selon la revendication 1, dans lequel R1 à R6 et R1' à R5' sont un hydrogène.

6. Dispositif électroluminescent organique selon la revendication 1, dans lequel la Formule chimique 1 est représentée par l'un quelconque des composés suivants :

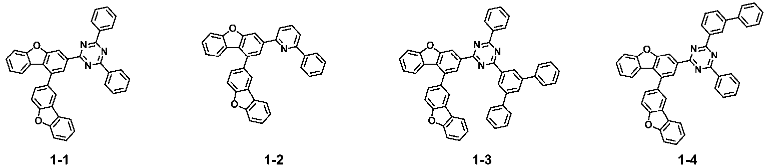

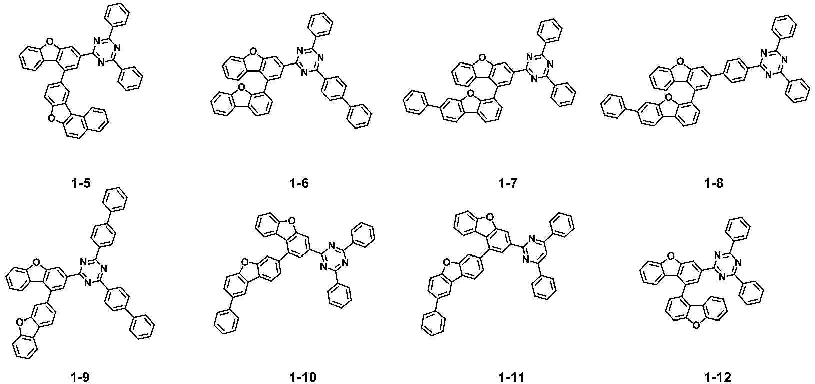

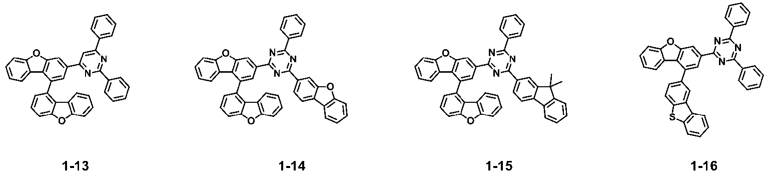

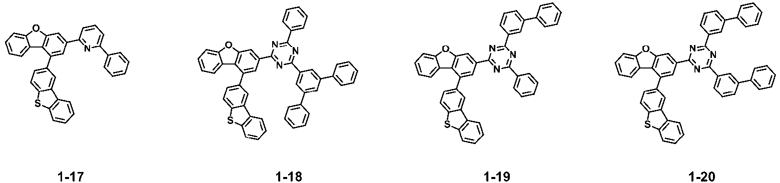

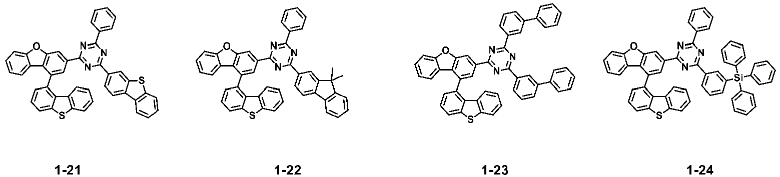

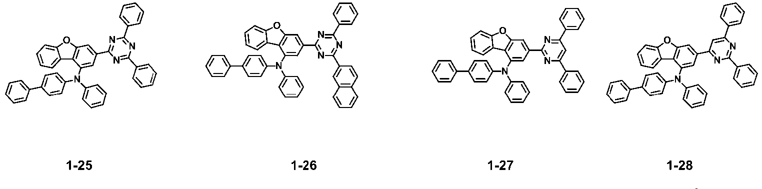

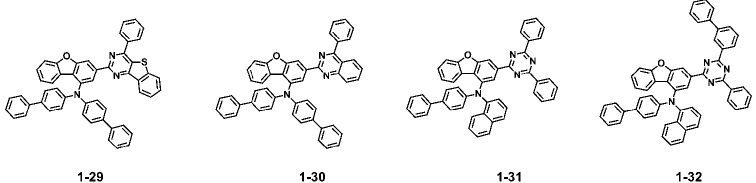

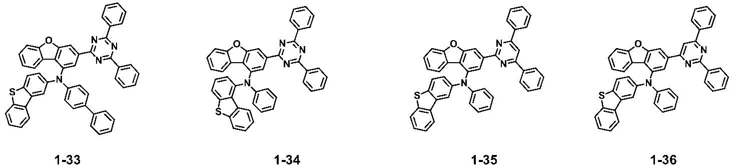

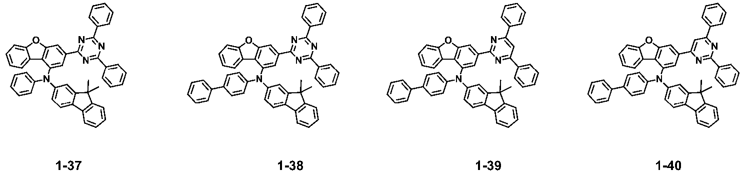

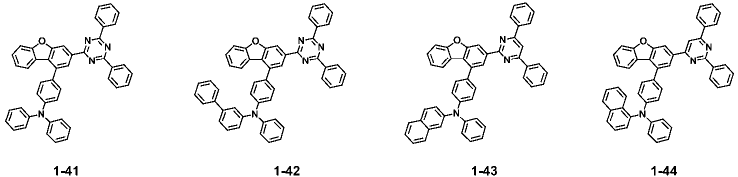

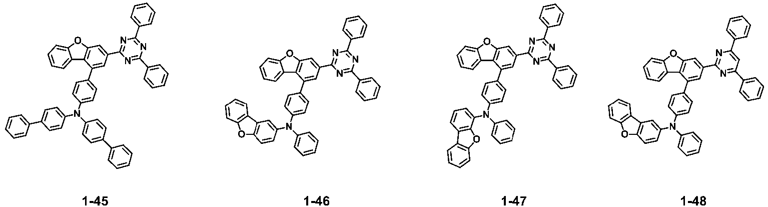

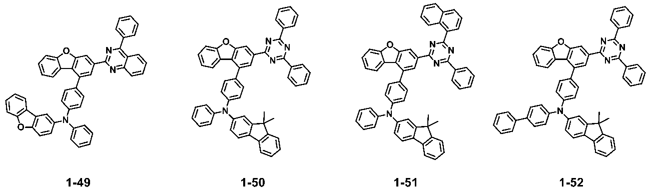

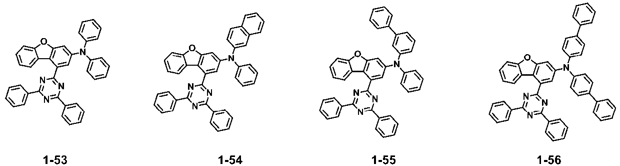

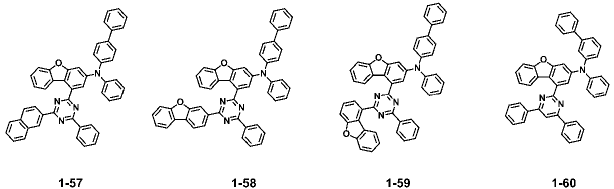

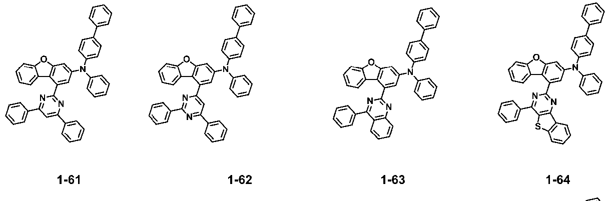

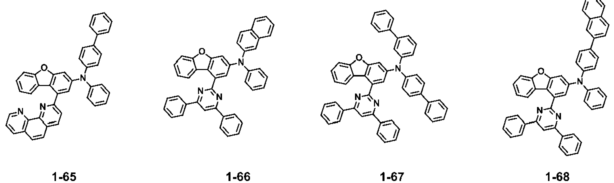

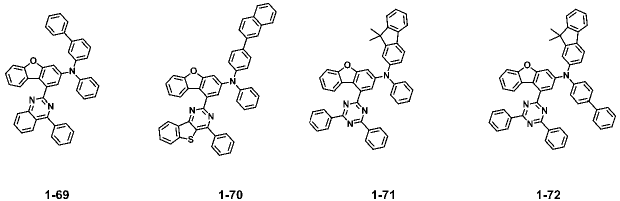

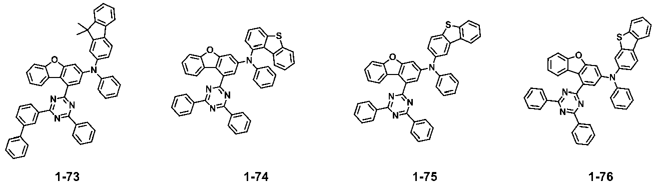

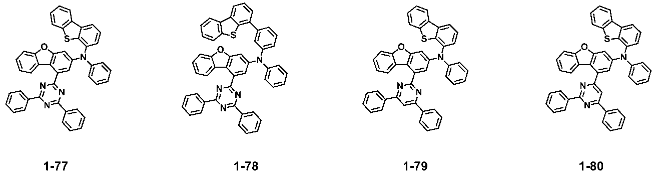

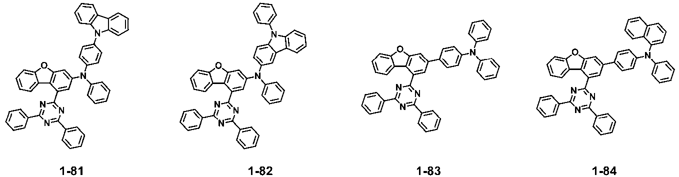

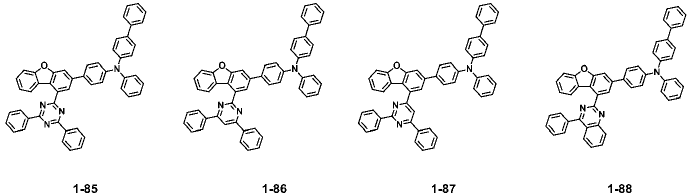

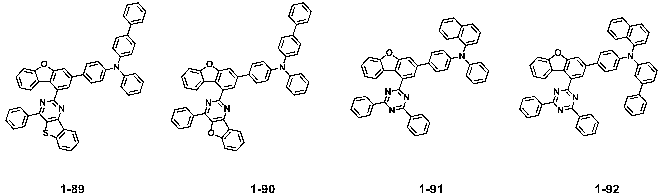

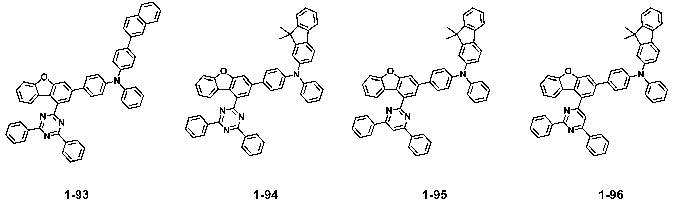

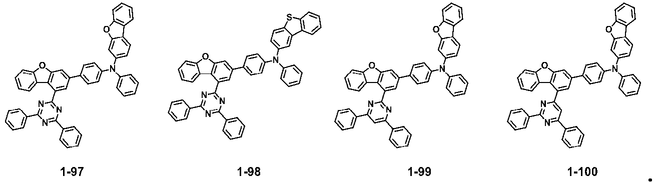

7. Dispositif électroluminescent organique selon la revendication 1, dans lequel la Formule chimique 2 est représentée par l'un quelconque des composés suivants :

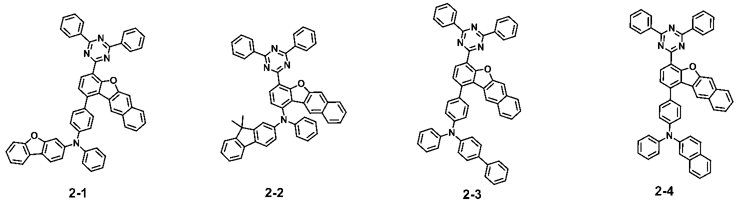

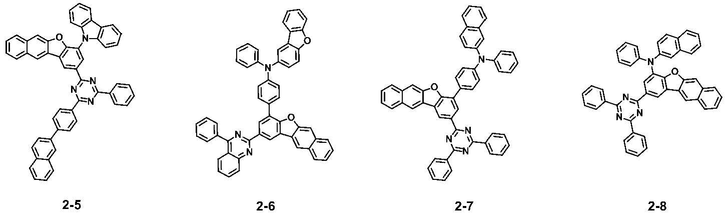

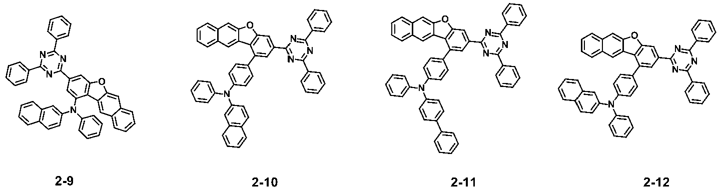

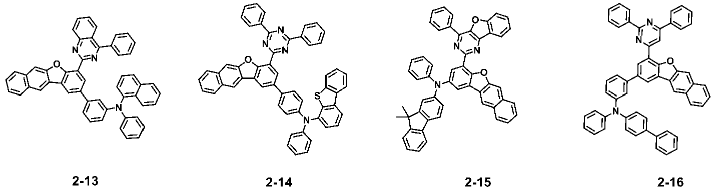

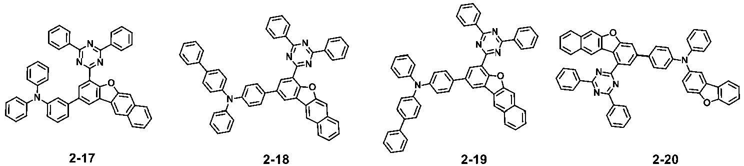

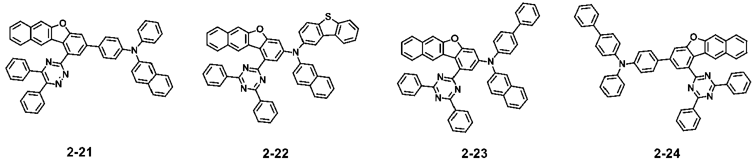

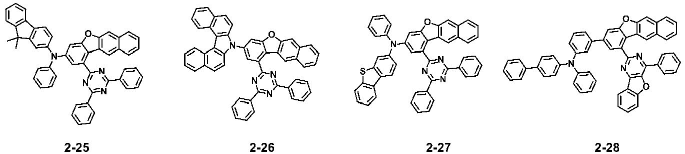

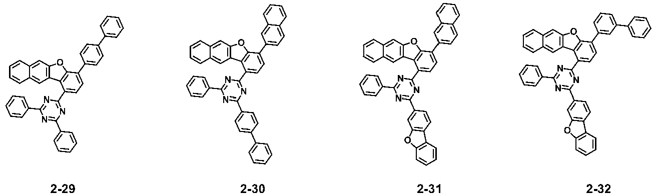

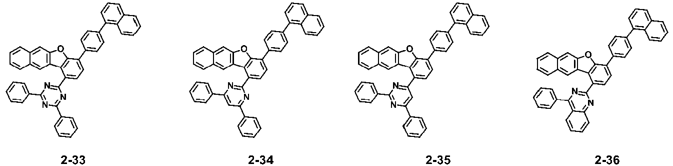

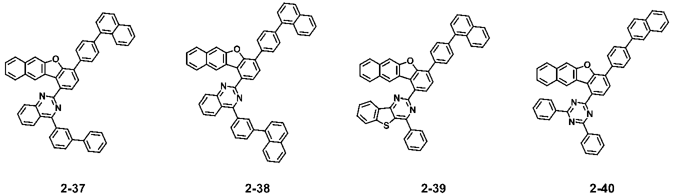

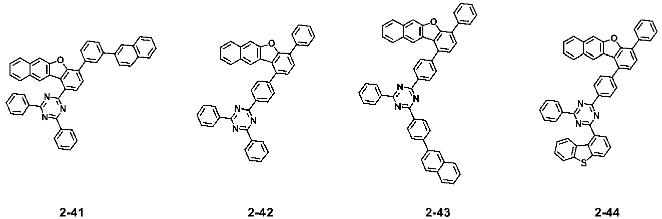

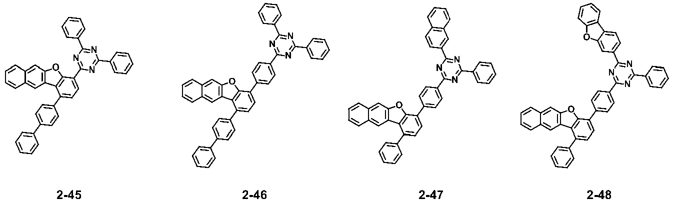

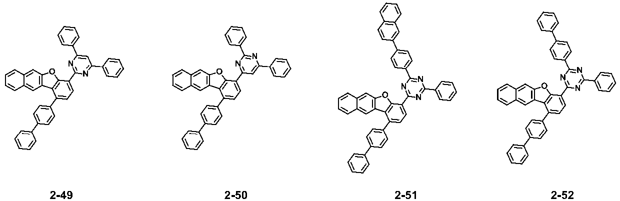

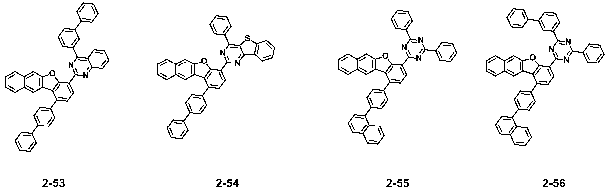

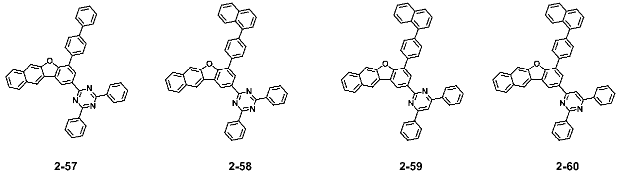

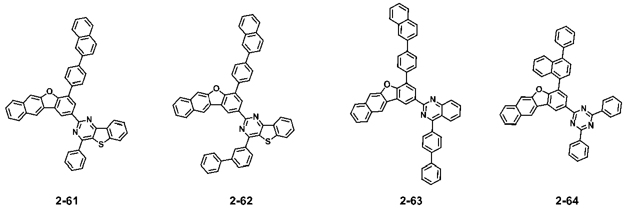

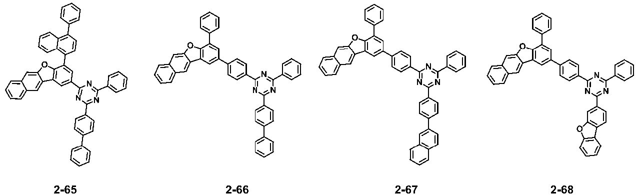

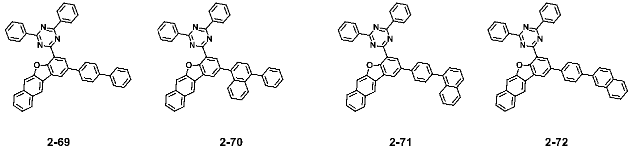

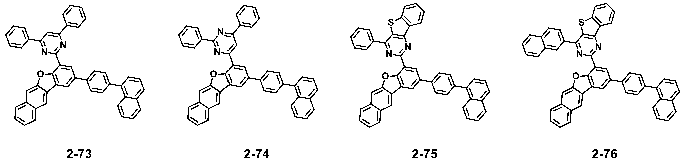

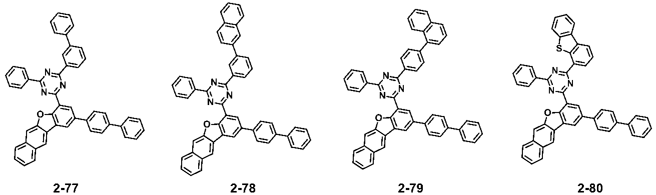

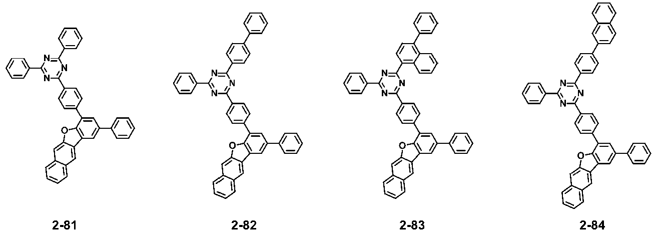

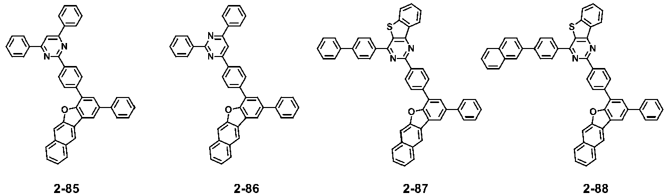

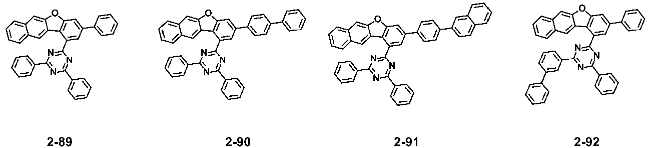

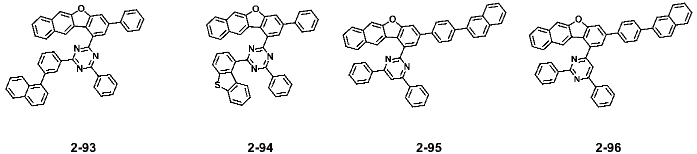

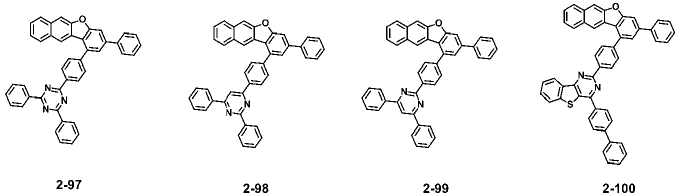

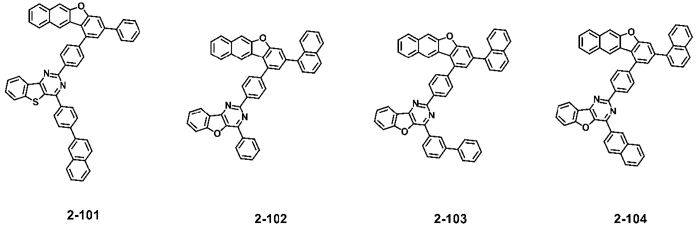

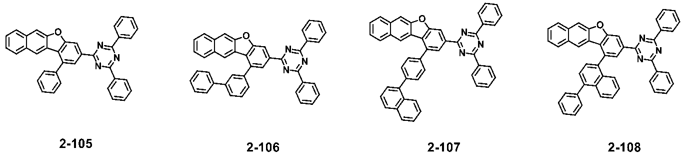

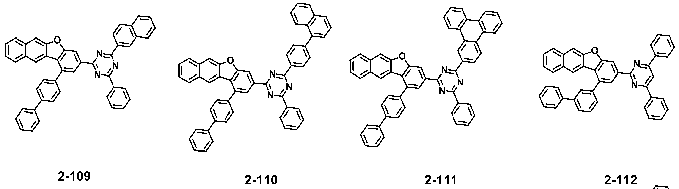

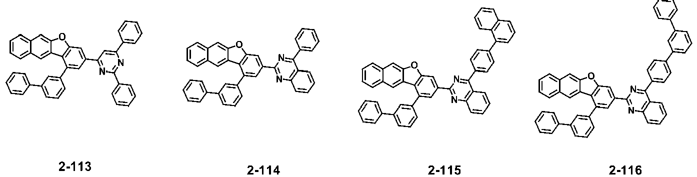

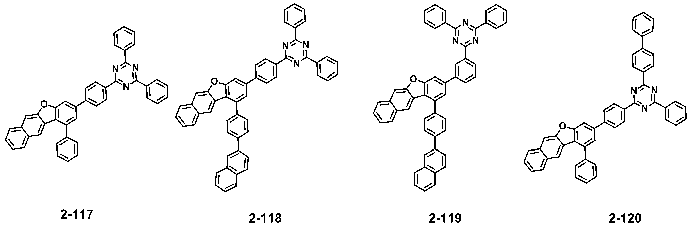

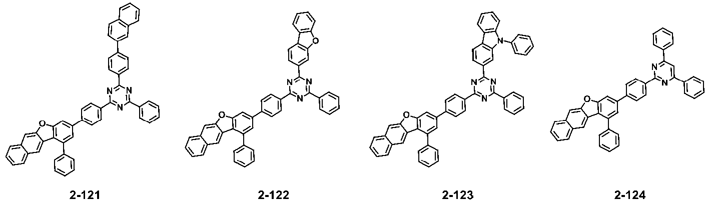

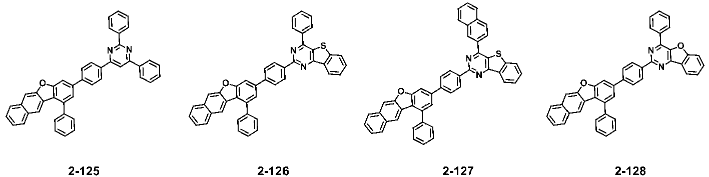

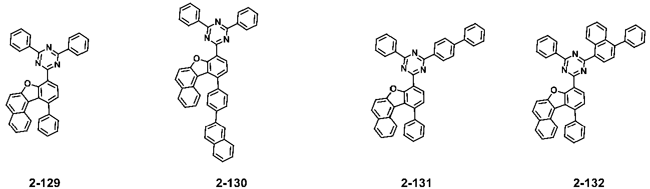

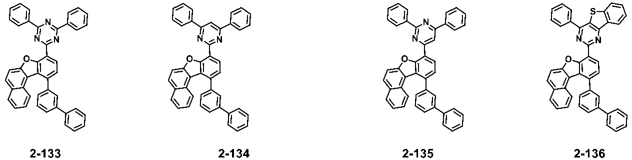

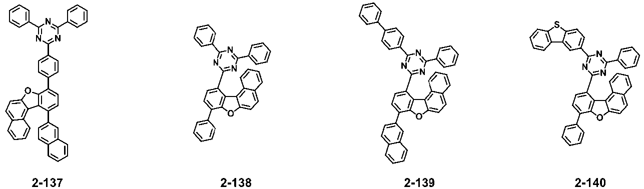

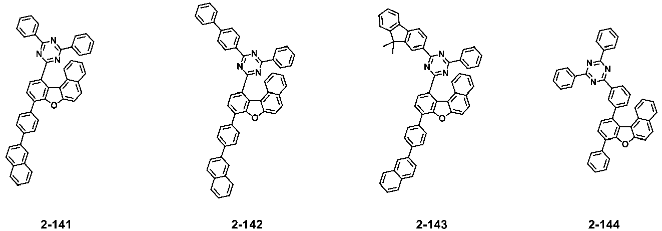

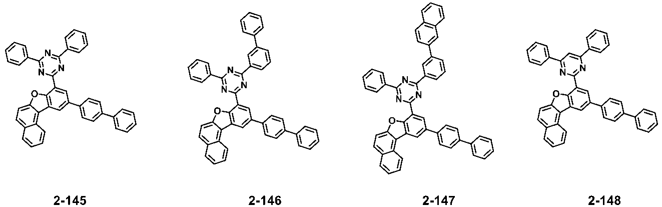

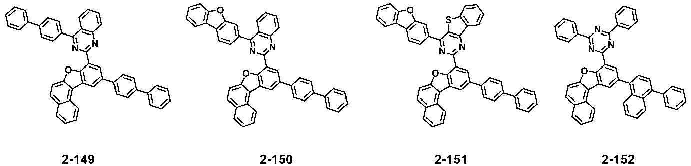

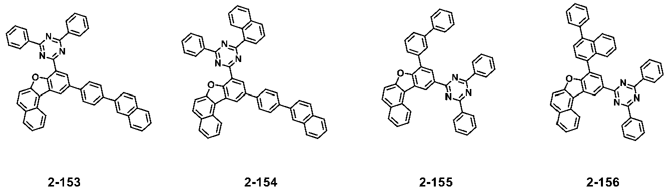

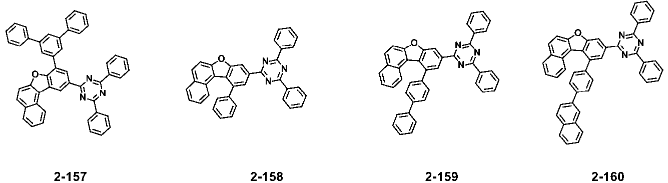

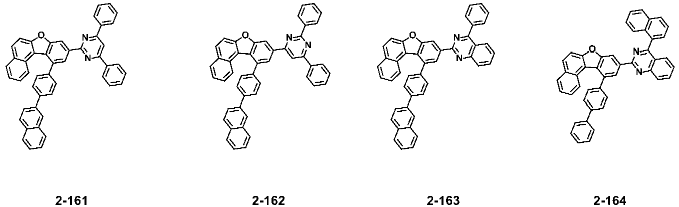

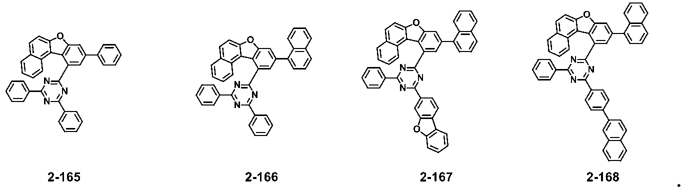

8. Dispositif électroluminescent organique selon la revendication 1, dans lequel la couche de matériau organique (300) inclut au moins une couche parmi une couche de blocage de trous (304), une couche d'injection d'électrons (306) et une couche de transfert d'électrons (305), et la ou les couches parmi une couche de blocage de trous (304), une couche d'injection d'électrons (306) et une couche de transfert d'électrons (305) inclut le composé hétérocyclique représenté par la Formule chimique 1 et le composé hétérocyclique représenté par la Formule chimique 2.

9. Dispositif électroluminescent organique selon la revendication 1, dans lequel la couche de matériau organique (300) inclut une couche électroluminescente (303), la couche électroluminescente (303) inclut un matériau hôte, et le matériau hôte inclut le composé hétérocyclique représenté par la Formule chimique 1 et le composé hétérocyclique représenté par la Formule chimique 2.

10. Dispositif électroluminescent organique selon la revendication 1, comprenant en outre une couche ou deux couches ou plus sélectionnées dans le groupe constitué d'une couche électroluminescente (303), une couche d'injection de trous (301), une couche de transfert de trous (302), une couche d'injection d'électrons (306), une couche de transfert d'électrons (305), une couche de blocage d'électrons et une couche de blocage de trous (304).

11. Composition d'une couche de matériau organique (300) d'un dispositif électroluminescent organique, la composition comprenant :
un composé hétérocyclique représenté par la Formule chimique 1 ci-après ; et
un composé représenté par la Formule chimique 2 ci-après : 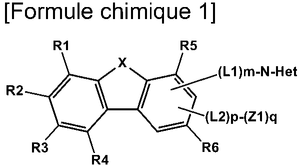 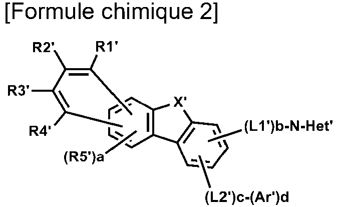
dans les Formules chimiques 1 et 2,
X et X' sont O,
L1 et L2 sont identiques ou différents l'un de l'autre, et chacun indépendamment une liaison directe ; ou un groupe phénylène,
L1' et L2' sont identiques ou différents l'un de l'autre, et chacun indépendamment une liaison directe ; un groupe phénylène ; un groupe biphénylène ; ou un groupe naphtalène,
N-Het est un groupe triazine non substitué ou substitué par un ou plusieurs substituants sélectionnés dans le groupe constitué d'un groupe phényle, un groupe biphényle, un groupe terphényle, un groupe naphtyle, un groupe triphénylényle, un groupe dibenzofurane, un groupe dibenzothiophène, un groupe pyridine, un groupe diméthylfluorényle, un groupe diphénylfluorényle et un groupe spirobifluorène ; un groupe pyrimidine non substitué ou substitué par un groupe phényle ; un groupe pyridine non substitué ou substitué par un groupe phényle ; un groupe quinoline non substitué ou substitué par un groupe phényle ;
un groupe quinazoline non substitué ou substitué par un groupe phényle ; un groupe phénanthroline ; ou un groupe benzo[4,5]thiéno[2,3-d]pyrimidine non substitué ou substitué par un groupe phényle,
N-Het est substitué encore par -CN ; un groupe phényle ; ou SiRR'R",
N-Het' est un groupe triazine non substitué ou substitué par un ou plusieurs substituants sélectionnés dans le groupe constitué d'un groupe phényle, un groupe biphényle, un groupe naphtyle, un groupe triphénylényle, un groupe dibenzofurane, un groupe dibenzothiophène et un groupe carbazole non substitué ou substitué par un groupe phényle ; un groupe pyrimidine non substitué ou substitué par un groupe phényle ; un groupe pyridine non substitué ou substitué par un groupe phényle ; un groupe quinazoline non substitué ou substitué par un ou plusieurs substituants sélectionnés dans le groupe constitué d'un groupe phényle, un groupe biphényle, un groupe terphényle, un groupe naphtyle et un groupe dibenzofurane ; un groupe benzofuro[3,2-d]pyrimidine non substitué ou substitué par un groupe phényle ou un groupe naphtyle ; ou un groupe benzo[4,5]thiéno[2,3-d]pyrimidine non substitué ou substitué par un groupe phényle ou un groupe naphtyle,
N-Het' est substitué encore par un groupe phényle ; ou un groupe naphtyle,
Ar' est sélectionné dans le groupe constitué d'un groupe phényle ; un groupe biphényle ; un groupe naphtyle ; un groupe terphényle ; un groupe carbazole ; un groupe carbazole fusionné par cycle phényle ; et un groupe amine non substitué ou substitué par un ou plusieurs substituants sélectionnés dans le groupe constitué d'un groupe phényle, un groupe biphényle, un groupe naphtyle, un groupe diméthylfluorényle, un groupe dibenzofurane et un groupe dibenzothiophène,
dans lequel Z1 de la Formule chimique 1 est un groupe amine non substitué ou substitué par un ou plusieurs substituants sélectionnés dans le groupe constitué d'un groupe phényle, un groupe biphényle, un groupe naphtyle, un groupe diméthylfluorényle, un groupe dibenzothiophène et un groupe dibenzofurane, ou représenté par la Formule chimique 1-1, 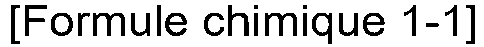 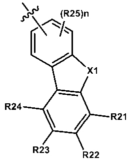
dans la Formule chimique 1-1, 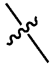 indique une position liée à L2 de la Formule chimique 1 ;
X1 est O ou S,
R21 à R25 sont identiques ou différents les uns des autres, et chacun indépendamment sélectionné dans le groupe constitué d'un hydrogène ; un groupe phényle ; un groupe biphényle ; un groupe triphénylényle ; et un groupe dibenzothiophène, ou groupes adjacents l'un à l'autre se lient l'un à l'autre pour former un cycle phényle
n est un nombre entier de 0 à 3 ;
quand n est 2 ou plus, les substituants entre parenthèses sont identiques ou différents les uns des autres ; et
R1 à R6 et R1' à R5' sont identiques ou différents les uns des autres, et chacun indépendamment sélectionnés dans le groupe constitué d'un hydrogène ; et un deutérium, R, R' et R" sont un groupe phényle,
m, p, b et c sont un nombre entier de 0 à 3 ;
q et d sont un nombre entier de 1 à 6 ;
a est un nombre entier de 0 à 2 ; et
quand a est 2 ou m, p, b, c, q et d sont 2 ou plus, les substituants entre parenthèses sont identiques ou différents les uns des autres.

12. Composition d'une couche de matériau organique (300) d'un dispositif électroluminescent organique selon la revendication 11, dans lequel le composé hétérocyclique représenté par la Formule chimique 1 et le composé hétérocyclique représenté par la Formule chimique 2 ont un rapport en poids de 1:10 à 10:1 dans la composition.

13. Procédé de fabrication d'un dispositif électroluminescent organique, le procédé consistant à :
préparer un substrat (100) ;
former une première électrode sur le substrat (100) ;
former une ou plusieurs couches de matériau organique (300) sur la première électrode ; et
former une deuxième électrode sur la couche de matériau organique (300),
dans lequel la formation de couches de matériau organique (300) consiste à former une ou plusieurs couches de matériau organique (300) en utilisant la composition d'une couche de matériau organique (300) selon la revendication 11.

14. Procédé de fabrication d'un dispositif électroluminescent organique selon la revendication 13, dans lequel la formation de couches de matériau organique (300) est formée en utilisant un procédé de dépôt thermique sous vide après avoir pré-mélangé le composé hétérocyclique de la Formule chimique 1 et le composé hétérocyclique de la Formule chimique 2.
